# EUROPEAN PATENT APPLICATION

(11) **EP 4 835 573 A1**
(43) Date of publication of application: **04.11.2026**
(21) Application number: 24912632.7
(22) Date of filing: 19.12.2024
(51) Int. Cl.: G03F 7/004, G03F 7/20, G03F 7/039

(54) **RESIST MATERIAL, PATTERN FORMATION METHOD, AND PATTERNED STRUCTURE**

(30) Priority: 28.12.2023 JP 2023223457
(71) Applicant: TOKYO OHKA KOGYO CO., LTD., Kawasaki-shi, Kanagawa 211 0012 (JP)
(72) Inventor: KIMURA, Kenta, Kawasaki-shi, Kanagawa 211-0012 (JP); NAGATA, Masaya, Kawasaki-shi, Kanagawa 211-0012 (JP); INARI, Takatoshi, Kawasaki-shi, Kanagawa 211-0012 (JP); NISHIZAWA, Akito, Kawasaki-shi, Kanagawa 211-0012 (JP)
(74) Representative: Plasseraud IP
(86) International application number: PCT/JP2024/045038
(87) International publication number: WO 2025/142743

(57) **Abstract**

An object of the present invention is to provide a novel resist material containing (A) a polyacid salt having one or more polar groups each having an acid-dissociable group or a mixture thereof and (B) a polymer, a pattern forming method, and a patterned structure.

## Description

### Technical Field

The present invention relates to a resist material, a pattern formation method, and a patterned structure.

### Background Art

The polyacid is an anionic metal oxide cluster represented by the general formula [MₓO_{y}]ⁿ⁻ (wherein x, y1, and n all denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ([X_{w}MₓO_{y}]ⁿ⁻ (wherein w, x, y, and n all denote natural numbers)) containing a different type of heteroatom X (for example, P⁵⁺, Si⁴⁺, Ge⁴⁺, B³⁺, or the like as a heteroatom X) in addition to the polyatom M and oxygen.

The physicochemical properties of a polyacid, such as redox ability, actinic radiation reactivity, and acid properties, can be changed depending on the combination and structure of the constituent elements, the type of counter cation, or the like.

Patent Literature 1 discloses an invention relating to a transfer method including the steps of providing a layer of a radiosensitive material containing a mixture of an organic compound, such as poly vinyl alcohol, and a polyoxometalate on a second material, exposing a selected region of the layer of the radiosensitive material to radiation to form a pattern in the layer, and then transferring the pattern into the second material thereunder.

### Citation List

### Patent Literature

PTL 1: U.S. Patent No. 5178989

### Summary of Invention

### Technical Problem

The present invention aims to provide a novel resist material, a pattern formation method, and a patterned structure.

As a result of extensive studies to solve the above problems, the present inventors have completed the present invention by finding that a novel resist material whose solubility in a developer can be changed by the action of an acid can be provided by using a resist material containing (A) a polyacid salt having one or more polar groups each having an acid-dissociable group or a mixture thereof and (B) a polymer.

That is, the present invention relates to the following inventions.
<1> A resist material containing (A) a polyacid salt having one or more polar groups each having an acid-dissociable group or a mixture thereof and (B) a polymer.
<2> The resist material according to <1>, wherein the (A) polyacid salt having one or more polar groups each having an acid-dissociable group or the mixture thereof has an anion moiety that is an isopolyacid anion, a heteropolyacid anion, or a heteropolyacid anion having a lacunary site in which the lacunary site is modified.
<3> The resist material according to <2>, wherein the isopolyacid anion is an isopolyoxomolybdate anion, an isopolyoxotungstate anion, an isopolyoxoniobate anion, or an isopolyoxotantalate anion.
<4> The resist material according to <2>, wherein the heteropolyacid anion has a polyatom of Mo, W, V, Nb, or Ta and a heteroatom of P, Si, B, S, or Ge.
<5> The resist material according to <2>, wherein the heteropolyacid anion having the lacunary site is a lacunary Keggin-type heteropolyacid anion or a lacunary Dawson-type heteropolyacid anion.
<6> The resist material according to <2>, wherein the modification is performed by bonding a group having one or more heteroatoms of P, Si, Ge, or Sn, to which one or more organic groups are bonded, to the heteropolyacid anion having the lacunary site via a part or all of the heteroatoms.
<7> The resist material according to <6>, wherein the organic group has one or more polar groups each having an acid-dissociable group.
<8> The resist material according to <7>, wherein the acid-dissociable group is a tertiary-carbon-type acid-dissociable group, an allyl- or benzyl-type acid-dissociable group, or an acetal-type acid-dissociable group.
<9> The resist material according to <1>, wherein the (A) polyacid salt having one or more polar groups each having an acid-dissociable group or the mixture thereof has a cation moiety that has H⁺, a metal ion, an onium cation, or an onium dication.
<10> The resist material according to <9>, wherein the onium cation or the onium dication is an ammonium cation, an ammonium dication, a phosphonium cation, a phosphonium dication, a sulfonium cation, a sulfonium dication, or an iodonium cation.
<11> The resist material according to <9>, wherein the onium cation or the onium dication has one or more polar groups each having an acid-dissociable group.
<12> The resist material according to <11>, wherein the acid-dissociable group is a tertiary-carbon-type acid-dissociable group, an allyl- or benzyl-type acid-dissociable group, or an acetal-type acid-dissociable group.
<13> The resist material according to <1>, wherein the (A) polyacid salt having one or more polar groups each having an acid-dissociable group or the mixture thereof is a polyacid salt having one or more polar groups each having an acid-dissociable group represented by the general formula (I) or a mixture thereof.

   (A^{m+})ₐ(C^{(am)-}) (I)

   [in the formula (I),
   A^{m+} each independently denotes H⁺, a metal ion, an onium cation, or an onium dication;
   C^{(am)-} denotes an isopolyacid anion, a heteropolyacid anion, or a heteropolyacid anion having a lacunary site in which the lacunary site is modified;
   A^{m+} and/or C^{(am)-} has one or more polar groups each having an acid-dissociable group; and
   m denotes an integer in the range of 1 to 5, and a denotes a real number greater than 0]
<14> The resist material according to <1>, wherein the (A) polyacid salt having one or more polar groups each having an acid-dissociable group or the mixture thereof is a polyacid salt having one or more polar groups each having an acid-dissociable group represented by the general formula (I') or a mixture thereof.

   (A'^{m'+})_{a'}(Bⁿ⁺)_{b}(C'^{(a'm'+bn)-}) (I')

   [in the formula (I'),
   A'^{m'+} each independently denotes H⁺, a metal ion, an ammonium cation, an ammonium dication, a phosphonium cation, or a phosphonium dication;
   Bⁿ⁺ each independently denotes a sulfonium cation, a sulfonium dication, or an iodonium cation;
   C'^{(a'm'+bn)-} denotes an isopolyacid anion, a heteropolyacid anion, or a heteropolyacid anion having a lacunary site in which the lacunary site is modified;
   A'^{m'+}, Bⁿ⁺, and/or C'^{(a'm'+bn)-} has one or more polar groups each having an acid-dissociable group; and
   m' denotes an integer in the range of 1 to 5, n denotes an integer of 1 or 2, a' denotes a real number, and b denotes a real number greater than 0]
<15> The resist material according to <1>, wherein the (B) polymer includes one or more structural units selected from the group consisting of a structural unit having a phenolic hydroxy group, a structural unit for adjusting solubility in a developer, and a structural unit having a fluorine atom.
<16> The resist material according to <1>, wherein a content ratio of the (B) polymer ranges from 0.1 to 200 parts by mass when a blending amount of the (A) polyacid salt having one or more polar groups each having an acid-dissociable group or the mixture thereof is 100 parts by mass.
<17> The resist material according to <15>, wherein the structural unit for adjusting solubility in a developer is a structural unit represented by the general formula (VIII-2) or (VIII-3). 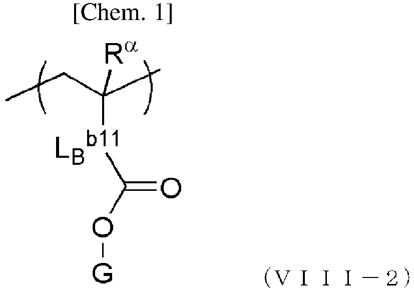 [in the formula (VIII-2),
   Rα denotes a hydrogen atom, a halogen atom, a C₁₋₃ alkyl group, or a C₁₋₃ haloalkyl group;
   L_{B}^{b11} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂-(provided that adjacent divalent carbon atoms are not substituted at the same time); and
   G denotes a tertiary-carbon-type acid-dissociable group, an allyl- or benzyl-type acid-dissociable group, or an acetal-type acid-dissociable group] 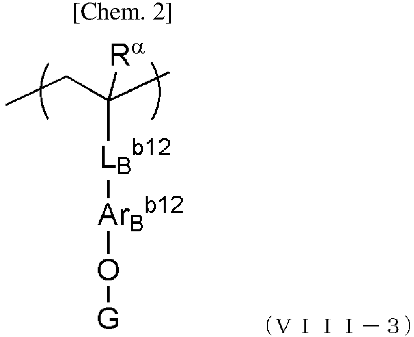 [in the formula (VIII-3),
   Rα denotes a hydrogen atom, a halogen atom, a C₁₋₃ alkyl group, or a C₁₋₃ haloalkyl group;
   L_{B}^{b12} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂-(provided that adjacent divalent carbon atoms are not substituted at the same time);
   Ar_{B}^{b12} denotes a C₆₋₁₈ arylene group optionally having a substituent; and
   G denotes a tertiary-carbon-type acid-dissociable group, an allyl- or benzyl-type acid-dissociable group, or an acetal-type acid-dissociable group]
<18> The resist material according to <15>, wherein the structural unit having a fluorine atom is a structural unit represented by the general formula (VIII-5) or (VIII-6). 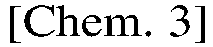 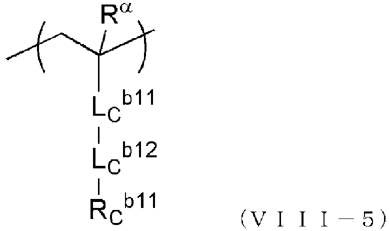 [in the formula (VIII-5),
   Rα denotes a hydrogen atom, a halogen atom, a C₁₋₃ alkyl group, or a C₁₋₃ haloalkyl group;
   L_{C}^{b11} denotes a single bond, -O-, -C(=O)-, -C(=O)-O-, -O-C(=O)-, -CONH-, - NH(C=O)-, -S-, or -SO₂-;
   L_{C}^{b12} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂-(provided that adjacent divalent carbon atoms are not substituted at the same time); and
   R_{C}^{b11} denotes a C₁₋₈ hydrocarbyl group optionally having a substituent in which at least one hydrogen atom is substituted with a fluorine atom] 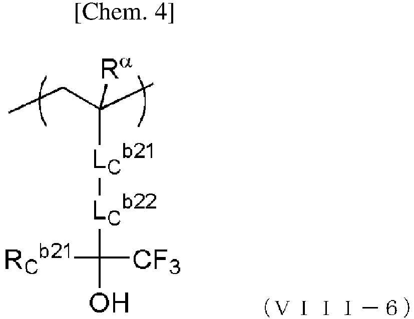 [in the formula (VIII-6),
   Rα denotes a hydrogen atom, a halogen atom, a C₁₋₃ alkyl group, or a C₁₋₃ haloalkyl group;
   L_{C}^{b21} denotes a single bond, -O-, -C(=O)-, -C(=O)-O-, -O-C(=O)-, -CONH-, - NH(C=O)-, -S-, or -SO₂-;
   R_{C}^{b21} denotes a hydrogen atom, a fluorine atom, or a C₁₋₄ alkyl group optionally having a substituent in which at least one hydrogen atom is substituted with a fluorine atom;
   Rα and L_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group, thereby forming a ring; and
   L_{C}^{b21} and R_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group, thereby forming a ring]
<19> A pattern forming method including:
   a step of forming a resist film using the resist material according to any one of <1> to <18>;
   a step of exposing the resist film; and
   a step of developing the exposed resist film using a developer.
<20> The pattern forming method according to <19>, wherein the step of exposing the resist film includes a step of exposing the resist film to an electron beam with a dose of 2 mC/cm² or less or extreme ultraviolet of 200 mJ/cm² or less.
<21> A patterned structure formed by patterning the resist material according to any one of <1> to <18>.

### Advantageous Effects of Invention

The present invention can provide a novel resist material, a pattern forming method, and a patterned structure.

At least one polar group having an acid-dissociable group is introduced into the (A) polyacid salt or the mixture thereof contained in a resist material according to the present invention. Thus, it is possible to provide a resist material whose solubility in a developer can be changed by the action of an acid or the like.

The component (A) may contain an isopolyacid anion, a heteropolyacid anion, or a heteropolyacid anion having a lacunary site in which the lacunary site is modified in an anion moiety thereof and an onium cation or onium dication in a cation moiety thereof. Thus, a resist material according to the present invention has high sensitivity to a source of DUV, XUV, EUV, an electron beam, or the like.

Furthermore, a resist material that generates an acid upon exposure to DUV, XUV, EUV, an electron beam, or the like can be provided by introducing a sulfonium cation, a sulfonium dication, or an iodonium cation into the cation moiety of the component (A).

A resist material according to the present invention contains a (B) polymer in addition to the component (A). Thus, etch resistance can be obtained by containing the component (A), and the EL margin can be increased by containing the component (B).

### Description of Embodiments

Preferred embodiments of the present invention will be described in detail below. However, the present invention is not limited to the following embodiments.

In the present description, the term "(meth)acryloyl group" is used to mean both an acryloyl group and a methacryloyl group.

The term "halogen atom", as used herein, refers to a fluorine atom, a chlorine atom, a bromine atom, or an iodine atom.

In the present description, for example, the term "C₁₋₆" or the like means the number of carbon atoms of a group serving as a mother nucleus.

The term "C₁₋₁₈ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.

A divalent carbon atom at any position of the "C₁₋₁₈ hydrocarbylene group" may be substituted with -O-, -S-, -C(=O)-, -COO-, -OCO-, -CONH-, -NHCO-, -NH(C=O)O-, -S-, -SO-, or -SO₂- (provided that adjacent divalent carbon atoms are not substituted at the same time).

The "C₁₋₁₈ hydrocarbylene group" is, for example, but not limited to, a "C₁₋₁₈ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "C₆₋₁₈ arylene group", such as a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group; or the like.

The term "C₁₋₁₈ alkyl group", as used herein, refers to a linear or branched alkyl group with 1 to 18 carbon atoms.

Furthermore, a divalent carbon atom at any position excluding the terminals contained in the "C₁₋₁₈ alkyl group" may be substituted with -O-, -C(=O)-, -C(=O)O-, - OCO-, -CONH-, -NHCO-, -NH(C=O)O-, -S-, or -SO₂-. However, adjacent divalent carbon atoms are not substituted at the same time.

The "C₁₋₁₈ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "C₁₋₁₈ alkyl group" in which a divalent carbon atom at any non-terminal position is substituted with -O-, -C(=O)-, -C(=O)O-, -OCO-, -CONH-, -NHCO-, - NH(C=O)O-, -S-, or -SO₂- is, for example, but not limited to, a 2-methoxyethoxymethyl group, an ethoxycarbonylmethyl group, or the like.

The term "C₁₋₁₈ haloalkyl group", as used herein, refers to a group in which one or more hydrogen atoms of the "C₁₋₁₈ alkyl group" are substituted by a halogen atom.

The "C₁₋₁₈ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "C₂₋₁₈ alkenyl group", as used herein, refers to an alkenyl group having one or more double bonds in the "C₁₋₁₈ alkyl group" having 2 or more carbon atoms, and includes an alkadienyl group, an alkatrienyl group, or the like.

The "C₂₋₁₈ alkenyl group" is, for example, but not limited to, a vinyl group (ethenyl group), an allyl group (2-propenyl group), a 1-propenyl group, an isopropenyl group (1-methyl vinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "C₂₋₁₈ alkynyl group", as used herein, refers to an alkynyl group having one or more triple bonds in the "C₁₋₁₈ alkyl group" having 2 or more carbon atoms.

The "C₂₋₁₈ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "C₃₋₁₈ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, or the like.

A divalent carbon atom at any non-terminal position in the "C₃₋₁₈ alicyclic group" may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time).

The "C₃₋₁₈ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbornyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, the group being monocyclic, polycyclic, or condensed, and being saturated or partially unsaturated.

The "3- to 18-membered non-aromatic heterocyclic group" is, for example, but not limited to, an aziridinyl group, an azetidyl group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "C₂₋₁₈ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and a sulfur atom form a ring, and the ring may be monocyclic, polycyclic, or a fused ring.

The "C₂₋₁₈ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "C₇₋₁₈ aralkyl group", as used herein, refers to a group in which a substitutable portion of a "C₁₋₁₂ alkyl group" is substituted by the "C₂₋₁₂ aryl group".

The "C₇₋₁₈ aralkyl group" is, for example, but not limited to, a benzyl group, a phenethyl group, a 3-phenylpropyl group, a 4-phenylbutyl group, a 1-naphthylmethyl group, a 2-naphthylmethyl group, or the like.

The term "C₁₋₁₈ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, or the like.

A divalent carbon atom at any non-terminal position in the "C₁₋₁₈ hydrocarbyl group" may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time). The same applies to the "C₁₋₁₈ hydrocarbyl group" or the like used in the following description of the definition of the "C₁₋₁₈ hydrocarbyloxy group" or the like.

The "C₁₋₁₈ hydrocarbyl group" is, for example, but not limited to, a "C₁₋₁₈ alkyl group", a "C₂₋₁₈ alkenyl group", a "C₂₋₁₈ alkynyl group", a "C₃₋₁₈ alicyclic group", a "C₂₋₁₈ aryl group", a "C₇₋₁₈ aralkyl group", or the like.

The term "C₁₋₁₈ hydrocarbyloxy group", as used herein, refers to a group in which an oxygen atom (-O-) is bonded to the "C₁₋₁₈ hydrocarbyl group".

The "C₁₋₁₈ hydrocarbyloxy group" is, for example, but not limited to, a "C₁₋₁₈ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "C₃₋₁₈ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "C₆₋₁₈ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "C₁₋₁₈ hydrocarbyloxy group", a divalent carbon atom at any non-terminal position in the "C₁₋₁₈ hydrocarbyl group" is preferably substituted with -O-, -C(=O)-, and/or -C(=O)O-, the "C₁₋₁₈ hydrocarbyloxy group" is more preferably a "C₁₋₁₈ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, or the like.

The term "C₁₋₁₈ hydrocarbylcarbonyl group", as used herein, refers to a group in which a carbonyl group (-C(=O)-) is bonded to the "C₁₋₁₈ hydrocarbyl group".

The "C₁₋₁₈ hydrocarbylcarbonyl group" is, for example, but not limited to, a "C₁₋₁₈ alkyl carbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "C₃₋₁₈ alicyclic carbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "C₆₋₁₈ aryl carbonyl group", such as a benzoyl group, a 1-naphthoyl group, or a 2-naphthoyl group; or the like.

The term "C₁₋₁₈ hydrocarbylcarbonyloxy group", as used herein, refers to a group in which an oxygen atom (-O-) is bonded to the "C₁₋₁₈ hydrocarbylcarbonyl group".

The "C₁₋₁₈ hydrocarbylcarbonyloxy group" is, for example, but not limited to, a "C₁₋₁₈ alkyl carbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "C₃₋₁₈ alicyclic carbonyloxy group", such as a cyclopropyl carbonyloxy group, a cyclobutyl carbonyloxy group, a cyclopentyl carbonyloxy group, or a cyclohexyl carbonyloxy group; a "C₆₋₁₈ aryl carbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "C₁₋₁₈ hydrocarbyloxycarbonyl group", as used herein, refers to a group in which a carbonyl group (-C(=O)-) is bonded to a "C₁₋₁₈ hydrocarbyloxy group".

The "C₁₋₁₈ hydrocarbyloxycarbonyl group" is, for example, but not limited to, a "C₁₋₁₈ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "C₃₋₁₈ alicyclic oxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "C₆₋₁₈ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "C₁₋₁₈ hydrocarbyloxycarbonyloxy group", as used herein, refers to a group in which an oxygen atom (-O-) is bonded to the "C₁₋₁₈ hydrocarbyloxycarbonyl group".

The "C₁₋₁₈ hydrocarbyloxycarbonyloxy group" is, for example, but not limited to, a "C₁₋₁₈ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "C₃₋₁₈ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "C₆₋₁₈ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "C₁₋₁₈ hydrocarbylamino group", as used herein, refers to a group in which one "C₁₋₁₈ hydrocarbyl group" is bonded to an amino group.

The "C₁₋₁₈ hydrocarbylamino group" is, for example, but not limited to, a "C₁₋₁₈ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "C₃₋₁₈ alicyclic amino group", such as a cyclopropyl amino group, a cyclobutyl amino group, a cyclopentyl amino group, a 2-methylcyclopentyl amino group, a 3-methylcyclopentyl amino group, a cyclohexyl amino group, a 2-methylcyclohexyl amino group, a 3-methylcyclohexyl amino group, or a 4-methylcyclohexyl amino group; a "C₆₋₁₈ arylamino group", such as a phenylamino group, a 1-naphthylamino group, or a 2-naphthylamino group; or the like.

The term "di-C₁₋₁₈ hydrocarbylamino group", as used herein, refers to a group in which two identical or different "C₁₋₁₈ hydrocarbyl groups" are bonded to an amino group.

The "di-C₁₋₁₈ hydrocarbylamino group" is, for example, but not limited to, a "di-C₁₋₁₈ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-C₃₋₁₈ alicyclic amino group", such as a dicyclopropylamino group, a dicyclobutylamino group, a dicyclopentylamino group, or a dicyclohexylamino group; a "di-C₆₋₁₈ arylamino group", such as a diphenylamino group or a phenylnaphthylamino group; an "N-C₁₋₁₈ alkyl-N-C₃₋₁₈ cycloalkylamino group", such as an N-methylcyclopentaneamino group or an N-methylcyclohexylamino group; an "N-C₁₋₁₈ alkyl-N-C₆₋₁₈ arylamino group", such as an N-methyl-2-phenylethylamino group or an N-ethyl-N-(4-methylphenyl)amino group; or the like.

The term "C₁₋₁₈ hydrocarbylaminocarbonyl group", as used herein, refers to a group in which a carbonyl group (-C(=O)-) is bonded to the "C₁₋₁₈ hydrocarbylamino group".

The "C₁₋₁₈ hydrocarbylaminocarbonyl group" is, for example, but not limited to, a "C₁₋₁₈ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "C₃₋₁₈ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "C₆₋₁₈ arylaminocarbonyl group", such as a phenylaminocarbonyl group, a 1-naphthylaminocarbonyl group, or a 2-naphthylaminocarbonyl group.

The term "di-C₁₋₁₈ hydrocarbylaminocarbonyl group", as used herein, refers to a group in which a carbonyl group (-C(=O)-) is bonded to a "di-C₁₋₁₈ hydrocarbylamino group".

The "di-C₁₋₁₈ hydrocarbylaminocarbonyl group" is, for example, but not limited to, a "di-C₁₋₁₈ alkylaminocarbonyl group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group, or an N-ethyl-N-n-hexylaminocarbonyl group; a "di-C₃₋₁₈ alicyclic aminocarbonyl group", such as a dicyclopropylaminocarbonyl group, a dicyclobutylaminocarbonyl group, a dicyclopentylaminocarbonyl group, or a dicyclohexylaminocarbonyl group; a "di-C₆₋₁₈ arylaminocarbonyl group", such as a diphenylaminocarbonyl group or a phenylnaphthylaminocarbonyl group; or the like.

The term "C₁₋₁₈ hydrocarbylcarbonylamino group", as used herein, refers to a group in which an amino group is bonded to the "C₁₋₁₈ hydrocarbylcarbonyl group".

The "C₁₋₁₈ hydrocarbylcarbonylamino group" is, for example, but not limited to, a "C₁₋₁₈ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "C₃₋₁₈ alicyclic carbonylamino group", such as a cyclopropyl carbonylamino group, a cyclobutyl carbonylamino group, a cyclopentyl carbonylamino group, or a cyclohexyl carbonylamino group; a "C₆₋₁₈ aryl carbonylamino group", such as a phenyl carbonylamino group, a naphthyl carbonylamino group, an acenaphthyl carbonylamino group, a phenanthrenyl carbonylamino group, or an anthracenyl carbonylamino group; or the like.

The term "C₁₋₁₈ hydrocarbylaminocarbonyloxy group", as used herein, refers to a group in which an oxygen atom (-O-) is bonded to the "C₁₋₁₈ hydrocarbylaminocarbonyl group".

The "C₁₋₁₈ hydrocarbylaminocarbonyloxy group" is, for example, but not limited to, a "C₁₋₁₈ alkylaminocarbonyloxy group", such as a methylaminocarbonyloxy group, an ethylaminocarbonyloxy group, or a n-propylaminocarbonyloxy group; a "C₃₋₁₈ alicyclicaminocarbonyloxy group", such as a cyclopropylaminocarbonyloxy group or a cyclohexylaminocarbonyloxy group; a "C₆₋₁₈ arylaminocarbonyloxy group", such as a phenylaminocarbonyloxy group or a 1-naphthylaminocarbonyloxy group; or the like.

The term "di-C₁₋₁₈ hydrocarbylaminocarbonyloxy group", as used herein, refers to a group in which an oxygen atom (-O-) is bonded to the "di-C₁₋₁₈ hydrocarbylaminocarbonyl group".

The "di-C₁₋₁₈ hydrocarbylaminocarbonyloxy group" is, for example, but not limited to, a "di-C₁₋₁₈ alkylaminocarbonyloxy group", such as a dimethylaminocarbonyloxy group, a diethylaminocarbonyloxy group, a di-n-propylaminocarbonyloxy group, or the like.

The term "C₁₋₁₈ hydrocarbylaminocarbonylamino group", as used herein, refers to a group in which the "C₁₋₁₈ hydrocarbylaminocarbonyl group" is bonded to an amino group.

The "C₁₋₁₈ hydrocarbylaminocarbonylamino group" is, for example, but not limited to, a "C₁₋₁₈ alkylaminocarbonylamino group", such as a methylaminocarbonylamino group, an ethylaminocarbonylamino group, or a n-propylaminocarbonylamino group; a "C₃₋₁₈ alicyclic aminocarbonylamino group", such as a cyclopropylaminocarbonylamino group or a cyclohexylaminocarbonylamino group; a "C₆₋₁₈ arylaminocarbonylamino group", such as a phenylaminocarbonylamino group or a 1-naphthylaminocarbonylamino group; or the like.

The term "di-C₁₋₁₈ hydrocarbylaminocarbonylamino group", as used herein, refers to a group in which a "di-C₁₋₁₈ hydrocarbylaminocarbonyl group" is bonded to an amino group.

The "di-C₁₋₁₈ hydrocarbylaminocarbonylamino group" is, for example, but not limited to, a "di-C₁₋₁₈ alkylaminocarbonylamino group", such as a dimethylaminocarbonylamino group, a diethylaminocarbonylamino group, a di-n-propylaminocarbonylamino group; or the like.

The term "C₁₋₁₈ hydrocarbyloxycarbonylamino group", as used herein, refers to a group in which the "C₁₋₁₈ hydrocarbyloxycarbonyl group" is bonded to an amino group.

The "C₁₋₁₈ hydrocarbyloxycarbonylamino group" is, for example, but not limited to, a "C₁₋₁₈ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "C₃₋₁₈ alicyclic oxycarbonylamino group", such as a cyclopropyloxycarbonylamino group or a cyclohexyloxycarbonylamino group; a "C₆₋₁₈ aryloxycarbonylamino group", such as a phenyloxycarbonylamino group or a 1-naphthyloxycarbonylamino group; or the like.

The term "C₁₋₁₈ hydrocarbylthio group", as used herein, refers to a group in which a sulfur atom (-S-) is bonded to the "C₁₋₁₈ hydrocarbyl group".

The "C₁₋₁₈ hydrocarbylthio group" is, for example, but not limited to, a "C₁₋₁₈ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "C₃₋₁₈ alicyclicthio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "C₆₋₁₈ arylthio group", such as a phenylthio group, a 1-naphthylthio group, a 2-naphthylthio group, an acenaphthylthio group, a phenanthrenylthio group, or an anthracenylthio group; or the like.

The term "C₁₋₁₈ hydrocarbylsulfinyl group", as used herein, refers to a group in which a sulfinyl group (-S(=O)-) is bonded to the "C₁₋₁₈ hydrocarbyl group".

The "C₁₋₁₈ hydrocarbylsulfinyl group" is, for example, but not limited to, a "C₁₋₁₈ alkylsulfinyl group", such as a methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "C₃₋₁₈ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "C₆₋₁₈ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "C₁₋₁₈ hydrocarbylsulfonyl group", as used herein, refers to a group in which a sulfonyl group (-SO₂-) is bonded to the "C₁₋₁₈ hydrocarbyl group".

The "C₁₋₁₈ hydrocarbylsulfonyl group" is, for example, but not limited to, a "C₁₋₁₈ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "C₃₋₁₈ alicyclicsulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexyl group; a "C₆₋₁₈ arylsulfonyl group", such as a phenylsulfonyl group, a naphthylsulfonyl group, an acenaphthylsulfonyl group, a phenanthrenylsulfonyl group, an anthracenylsulfonyl group, or the like.

In the present specification, the term "acid-dissociable group" refers to a group that substitutes for a hydrogen atom of a polar group, such as a hydroxy group (including a phenolic hydroxy group or the like), a carboxy group, an amino group, a sulfo group, or the like, and that is dissociated by the action of an acid.

In a compound having the polar groups with the above acid-dissociable group, the acid-dissociable group can be dissociated by the action of an acid to generate the polar group, thus increasing polarity of the compound. This enables solubility of the compound in a developer to be changed. More specifically, when a highly polar developer such as an alkaline aqueous solution is used as the developer, solubility of the compound in the developer relatively increases, whereas, when a low-polarity organic developer is used as the developer, solubility of the compound in the developer relatively decreases.

The polar group is preferably a hydroxy group (including a phenolic hydroxy group or the like) or a carboxy group.

The acid-dissociable group is not particularly limited and may be a known and commonly used acid-dissociable group that can be used for a chemically amplified resist. The acid-dissociable group is, for example, an acid-dissociable group G for a polar group having an acid-dissociable group represented by any one of the following general formulae (G-1) to (G-4).

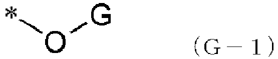

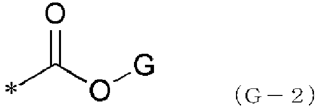

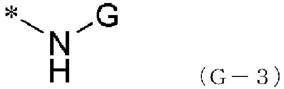

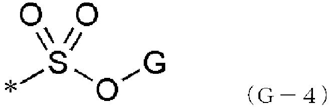

The acid-dissociable group G is not particularly limited, provided that it can be dissociated by the action of an acid, and may be a known and commonly used group. The acid-dissociable group G is, for example, a "tertiary-carbon-type acid-dissociable group G_{A}" represented by the following general formula (g-1), an "allyl- or benzyl-type acid-dissociable group G_{B}" represented by the following general formula (g-2), an "acetal-type acid-dissociable group G_{C}" represented by the following general formula (g-3), or the like. Each of them will be sequentially described below.

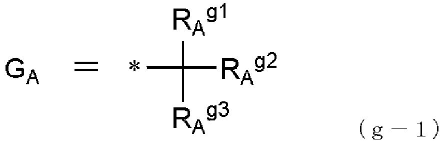

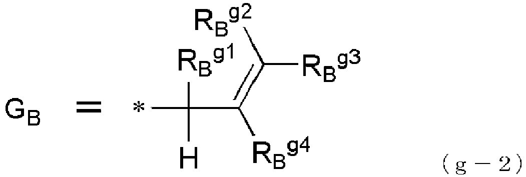

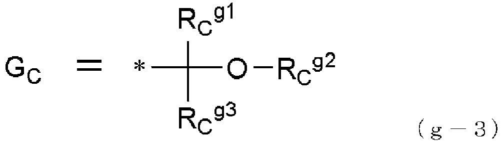

### <Tertiary-carbon-type Acid-Dissociable Group G_{A}>

As the acid-dissociable group G, an acid-dissociable group in which a carbon that is directly bonded to a polar group and to which R_{A}^{g1} to R_{A}^{g3} are bonded is a tertiary carbon atom, such as a "tertiary-carbon-type acid-dissociable group G_{A}" represented by the following general formula (g-1), can be used.

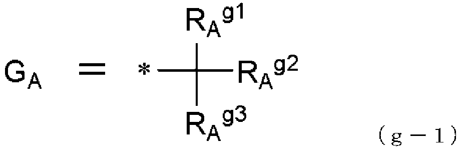

"R_{A}^{g1}" denotes an optionally substituted C₁₋₁₂ hydrocarbyl group in which any divalent carbon atom at any non-terminal position may be substituted with -O-, -C(=O)-, -C(=O)O-, -OCO-, -CONH-, NHCO-, -S-, or -SO₂- (provided that adjacent divalent carbon atoms are not substituted at the same time).

R_{A}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom at any non-terminal position may be substituted with -O-, -C(=O)-, - C(=O)O-, -OCO-, -CONH-, NHCO-, -S-, or -SO₂- (provided that adjacent divalent carbon atoms are not substituted at the same time),
and more preferably a C₁₋₁₂ alkyl group or a C₃₋₁₂ alicyclic group each optionally having a substituent and any divalent carbon atom at any non-terminal position may be substituted with -O-, -C(=O)-, -C(=O)O-, -OCO-, -CONH-, NHCO-, -S-, or -SO₂-(provided that adjacent divalent carbon atoms are not substituted at the same time).

"R_{A}^{g2}" and "R_{A}^{g3}" each independently denote an optionally substituted C₁₋₁₂ hydrocarbyl group, and a divalent carbon atom at any non-terminal position may be substituted with -O-, -C(=O)-, -C(=O)O-, -OCO-, -CONH-, NHCO-, -S-, or -SO₂-(provided that adjacent divalent carbon atoms are not substituted at the same time), or R_{A}^{g2} and R_{A}^{g3} may be combined to form a C₃₋₁₈ alicyclic group or a 3- to 18-membered non-aromatic heterocyclic group, each optionally having a substituent, and a divalent carbon atom at any position except the terminal positions may be substituted with -O-, - C(=O)-, -C(=O)O-, -OCO-, -CONH-, NHCO-, -S-, or -SO₂- (provided that adjacent divalent carbon atoms are not substituted at the same time).

In R_{A}^{g2} and R_{A}^{g3}, preferably, R_{A}^{g2} and R_{A}^{g3} may be combined to form a C₃₋₁₈ alicyclic group or a 3- to 18-membered non-aromatic heterocyclic group, each optionally having a substituent, and a divalent carbon atom at any non-terminal position may be substituted with -O-, -C(=O)-, -C(=O)O-, -OCO-, -CONH-, NHCO-, -S-, or -SO₂-(provided that adjacent divalent carbon atoms are not substituted at the same time).

More preferably, the substituted C₃₋₁₈ alicyclic group or the 3- to 18-membered non-aromatic heterocyclic group, each optionally having a substituent, has a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, and a divalent carbon atom at any position except the terminal positions may be substituted with -O-, -C(=O)-, -C(=O)O-, -OCO-, -CONH-, NHCO-, -S-, or -SO₂-(provided that adjacent divalent carbon atoms are not substituted at the same time).

A tertiary-carbon-type acid-dissociable group G_{A} represented by the general formula (g-1) is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

The tertiary-carbon-type acid-dissociable group G_{A} represented by the general formula (g-1) is, for example, any one of the following tertiary-carbon-type acid-dissociable groups.

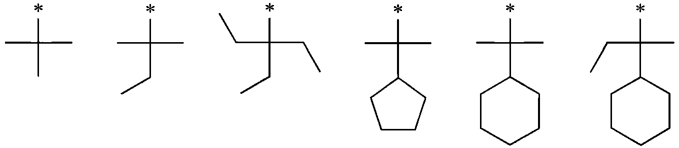

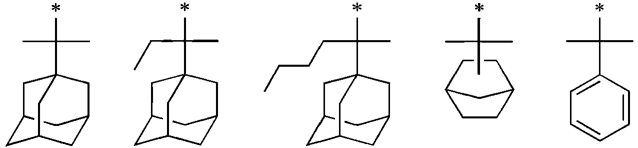

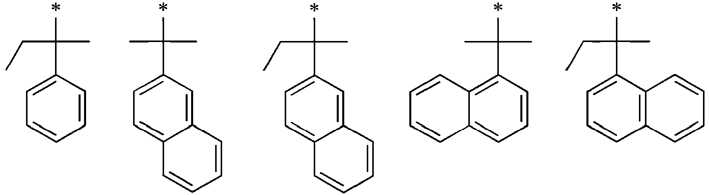

### <<Tertiary-Carbon-Type Acid-Dissociable Group G_{A1} and G_{A2}>>

In the "tertiary-carbon-type acid-dissociable group G_{A}" represented by the general formula (g-1), the case where R_{A}^{g2} and R_{A}^{g3} may be combined to form a C₃₋₁₈ alicyclic group or a 3- to 18-membered non-aromatic heterocyclic group, each optionally having a substituent, is, for example, a tertiary-carbon-type acid-dissociable group G_{A1} represented by the following general formula (g-1-1), a tertiary-carbon-type acid-dissociable group G_{A2} represented by the following general formula (g-1-2), or the like.

### <<Tertiary-Carbon-Type Acid-Dissociable Group G_{A1} Represented by General Formula (g-1-1)>>

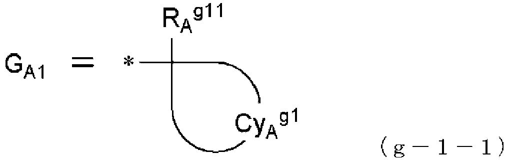

In the tertiary-carbon-type acid-dissociable group G_{A1} represented by the general formula (g-1-1), R_{A}^{g11} denotes a C₁₋₁₂ alkyl group, a C₃₋₁₂ alicyclic group, a C₆₋₁₂ aryl group, or a C₇₋₁₂ aralkyl group, each optionally having a substituent, and any divalent carbon atom at any non-terminal position may be substituted with -O-, -C(=O)-, - C(=O)O-, -OCO-, -CONH-, -NHCO-, -S-, or -SO₂- (provided that adjacent divalent carbon atoms are not substituted at the same time).

Cy_{A}^{g1}, together with the tertiary carbon atom, forms a C₃₋₁₈ alicyclic group or a 3-to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂- (provided that adjacent divalent carbon atoms are not substituted at the same time).

Preferably, Cy_{A}^{g1}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time).

The tertiary-carbon-type acid-dissociable group G_{A1} represented by the general formula (g-1-1) is, for example, the following tertiary-carbon-type acid-dissociable groups.

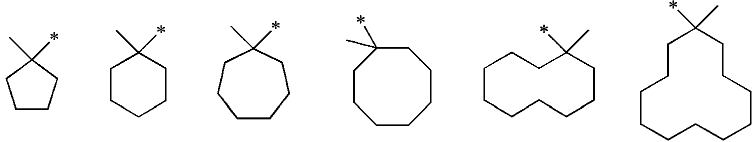

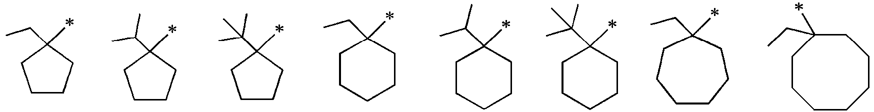

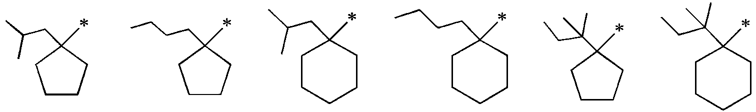

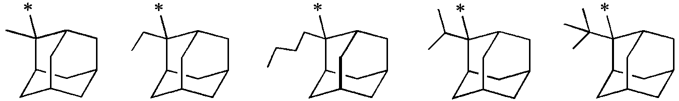

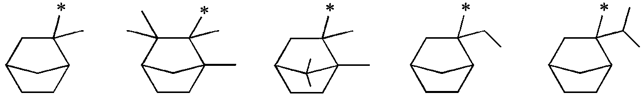

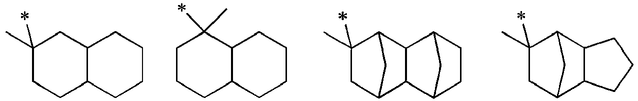

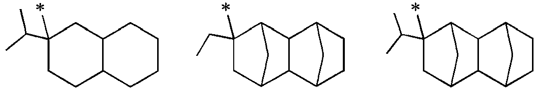

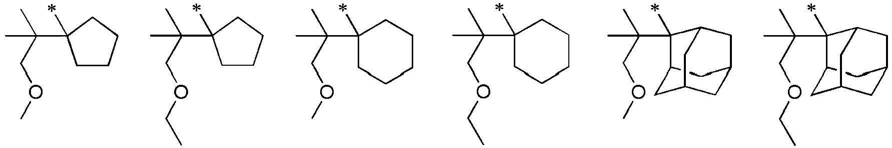

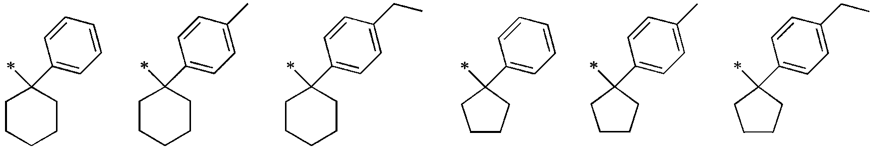

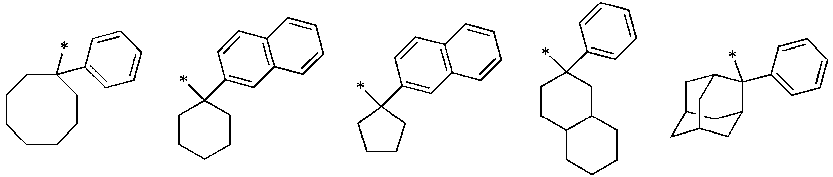

### <<Tertiary-Carbon-Type Acid-Dissociable Group G_{A2} Represented by General Formula (g-1-2)>>

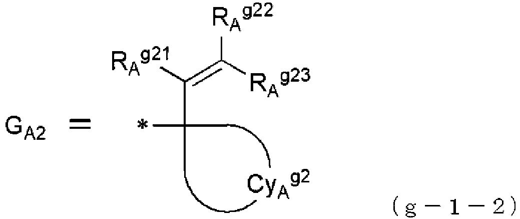

In the general formula (g-1-2), R_{A}^{g21} to R_{A}^{g23} each independently denote a hydro group or an optionally substituted C₁₋₁₂ hydrocarbyl group, any divalent carbon atom except the terminal positions may be substituted with -O-, -C(=O)-, -C(=O)O-, -OCO-, - CONH-, NHCO-, -S-, or -SO₂- (provided that adjacent divalent carbon atoms are not substituted at the same time), and R_{A}^{g21} and R_{A}^{g22}, and/or R_{A}^{g22} and R_{A}^{g23} may be directly bonded to each other by a single bond or may be bonded to each other via a divalent linker such as, -O-, -S-, -C(=O)-, -S(=O)-, -S(=O)₂-, -C(=O)O-, or a C₁₋₃ alkylene group, to form a ring.

The case where R_{A}^{g21} and R_{A}^{g22}, and/or R_{A}^{g22} and R_{A}^{g23} form a ring together with a carbon atom contained in the ethylenically unsaturated double bond is, for example, a case where they form a cyclopentenyl group, a cyclohexenyl group, a cyclopentylidene ethenyl group, a cyclohexylidene ethenyl group, or the like, each optionally having a substituent.

Cy_{A}^{g2}, together with the tertiary carbon atom, forms a C₃₋₁₈ alicyclic group or a 3-to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂- (provided that adjacent divalent carbon atoms are not substituted at the same time).

Preferably, Cy_{A}^{g2}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time).

The tertiary-carbon-type acid-dissociable group G_{A2} represented by the general formula (g-1-2) is, for example, the following tertiary-carbon-type acid-dissociable groups.

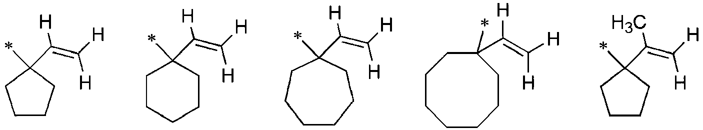

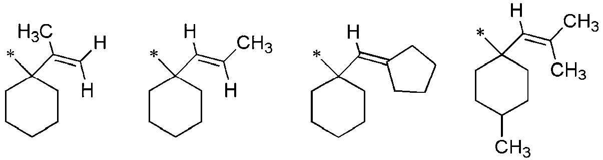

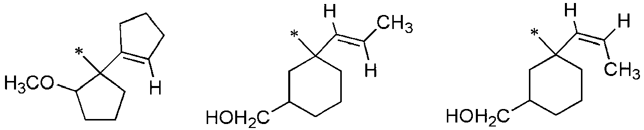

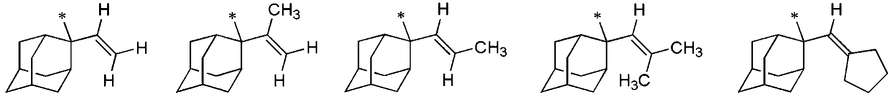

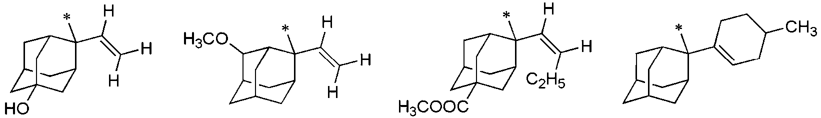

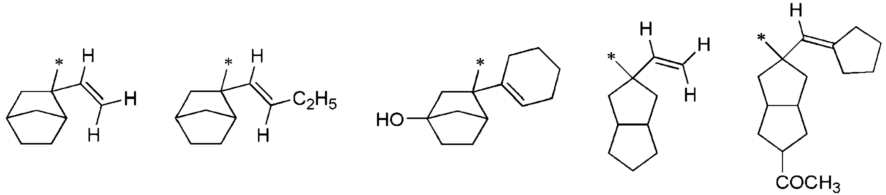

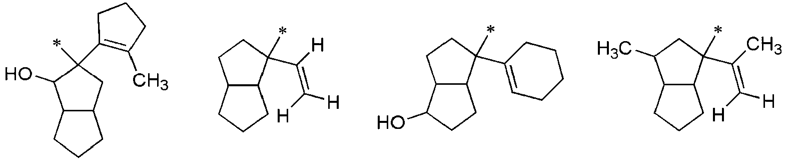

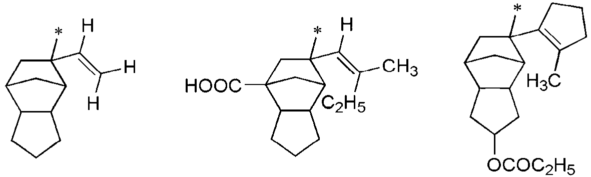

### <Allyl-Type or Benzyl-Type Acid-Dissociable Group G_{B}>

As the acid-dissociable group G, an acid-dissociable group in which a carbon that is directly bonded to a polar group corresponds to the allylic position or the benzylic position, such as an "allyl-type or benzyl-type acid-dissociable group G_{B}" represented by the following general formula (g-2), can be used.

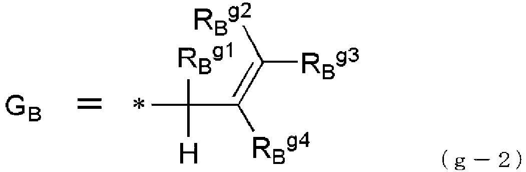

"R_{B}^{g1}" denotes an optionally substituted C₁₋₁₂ hydrocarbyl group in which any divalent carbon atom except the terminal positions may be substituted with -O-, -C(=O)-, -C(=O)O-, -OCO-, -CONH-, NHCO-, -S-, or -SO₂- (provided that adjacent divalent carbon atoms are not substituted at the same time).

R_{B}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom except the terminal positions may be substituted with -O-, -C(=O)-, - C(=O)O-, -OCO-, -CONH-, NHCO-, -S-, or -SO₂- (provided that adjacent divalent carbon atoms are not substituted at the same time),
more preferably a C₁₋₁₂ alkyl group or a C₃₋₁₂ alicyclic group each optionally having a substituent and any divalent carbon atom except the terminal positions may be substituted with -O-, -C(=O)-, -C(=O)O-, -OCO-, -CONH-, NHCO-, -S-, or -SO₂- (provided that adjacent divalent carbon atoms are not substituted at the same time).

"R_{B}^{g2}" to "R_{B}^{g4}" each independently denote a hydro group, or an optionally substituted C₁₋₁₂ hydrocarbyl group in which any divalent carbon atom except the terminal positions may be substituted with -O-, -C(=O)-, -C(=O)O-, -OCO-, -CONH-, NHCO-, - S-, or -SO₂- (provided that adjacent divalent carbon atoms are not substituted at the same time).

R_{B}^{g1} and R_{B}^{g2}, R_{B}^{g2} and R_{B}^{g3}, and/or R_{B}^{g3} and R_{B}^{g4} may be linked to each other directly by a single bond or via divalent linking -O-, -S-, -C(=O)-, -S(=O)-, -S(=O)₂-, - C(=O)O-, or a C₁₋₃ alkylene group to form a ring.

In the allyl-type or benzyl-type acid-dissociable group G_{B} represented by general formula (g-2), the case where R_{B}^{g1} and R_{B}^{g2}, R_{B}^{g2} and R_{B}^{g3}, and/or R_{B}^{g3} and R_{B}^{g4} form a ring together with a carbon atom contained in an ethylenically unsaturated double bond is, for example, a case where they form a cyclopentenyl group, a cyclohexenyl group, a cyclopentylidene ethenyl group, a cyclohexylidene ethenyl group, a benzyl group, a 2,3-dihydro-1H-indanyl group, or the like, each optionally having a substituent.

Examples of the allyl-type or benzyl-type acid-dissociable group G_{B} represented by general formula (g-2) include the following allyl-type or benzyl-type acid-dissociable groups.

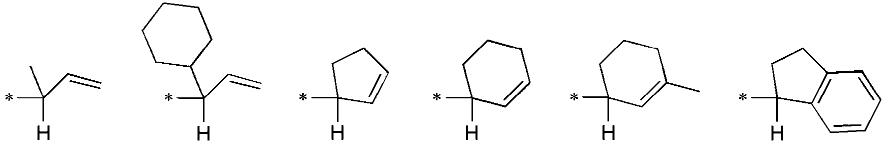

### <Acetal-Type Acid-Dissociable Group G_{C}>

The acid-dissociable group G can be an acid-dissociable group in which an oxygen atom is bonded to a carbon atom directly bonded to a polar group, such as an "acetal-type acid-dissociable group G_{C}" represented by the following general formula (g-3).

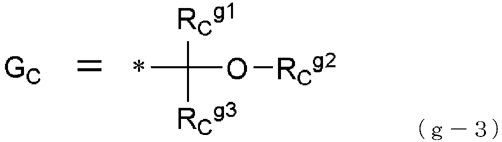

"R_{C}^{g1}" and "R_{C}^{g3}" each independently denote a hydro group, or an optionally substituted C₁₋₁₂ hydrocarbyl group in which any divalent carbon atom except the terminal positions may be substituted with -O-, -C(=O)-, -C(=O)O-, -OCO-, -CONH-, NHCO-, - S-, or -SO₂- (provided that adjacent divalent carbon atoms are not substituted at the same time).

Preferably, R_{C}^{g1} and R_{C}^{g3} denote a hydro group, or a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, -CONH-, NHCO-, -S-, or -SO₂-(provided that adjacent divalent carbon atoms are not substituted at the same time),
more preferably a hydro group, or a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, - C(=O)O-, -OCO-, -CONH-, NHCO-, -S-, or -SO₂- (provided that adjacent divalent carbon atoms are not substituted at the same time).

"R_{C}^{g2}" denotes an optionally substituted C₁₋₁₂ hydrocarbyl group in which any divalent carbon atom except the terminal positions may be substituted with -O-, -C(=O)-, -C(=O)O-, -OCO-, -CONH-, NHCO-, -S-, or -SO₂- (provided that adjacent divalent carbon atoms are not substituted at the same time).

Preferably, R_{C}^{g2} denotes a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, - C(=O)O-, -OCO-, -CONH-, NHCO-, -S-, or -SO₂- (provided that adjacent divalent carbon atoms are not substituted at the same time),
more preferably a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, NHCO-, -S-, or -SO₂- (provided that adjacent divalent carbon atoms are not substituted at the same time).

The acetal-type acid-dissociable group G_{C} represented by the general formula (g-3) is, for example, a methoxymethoxy group, an ethoxymethoxy group, a n-propoxymethoxy group, a n-butoxymethoxy group, a 2,2-dimethylpropoxymethoxy group, a 2,2-dimethylbutoxymethoxy group, a cyclohexyloxymethoxy group, a 1-ethoxyethoxy group, a 1-n-butoxyethoxy group, a 1-cyclohexyloxyethoxy group, or the like.

The term "a hydroxy or carboxy group having a protective group", as used herein, refers to a hydroxy or carboxy group in which the hydroxy group (including a phenolic hydroxy group) or the carboxy group is protected by an ether protective group, a silyl ether protective group, an acyl protective group, an aminocarbonyl protective group, or the like.

The ether protective group is, for example, but not limited to, a methyl group, a benzyl group, a p-methoxybenzyl group, a t-butyl group, a triphenylmethyl group, a p-methoxyphenyldiphenylmethyl group, a di(p-methoxyphenyl)phenylmethyl group, or the like.

The silyl ether protective group is, for example, but not limited to, a t-butyldimethylsilyl group (TBS), a triisopropylsilyl group (TIPS), a trimethylsilyl group (TMS), a triethylsilyl group (TES), a t-butyldiphenylsilyl group (TBDPS), or the like.

The acyl protective group is, for example, but not limited to, an acetyl group, a pivaloyl group, a benzoyl group, or the like.

The aminocarbonyl protective group is not particularly limited but is, for example, a dimethylaminocarbonyl group, a diethylaminocarbonyl group, a diisopropylaminocarbonyl group, an N-phenyl-N-methyl-aminocarbonyl group, or the like.

The phrase "optionally substituted" or "optionally having a substituent", as used herein, is not particularly limited provided that it is chemically acceptable and has the advantages of the present invention.

The "substituent" is, for example, (1) a halogen atom, (2) a haloalkyl group, (3) a hydroxy group, (4) a thiol group, (5) a nitro group, (6) a cyano group, (7) a carboxy group, (8) an amino group, (9) a sulfo group, (10) a vinyl group, (11) an allyl group, (12) a (meth)acryloyl group, (13) a (meth)acryloyloxy group, (14) a (meth)acrylamide group, (15) a styryl group, (16) an epoxy group, (17) a glycidyl group, (18) an amide group, (19) a hydroxy group or a carboxy group each having a protective group, (20) a polar group having an acid-dissociable group, or (21) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, a C₁₋₁₈ hydrocarbylthio group, a C₁₋₁₈ hydrocarbylsulfinyl group, or a C₁₋₁₈ hydrocarbylsulfonyl group, in which at least part of hydrogen atoms may be substituted with (1) to (20), and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time), or the like.

### [1. Resist Material]

A resist material according to the present embodiment contains (A) a polyacid salt having one or more polar groups each having an acid-dissociable group or a mixture thereof and (B) a polymer.

Furthermore, the resist material according to the present embodiment may contain an organic solvent, another component, and the like as optional components.

### [1-1. (A) Polyacid Salt Having One or More Polar Groups Each Having Acid-Dissociable Group or Mixture Thereof]

The anion moiety of the (A) polyacid salt having one or more polar groups each having an acid-dissociable group or the mixture thereof according to the present embodiment is composed of an isopolyacid anion, a heteropolyacid anion, or a heteropolyacid anion having a lacunary site in which the lacunary site is modified. Furthermore, the cation moiety of the component (A) is composed of H⁺, a metal ion, an onium cation, or an onium dication.

One or more polar groups each having an acid-dissociable group may be included in the anion moiety, the cation moiety, or both the anion moiety and the cation moiety of the component (A).

Due to the anion moiety and/or the cation moiety of the component (A) containing one or more polar groups each having an acid-dissociable group, the acid-dissociable group can be dissociated by the action of an acid, and the solubility in a developer can be significantly changed.

### [1-1-1. Anion Moiety of Component (A)]

The anion moiety of the component (A) according to the present embodiment may be an isopolyacid anion, a heteropolyacid anion, or a heteropolyacid anion having a lacunary site in which the lacunary site is modified.

### [1-1-1-1. Isopolyacid Anion]

The isopolyacid anion according to the present embodiment is not particularly limited and may be, for example, an isopolyoxomolybdate anion, an isopolyoxotungstate anion, an isopolyoxovanadate anion, an isopolyoxoniobate anion, an isopolyoxotantalate anion, or the like.

The isopolyoxomolybdate anion is, for example, [MoO₄]²⁻, [Mo₇O₂₄]⁶⁻, [Mo₈O₂₆]⁴⁻, or the like. The isopolyoxotungstate anion is, for example, [W₄O₁₃]²⁻, [W₅O₁₆]²⁻, [W₆O₁₉]²⁻, [W₇O₂₂]²⁻, [W₇O₂₄]⁶⁻, [H_{z}W₁₂O₄₀]^{-(8-z)} (wherein z denotes an integer in the range of 1 to 4), [W₁₀O₃₂]⁴⁻, [H₄W₁₁O₃₈]⁶⁻, [H₇W₁₁O₄₀]⁷⁻, [HW₅O₁₉]⁷⁻, [H₃W₁₁O₂₂]⁵⁻, or the like. The isopolyoxovanadate anion is, for example, [V₄O₁₂]⁴⁻, [V₁₀O₂₈]⁶⁻, or the like, the isopolyoxoniobate anion is, for example, [Nb₆O₁₉]⁸⁻, [Nb₁₀O₂₈]⁶⁻, or the like, and the isopolyoxotantalate anion is, for example, [Ta₆O₁₉]⁸⁻, [Ta₈O₂₁]²⁻, or the like.

The isopolyoxomolybdate anion, the isopolyoxotungstate anion, the isopolyoxovanadate anion, the isopolyoxoniobate anion, and the isopolyoxotantalate anion include various isomers and the like.

The isopolyoxotungstate anion is preferably [W₄O₁₃]²⁻, [W₅O₁₆]²⁻, [W₆O₁₉]²⁻, [W₇O₂₂]²⁻, [W₇O₂₄]⁶⁻, [W₁₀O₃₂]⁴⁻, or [H_{z}W₁₂O₄₀]^{-(8-z)} (z denotes an integer in the range of 1 to 4), [H₄W₁₁O₃₈]⁶⁻, [H₇W₁₁O₄₀]⁷⁻, [HW₅O₁₉]⁷⁻, [H₃W₁₁O₂₂]⁵⁻, [H₄W₂₂O₇₄]¹²⁻, or [H₁₀W₃₄O₁₁₆]¹⁸⁻, more preferably [W₆O₁₉]²⁻, [W₇O₂₄]⁶⁻, [W₁₀O₃₂]⁴⁻, or [H_{z}W₁₂O₄₀]^{-(8-z)} (z denotes an integer in the range of 1 to 4), still more preferably [W₆O₁₉]²⁻, [W₇O₂₄]⁶⁻, [W₁₀O₃₂]⁴⁻, [H₂W₁₂O₄₀]⁶⁻, or [H₃W₁₂O₄₀]⁵⁻.

### [1-1-1-2. Heteropolyacid Anion]

The heteropolyacid anion according to the present embodiment is, for example, a heteropolyoxomolybdate anion, a heteropolyoxotungstate anion, a heteropolyoxovanadate anion, a heteropolyoxoniobate anion, a heteropolyoxotantalate anion, or the like.

The polyatom of the heteropolyacid anion is preferably Mo, W, V, Nb, or Ta, more preferably Mo or W.

The heteropolyoxomolybdate anion is, for example, a phosphomolybdate anion, a silicomolybdate anion, a boromolybdate anion, a thiomolybdate anion, a phosphotungstomolybdate anion, a cobalt molybdate anion, an arsenomolybdate anion, a germanomolybdate anion, or the like. The heteropolyoxotungstate anion is, for example, a phosphotungstate anion, a silicotungstate anion, a borotungstate anion, a thiotungstate anion, a cobalt tungstate anion, an arsenotungstate anion, a germanotungstate anion, or the like. The heteropolyoxovanadate anion is, for example, a phosphomolybdovanadate anion, a boromolybdovanadate anion, a boromolybdotungstovanadate anion, or the like.

The heteroatom of the heteropolyacid anion is preferably P, Si, Ge, B, S, Co, or As, more preferably P, Si, B, S, or Ge.

The heteropolyoxomolybdate anion, the heteropolyoxotungstate anion, the heteropolyoxovanadate anion, and the like include a Keggin type, a Dawson type, an Anderson type, and isomers thereof.

The heteropolyoxotungstate anion is preferably [PW₁₂O₄₀]³⁻, [SiW₁₂O₄₀]⁴⁻, [BW₁₂O₄₀]⁵⁻, [SW₁₂O₄₀]²⁻, [P₂W₁₈O₆₂]⁶⁻, or [Si₂W₁₈O₆₂]⁸⁻.

### [1-1-1-3. Heteropolyacid Anion Having Modified Lacunary Site]

The heteropolyacid anion having a lacunary site in which the lacunary site is modified according to the present embodiment can be a heteropolyacid anion having a modified lacunary site produced by reacting a terminal oxygen atom of the lacunary site in the heteropolyacid anion having the lacunary site with a P, Si, Ge, or Sn compound having one or more organic groups and two or more leaving groups.

### [1-1-1-3-1. Heteropolyacid Anion Having Lacunary Site]

The heteropolyacid anion having the lacunary site according to the present embodiment is not particularly limited and may be a lacunary species having a defect in part of the basic skeleton of the heteropolyacid anion, and any of a mono-lacunary species, a di-lacunary species, a tri-lacunary species, or the like may be used. The heteropolyacid anion having the lacunary site is, for example, a lacunary Keggin-type heteropolyacid anion, a lacunary Dawson-type heteropolyacid anion, or the like.

### [1-1-1-3-1-1. Lacunary Keggin-Type Heteropolyacid Anion]

The lacunary Keggin-type heteropolyacid anion is, for example, a mono-lacunary Keggin-type heteropolyacid anion represented by the following general formula (II-1), a di-lacunary Keggin-type heteropolyacid anion represented by the following general formula (II-2), a tri-lacunary Keggin-type heteropolyacid anion represented by the following general formula (II-3), or the like.

[XM₁₁O₃₉]^{c11-} (II-1)

[XM₁₀O₃₆]^{c12-} (II-2)

[XM₉O₃₄]^{c13-} (II-3)

(wherein
X denotes a heteroatom of P, Si, B, S, or Ge,
M denotes a polyatom of Mo, W, V, Nb, or Ta, and
c11- to c13- denote the number of negative charges, and c11 to c13 denote natural numbers.)

In the general formulae (II-1) to (II-3), the values of c11 to c13 vary with the types of X and M.

For example, in the general formula (II-1), when X denotes P and M denotes Mo or W, c11 is 7 ([PMo₁₁O₃₉]⁷⁻, [PW₁₁O₃₉]⁷⁻), when X denotes Si and M denotes Mo or W, c11 is 8 ([SiMo₁₁O₃₉]⁸⁻, [SiW₁₁O₃₉]⁸⁻), when X denotes S and M denotes Mo or W, c11 is 6 ([SMo₁₁O₃₉]⁶⁻, [SW₁₁O₃₉]⁶⁻), when X denotes B and M denotes Mo or W, c11 is 9 ([BMo₁₁O₃₉]⁹⁻, [BW₁₁O₃₉]⁹⁻), and when X denotes Ge and M denotes Mo or W, c11 is 8 ([GeMo₁₁O₃₉]⁸⁻, [GeW₁₁O₃₉]⁸⁻).

In the general formula (II-2), when X denotes P and M denotes Mo or W, c12 is 7 ([PMo₁₀O₃₆]⁷⁻, [PW₁₀O₃₆]⁷⁻), when X denotes Si and M denotes Mo or W, c12 is 8 ([SiMo₁₀O₃₆]⁸⁻, [SiW₁₀O₃₆]⁸⁻), when X denotes B and M denotes Mo or W, c12 is 9 ([BMo₁₀O₃₆]⁹⁻, [BW₁₀O₃₆]⁹⁻), and when X denotes Ge and M denotes Mo or W, c12 is 8 ([GeMo₁₀O₃₆]⁸⁻, [GeW₁₀O₃₆]⁸⁻).

In the general formula (II-3), for example, when X denotes P and M denotes Mo or W, c13 is 9 ([PMo₉O₃₄]⁹⁻, [PW₉O₃₄]⁹⁻), when X denotes Si and M denotes Mo or W, c13 is 10 ([SiMo₉O₃₄]¹⁰⁻, [SiW₉O₃₄]¹⁰⁻), when X denotes S and M denotes Mo or W, c13 is 8 ([SMo₉O₃₄]⁸⁻, [SW₉O₃₄]⁸⁻), and when X denotes Ge and M denotes Mo or W, c13 is 10 ([GeMo₉O₃₄]¹⁰⁻, [GeW₉O₃₄]¹⁰⁻).

The isomer structure of the lacunary Keggin-type heteropolyacid anion is preferably an α-form, a β-form, or a γ-form.

The isomer structure of the mono-lacunary Keggin-type heteropolyacid anion represented by the general formula (II-1) is preferably [α-PW₁₁O₃₉]⁷⁻, [β-PW₁₁O₃₉]⁷⁻, [γ-PW₁₁O₃₉]⁷⁻, [α-PMo₁₁O₃₉]⁷⁻, [β-PMo₁₁O₃₉]⁷⁻, [γ-PW₁₁O₃₉]⁷⁻, [α-SiW₁₁O₃₉]⁸⁻, [β-SiW₁₁O₃₉]⁸⁻, [γ-SiW₁₁O₃₉]⁸⁻, [α-SiMo₁₁O₃₉]⁸⁻, [β-SiMo₁₁O₃₉]⁸⁻, or [γ-SiW₁₁O₃₉]⁸⁻, more preferably [α-PW₁₁O₃₉]⁷⁻, [α-PMo₁₁O₃₉]⁷⁻, [α-SiW₁₁O₃₉]⁸⁻, or [α-SiMo₁₁O₃₉]⁸⁻.

The isomer structure of the di-lacunary Keggin-type heteropolyacid anion represented by the general formula (II-1) is preferably [α-PW₁₀O₃₆]⁷⁻, [β-PW₁₀O₃₆]⁷⁻, [γ-PW₁₀O₃₆]⁷⁻, [α-PMo₁₀O₃₆]⁷⁻, [β-PMo₁₀O₃₆]⁷⁻, [γ-PW₁₀O₃₆]⁷⁻, [α-SiW₁₀O₃₆]⁸⁻, [β-SiW₁₀O₃₆]⁸⁻, [γ-SiW₁₀O₃₆]⁸⁻, [α-SiMo₁₀O₃₆]⁸⁻, [β-SiMo₁₀O₃₆]⁸⁻, or [γ-SiW₁₀O₃₆]⁸⁻, more preferably [γ-PW₁₀O₃₆]⁷⁻, [γ-PMo₁₀O₃₆]⁷⁻, [γ-SiW₁₀O₃₆]⁸⁻, or [γ-SiMo₁₀O₃₆]⁸⁻.

The isomer structure of the tri-lacunary Keggin-type heteropolyacid anion represented by the general formula (III-1) is preferably [α-PW₉O₃₄]⁹⁻, [β-PW₉O₃₄]⁹⁻, [γ-PW₉O₃₄]⁹⁻, [α-PMo₉O₃₄]⁹⁻, [β-PMo₉O₃₄]⁹⁻, [γ-PW₉O₃₄]⁹⁻, [α-SiW₉O₃₄]¹⁰⁻, [β-SiW₉O₃₄]¹⁰⁻, [γ-SiW₉O₃₄]¹⁰⁻, [α-SiMo₉O₃₄]¹⁰⁻, [β-SiMo₉O₃₄]¹⁰⁻, or [γ-SiW₉O₃₄]¹⁰⁻.

### [1-1-1-3-1-2. Lacunary Dawson-Type Heteropolyacid Anion]

The lacunary Dawson-type heteropolyacid anion is, for example, a mono-lacunary Dawson-type heteropolyacid anion represented by the following general formula (III-1), a di-lacunary Dawson-type heteropolyacid anion represented by the following general formula (III-2), a tri-lacunary Dawson-type heteropolyacid anion represented by the following general formula (III-3), or the like.

[X₂M₁₇O₆₁]^{c21-} (III-1)

[X₂M₁₆O₅₈]^{c22-} (III-2)

[X₂M₁₅O₅₆]^{c23-} (III-3)

(wherein
X denotes a heteroatom of P, Si, B, S, or Ge,
M denotes a polyatom of Mo, W, V, Nb, or Ta, and
c21- to c23- denote the number of negative charges, and c21 to c23 denote natural numbers.)

In the general formulae (III-1) to (III-3), the values of c21 to c23 vary with the types of X and M.

For example, in the general formula (III-1), when X denotes P and M denotes Mo or W, c21 is 10 ([P₂Mo₁₇O₆₁]¹⁰⁻, [P₂W₁₇O₆₁]¹⁰⁻), and when X denotes S and M denotes W, c21 is 8 ([S₂W₁₇O₆₁]⁸⁻).

In the general formula (III-2), when X denotes Ge and M denotes Mo, c22 is 12 ([Ge₂Mo₁₆O₅₈]¹²⁻).

In the general formula (III-3), when X denotes P and M denotes Mo or W, c23 is 12 ([P₂Mo₁₅O₅₆]¹²⁻, [P₂W₁₅O₅₆]¹²⁻).

The isomer structure of the lacunary Dawson-type heteropolyacid anion is preferably an α-form, a β-form, or a γ-form.

The isomer structure of the lacunary Dawson-type heteropolyacid anion represented by the general formula (III-1), (III-2), or (III-3) is preferably [α-P₂W₁₇O₆₁]¹⁰⁻, [α-P₂W₁₅O₅₆]¹²⁻, [α-S₂W₁₇O₆₁]⁸⁻, or the like.

### [1-1-1-3-1-3. Modification of Lacunary Site]

The lacunary site of the heteropolyacid anion having the lacunary site according to the present embodiment is modified by reacting a terminal oxygen atom of the lacunary site with a P, Si, Ge, or Sn compound having one or more organic groups and two or more leaving groups. In this reaction, the terminal oxygen atom of the lacunary site of the heteropolyacid anion is bonded to a group having a heteroatom of P, Si, Ge, or Sn bonded to one or more organic groups via a part or all of the heteroatom, whereby the lacunary site is modified.

### [1-1-1-3-1-4. Binding Form of Lacunary Site and Notation Thereof]

In the heteropolyacid anion having the modified lacunary site according to the present embodiment, a terminal oxygen atom of the lacunary site in the heteropolyacid anion having the lacunary site is modified by a group having a heteroatom of P, Si, Ge, or Sn bonded to one or more organic groups.

The binding form between the terminal oxygen atom of the lacunary site of the heteropolyacid anion and the group having a heteroatom of P, Si, Ge, or Sn bonded to one or more organic groups is not particularly limited and may be represented by, for example, the following general formulae (IV-1) to (IV-5). 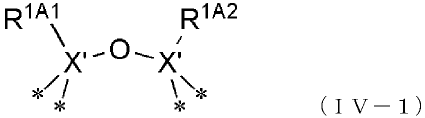 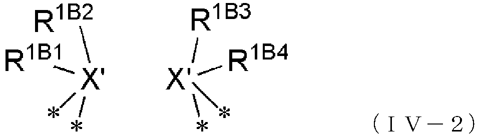 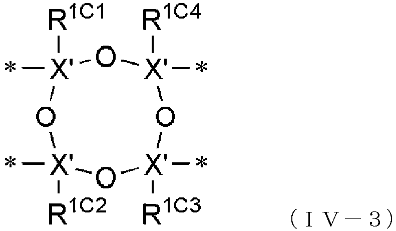 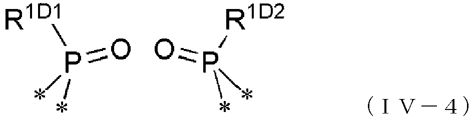 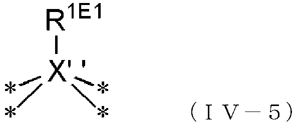 [In the formula (IV-1)~(IV-5)
X' denotes Si or Ge;
X" denotes a heteroatom of Si, Ge, or Sn;
R^{1A1} to R^{1E1} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{1A1} to R^{1E1} excluding the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time),
a hydrogen atom in R^{1A1} to R^{1E1} may be substituted with, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
* denotes a terminal oxygen atom of the lacunary site.]

In the present description, for convenience, a heteropolyacid anion having a lacunary site modified with a group having a heteroatom of Si or Ge bonded to one or more organic groups represented by the general formula (IV-1) can be represented by the following general formula (V-1).

[X_{w}MₓO_{y}(R^{1A1}X')(R^{1A2}X')O]^{c-} (V-1)

(In the formula, w, x, y, and c all denote natural numbers, and X, M, X', R^{1A1}, and R^{1A2} are the same as above.)

When R^{1A1} and R^{1A2} are identical, they can be denoted as R^{1A} in the following general formula (V-1').

[X_{w}MₓO_{y}(R^{1A}X')₂O]^{c-} (V-1')

The heteropolyacid anion having the modified lacunary site represented by the general formula (V-1) or (V-1') is not particularly limited and may be produced by, for example, reacting a heteropolyacid anion having a lacunary site with (R^{1A})X'Y₃ (Y denotes a leaving group, for example, a halogen atom, a hydroxy group, an alkoxy group (preferably a C₁₋₄ alkoxy group, more preferably a C₁₋₂ alkoxy group), an alkyl carbonyloxy group (preferably a C₁₋₄ alkyl carbonyloxy group), a hydrocarbylsulfonyloxy group (preferably a C₁₋₆ alkylsulfonyloxy group or a C₇₋₁₀ aralkylsulfonyloxy group, for example, a methanesulfonyloxy group, a p-toluenesulfonyloxy group, or the like)).

Likewise, in the present description, for convenience, a heteropolyacid anion having a lacunary site modified with a group having a heteroatom of Si or Ge bonded to one or more organic groups represented by the general formula (IV-2) can be represented by the following general formula (V-2).

[X_{w}MₓO_{y}(R^{1B1}R^{1B2}X')(R^{1B3}R^{1B4}Si)]^{c-} (V-2)

(In the formula, w, x, y, and c all denote natural numbers, and X, M, X', R^{1B1}, R^{1B2}, R^{1B3}, and R^{1B4} are the same as above.)

When R^{1B1}R^{1B2} and R^{1B3}R^{1B4} are identical, they can be represented by the following general formula (V-2').

[X_{w}MₓO_{y}(R^{1B1}R^{1B2}X')₂]^{c-} (V-2')

The heteropolyacid anion having the modified lacunary site represented by the general formula (V-2) or (V-2') is not particularly limited and may be produced by, for example, reacting a heteropolyacid anion having a lacunary site with (R^{1B1})(R^{1B2})X'Y₂ (Y denotes a leaving group as described above).

In the present description, for convenience, a heteropolyacid anion having a lacunary site modified with a group having a heteroatom of Si or Ge bonded to one or more organic groups represented by the general formula (IV-3) can be represented by the following general formula (V-3).

[X_{w}MₓO_{y}(R^{1C1}X'O)(R^{1C2}X'O)(R^{1C3}X'O)(R^{1C4}X'O)]^{c-} (V-3)

(In the formula, w, x, y, and c all denote natural numbers, and X, M, X', R^{1C1}, R^{1C2}, R^{1C3}, and R^{1C4} are the same as above.)

When R^{1C1}, R^{1C2}, R^{1C3}, and R^{1C4} are identical, they can be denoted as R^{1C} in the following general formula (V-3').

[X_{w}MₓO_{y}(R^{1C}X'O)₄]^{c-} (V-3')

The heteropolyacid anion having the modified lacunary site represented by the general formula (V-3) or (V-3') is not particularly limited and may be produced by, for example, reacting a di-lacunary Keggin-type or Dawson-type heteropolyacid anion with R^{1C}X'Y₃ (Y denotes a leaving group as described above).

In the present description, for convenience, a heteropolyacid anion having a lacunary site modified with a group having a heteroatom of P bonded to one or more organic groups represented by the general formula (IV-4) can be represented by the following general formula (V-4).

[X_{w}MₓO_{y}(R^{1D1}P=O)(R^{1D2}P=O)]^{c-} (V-4)

(In the formula, w, x, y, and c all denote natural numbers, and X, M, R^{1D1}, and R^{1D2} are the same as above.)

When R^{1D1} and R^{1D2} are identical, they can be denoted as R^{1D} in the following general formula (V-4').

[X_{w}MₓO_{y}(R^{1D}P=O)₂]^{c-} (V-4')

The heteropolyacid anion having the modified lacunary site represented by the general formula (V-4) or (V-4') is not particularly limited and may be produced by, for example, reacting a heteropolyacid anion having a lacunary site with R^{1D}P(=O)Y₂ (Y denotes a leaving group as described above).

In the present description, for convenience, a heteropolyacid anion having a lacunary site modified with a group having a heteroatom of Si, Ge, or Sn bonded to one or more organic groups represented by the general formula (IV-5) can be represented by the following general formula (V-5).

[X_{w}MₓO_{y}(R^{1E1}X'')]^{c-} (V-5)

(In the formula, w, x, y, and c all denote natural numbers, and X, M, X'', and R^{1E1} are the same as above.)

(V-5) may be represented by the following general formula (V-5') in some cases. Note that R^{1E} is defined in the same manner as R^{1E1}.

[X_{w}MₓO_{y}(R^{1E}X'')]^{c-} (V-5')

The heteropolyacid anion having the modified lacunary site represented by the general formula (V-5) or (V-5') is not particularly limited and may be produced by, for example, reacting a heteropolyacid anion having a lacunary site with R^{1E}X''Y₃ (Y denotes a leaving group as described above).

Among the heteropolyacid anions having the modified lacunary site represented by the general formulae (V-1) to (V-5) and (V-1') to (V-5'), heteropolyacid anions having a modified lacunary site represented by the following general formulae (VI-1) to (VI-12) are preferred from the perspective of being relatively stable and capable of controlling the reactivity.

[XM₁₁O₃₉(R^{1A}X')₂O]^{c31-} (VI-1)

[XM₁₁O₃₉(R^{1B1}R^{1B2}X')₂]^{c31-} (VI-2)

[XM₁₁O₃₉(R^{1D}P=O)₂]^{c31-} (VI-3)

[XM₁₁O₃₉(R^{1E}X'')]^{c31-} (VI-4)

[XM₁₀O₃₆(R^{1A}X')₂O]^{c32-} (VI-5)

[XM₁₀O₃₆(R^{1B1}R^{1B2}X')₂]^{c32-} (VI-6)

[XM₁₀O₃₆(R^{1C}X'O)₄]^{c32-} (VI-7)

[XM₁₀O₃₆(R^{1D}P=O)₂]^{c32-} (VI-8)

[X₂M₁₇O₆₁(R^{1A}X')_{2O}]^{c33-} (VI-9)

[X₂M₁₇O₆₁(R^{1B1}R^{1B2}X'₂]^{c33-} (VI-10)

[X₂M₁₇O₆₁(R^{1D}P=O)₂]^{c33-} (VI-11)

[X₂M₁₇O₆₁(R^{1E}X")]^{c33-} (VI-12)

(wherein
X denotes a heteroatom of P, Si, B, S, or Ge,
M denotes a polyatom of Mo, W, V, Nb, or Ta, and
X' denotes a heteroatom of Si or Ge;
X" denotes a heteroatom of Si, Ge, or Sn;
R^{1A} to R^{1E} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
   a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time),
a hydrogen atom in R^{1A} to R^{1E} may be substituted with, for example, (a) a halogen atom, (b) a C₁₋₃ haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (1) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group;
c31, c32, and c33 denote natural numbers.)

In the heteropolyacid anion having the modified lacunary site, since four terminal oxygen atoms of the lacunary site are modified, in general, the value of c31 is c11 - 4, the value of c32 is c12 - 4, and the value of c33 is c21 - 4.

On the other hand, for example, when the organic group contains an amino group and the amino group is protonated to be an ammonium cation, or when the organic group contains a carboxy group and the carboxy group is converted into a carboxy anion, the values of c31 to c33 are different from the above values.

### [1-1-1-3-2. Organic Group]

The organic groups represented by R^{1A}, R^{1B1} or R^{1B2}, R^{1C}, R^{1D}, and R^{1E} are not particularly limited and may be those known and commonly used.

From the perspective of providing a functional building block, the organic group is preferably an organic group having one or more substituents, such as a hydroxy group, a halogen atom, and an epoxy group, an organic group having one or more ethylenically unsaturated double bonds, or an organic group having one or more polar groups each having an acid-dissociable group.

### <Organic Group Having One or More Substituents, such as Hydroxy Group, Halogen Atom, or Epoxy Group>

In the organic group represented by R^{1A}, R^{1B1} or R^{1B2}, R^{1C}, R^{1D}, and R^{1E}, preferably, R^{1A} to R^{1E} denote
a C₁₋₁₈ hydrocarbyl group optionally having a substituent; any divalent carbon atom excluding the terminals in R^{1A} to R^{1E} may be substituted with -O-, -C(=O)-, - C(=O)O-, -OCO-, -CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (p) an epoxy group, (q) a glycidyl group, or (r) an amide group,
more preferably, R^{1A} to R^{1E} denote a C₁₋₁₈ alkyl group, a C₃₋₁₈ alicyclic group, or a C₇₋₁₈ aralkyl group, each optionally having a substituent; any divalent carbon atom excluding the terminals in R^{1A1} to R^{1E1} may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (p) an epoxy group, (q) a glycidyl group, or (r) an amide group.

Specific examples of R^{1A} to R^{1E} include, but are not limited to, a 1-glycidyloxypropan-3-yl group, a 1-glycidyloxy-n-octan-8-yl group, a 1-aminopropan-3-yl group, a 1-(2-aminoethylamino)-propan-3-yl group, a 3,3,3-trifluoropropan-1-yl group, a chloromethyl group, a 1-chloropropan-3-yl group, a 1-bromopropan-3-yl group, a 1-iodopropan-3-yl group, or the like.

### <Organic Group Having One or More Ethylenically Unsaturated Double Bonds>

From the perspective of having a building block having actinic radiation reactivity, the organic groups represented by R^{1A}, R^{1B1} or R^{1B2}, R^{1C}, R^{1D}, and R^{1E} preferably contain one or more ethylenically unsaturated double bonds.

In the above case, R^{1A} to R^{1E} preferably denote
a C₁₋₁₈ hydrocarbyl group optionally having a substituent; any divalent carbon atom excluding the terminals in R^{1A} to R^{1E} may be substituted with -O-, -C(=O)-, - C(=O)O-, -OCO-, -CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (j) a vinyl group, (k) an allyl group, (l) a (meth)acryloyl group, (m) a (meth)acryloyloxy group, (n) a (meth)acrylamide group, or (o) a styryl group,
more preferably a C₁₋₁₈ alkyl group, a C₃₋₁₈ alicyclic group, or a C₇₋₁₈ aralkyl group, each optionally having a substituent; any divalent carbon atom excluding the terminals in R^{1A} to R^{1E} may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (j) a vinyl group, (k) an allyl group, (l) a (meth)acryloyl group, (m) a (meth)acryloyloxy group, (n) a (meth)acrylamide group, or (o) a styryl group.

Specific examples of the organic groups R^{1A} to R^{1E} having an ethylenically unsaturated double bond include, but are not limited to, a vinyl group, an allyl group, a 5-hexen-1-yl group, a 6-hepten-1-yl group, a 7-octen-1-yl group, a 1-acryloyloxypropan-3-yl group, a 1-methacryloyloxypropan-3-yl group, a 1-vinylbenzene-4-yl group, or the like.

### <Organic Group Having One or More Polar Groups Each Having Acid-Dissociable Group>

From the perspective of providing a building block that can change the solubility in a developer by the action of an acid or the like, the organic groups represented by R^{1A}, R^{1B1} or R^{1B2}, R^{1C}, R^{1D}, and R^{1E} preferably contain one or more polar groups each having an acid-dissociable group.

The organic groups R^{1A} to R^{1E} having one or more polar groups each having an acid-dissociable group are preferably
a C₁₋₁₈ hydrocarbyl group optionally having a substituent; a divalent carbon atom at any position of R^{1A} to R^{1E} excluding the terminal positions may be substituted with - O-, -C(=O)-, -C(=O)O-, -OCO-, -CONH-, -NHCO-, -NH(C=O)O-, -S-, or -SO₂-(provided that adjacent divalent carbon atoms are not substituted at the same time); a hydrogen atom in R^{1A} to R^{1E} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and at least one hydrogen atom in R^{1A}, R^{1B1} or R^{1B2}, R^{1C}, R^{1D}, and R^{1E} is substituted with (t) a hydroxy group, a carboxy group, an amino group, or a sulfo group, each having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent; a divalent carbon atom at any position of R^{1A} to R^{1E} excluding the terminal positions may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); a hydrogen atom in R^{1A} to R^{1E} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and at least one hydrogen atom in R^{1A}, R^{1B1} or R^{1B2}, R^{1C}, R^{1D}, and R^{1E} is substituted with the (t) polar group having an acid-dissociable group,
still more preferably a C₁₋₁₈ alkyl group, a C₆₋₁₈ aryl group, or a C₇₋₁₈ aralkyl group, each optionally having a substituent; a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and at least one hydrogen atom in R^{1A}, R^{1B1} or R^{1B2}, R^{1C}, R^{1D}, and R^{1E} is substituted with the (t) polar group having an acid-dissociable group.

R^{1A}, R^{1B1} or R^{1B2}, R^{1C}, R^{1D}, and R^{1E} are characterized by having one or more polar groups each having an acid-dissociable group; for example, they incorporate a polar group, such as a hydroxy group, a carboxy group, an amino group, or a sulfo group, each having an acid-dissociable group. The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

R^{1A}, R^{1B1} or R^{1B2}, R^{1C}, R^{1D}, and R^{1E}, each having one or more polar groups each having an acid-dissociable group, are, for example, the following. 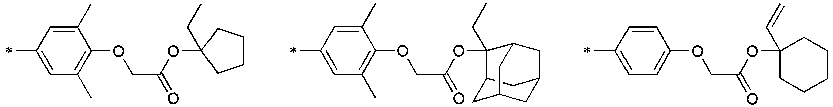 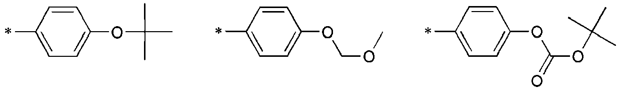 [* denotes a binding site with a heteroatom of P, Si, Ge, or Sn bonded to one or more organic groups each having a polar group having an acid-dissociable group.]

### [1-1-2. Cation Moiety of Component (A)]

The cation moiety of the component (A) according to the present embodiment can be H⁺, a metal ion, an onium cation, or an onium dication. The onium cation or onium dication may be one that exhibits a function as a photoacid generator.

Furthermore, one or more polar groups each having an acid-dissociable group may be included in the cation moiety of the component (A). In this case, the cation moiety of the component (A) contains an onium cation or onium dication having one or more polar groups each having an acid-dissociable group.

### [1-1-2-1. Metal Ion]

A metal ion that can be used as the cation moiety of the heteropolyacid salt having the modified lacunary site or the mixture thereof is not particularly limited but is, for example, Li⁺, Na⁺, K⁺, Rb⁺, Cs⁺, Be²⁺, Mg²⁺, Ca²⁺, Sr²⁺, Ba²⁺, Al³⁺, Co³⁺, Bi³⁺, Zr⁴⁺, Hf⁴⁺, Bi⁵⁺, or the like.

The metal ion is preferably Li⁺, Na⁺, K⁺, Rb⁺, Cs⁺, Mg²⁺, Ca²⁺, Sr²⁺, Ba²⁺, Al³⁺, or Co³⁺, more preferably Na⁺, K⁺, Rb⁺, Cs⁺, Ca²⁺, Al³⁺, or Co³⁺.

These metal ions may be used alone or in combination of two or more thereof.

### [1-1-2-2. Onium Cation or Onium Dication]

The onium cation or onium dication that can be used as the cation moiety of the heteropolyacid salt having the modified lacunary site or the mixture thereof is not particularly limited and may be a known and commonly used one.

The onium cation or onium dication is, for example, an ammonium cation, an ammonium dication, a phosphonium cation, a phosphonium dication, a sulfonium cation, a sulfonium dication, an iodonium cation, or the like.

These onium cations or onium dications may be used alone or in combination of two or more thereof.

From the perspective of providing a building block that generates an acid upon exposure to DUV, XUV, EUV, an electron beam, or the like, the onium cation or onium dication is preferably a sulfonium cation, a sulfonium dication, or an iodonium cation.

### [1-1-2-2-1. Ammonium Cation]

The ammonium cation is not particularly limited and may be a known and commonly used one. The ammonium cation is not particularly limited but is, for example, an ammonium ion (NH₄⁺), a primary ammonium cation (NH₃(R^{2A})⁺)), a secondary ammonium cation (NH₂(R^{2A})(R^{2B})⁺), a tertiary ammonium cation (NH(R^{2A})(R^{2B})(R^{2C})⁺), or a quaternary ammonium cation (N(R^{2A})(R^{2B})(R^{2C})(R^{2D})⁺). R^{2A} to R^{2D} denote the same as defined below.

The ammonium cation is preferably an ammonium ion (NH₄⁺) or a quaternary ammonium cation; particularly, an ammonium ion (NH₄⁺) or an organic quaternary ammonium cation represented by the following general formula (VII-1) is more preferred.

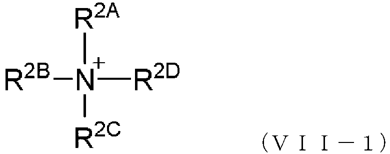

In general formula (VII-1), R^{2A} to R^{2D} each independently represent a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R^{2A} to R^{2D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
a hydrogen atom in R^{2A} to R^{2D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{2A} to R^{2D} may be bonded to each other directly by a single bond or via a divalent linking group -O-, -S-, -C(=O)-, -S(=O)-, -S(=O)2-, -C(=O)O-, or a C1-3 alkylene group to form a ring together with a nitrogen atom in the formula (VII-1).
R^{2A} to R^{2D} in the organic quaternary ammonium cation represented by the general formula (VII-1), preferably each independently denote
a C₁₋₁₈ hydrocarbyl group, a 3- to 18-membered non-aromatic heterocyclic group, or a 5- to 18-membered aromatic heterocyclic group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); a hydrogen atom in R^{2A} to R^{2D} is substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); a hydrogen atom in R^{2A} to R^{2D} is substituted with (a) a halogen atom, (b) a C₁₋₃ haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group.

Specific examples of the organic quaternary ammonium cation include a tetramethylammonium cation, a tetraethylammonium cation, a tetrapropylammonium cation, a tetrabutylammonium cation, a tetraheptylammonium cation, a trimethylethylammonium cation, a dimethyldiethylammonium cation, a dimethylethylpropylammonium cation, a methylethylpropylbutylammonium cation, a trimethylphenylammonium cation, a triethylhexylammonium cation, a triethylcyclohexylammonium cation, a dodecyltrimethylammonium cation, a diallyldimethylammonium cation, a (3-acrylamidepropyl)trimethylammonium cation, a trimethyl-2-methacryloyloxyethylammonium cation, an N-(2-acryloyloxyethyl)-N-benzyl-N,N-dimethylammonium cation, a trimethylvinylammonium cation, an N-4-vinylbenzyltriallylammonium cation, a 3-hydroxypropyltriallylammonium cation, a 2-trifluoromethylbenzyltriallylammonium cation, a di-2-(N-methylacrylamide)ethyldimethylammonium cation, an allyltrimethylammonium cation, a butyl(2-methacryloyloxyethyl)dimethylammonium cation, an ethoxycarbonylmethyltriethylammonium cation, a 2-hydroxyethyltrimethylammonium cation, a 2-acetylethyltrimethylammonium cation, a (4-((diisopropylcarbamoyl)oxy)phenyl)trimethylammonium cation, a (4-(methacryloyloxy)phenyl)trimethylammonium cation, and a trimethyl(4-(nonanoyloxy)phenyl)ammonium cation.

### <Organic Quaternary Ammonium Cation Having One or More Substituents>

From the perspective of providing a functional building block, in the organic quaternary ammonium cation represented by the general formula (VII-1),
R^{2A} to R^{2D} more preferably each independently denote
a C₁₋₁₈ hydrocarbyl group, a 3- to 18-membered non-aromatic heterocyclic group, or a 5- to 18-membered aromatic heterocyclic group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time)
   ; at least one hydrogen atom in R^{2A} to R^{2D} is substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time)
; at least one hydrogen atom in R^{2A} to R^{2D} is substituted with (a) a halogen atom, (b) a C₁₋₃ haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group.

R^{2A} to R^{2D} each having one or more substituents are not particularly limited but are, for example, a C₁₋₁₈ hydrocarbyl group having a hydroxy group or a glycidyl group, such as a 2-trifluoromethylbenzyl group, a 2-hydroxyethyl group, a 3-hydroxypropyl group, or a 1-glycidyloxypropan-3-yl group; a C₁₋₁₈ hydrocarbyl group having an ethylenically unsaturated group, such as a vinyl group, an allyl group, a vinylbenzyl group, a propenyl group, a butenyl group, a pentenyl group, a hexenyl group, a heptenyl group, an acryloylethyl group, an acryloylpropyl group, a methacryloylethyl group, a methacryloylpropyl group, an acryloyloxyethyl group, an acryloyloxypropyl group, a methacryloyloxyethyl group, a methacryloyloxypropyl group, an acryloylaminoethyl group, an acryloylaminopropyl group, a methacryloylaminoethyl group, a methacryloylaminopropyl group, or a styryl group; or a C₁₋₁₈ hydrocarbyl group having an acid-dissociable group, such as a 4-methoxymethoxyphenyl group, a methoxymethyl group, an ethoxyethyl group, a methoxyethoxymethyl group, a t-butoxycarbonyl group, a 1-methylcyclopentyl group, a 1-ethylcyclopentyl group, a 1-phenylcyclopentyl group, a 1-tolylcyclopentyl group, a 1-methylcyclohexyl group, a 1-ethylcyclohexyl group, a 1-phenylcyclohexyl group, a 1-tolylcyclohexyl group, a 1-(naphthalen-2-yl)cyclohexyl group, a 1-(1-methoxy-2-methylpropan-2-yl)cyclopentyl group, a 1-(1-ethoxy-2-methylpropan-2-yl)cyclopentyl group, a 2-methyladamantan-2-yl group, a 2-ethyladamantan-2-yl group, a 2-phenyladamantan-2-yl group, a diethylaminocarbonyl group, or a diisopropylaminocarbonyl group; or the like.

### <Organic Quaternary Ammonium Cation Having One or More Polar Groups Each Having Acid-Dissociable Group>

From the perspective of providing a building block that changes the solubility in a developer or the like by the action of an acid or the like, as an organic quaternary ammonium cation represented by the general formula (VII-1), at least one of R^{2A} to R^{2D} preferably contains a polar group having an acid-dissociable group.

In the above case, in the general formula (VII-2), R^{2A} to R^{2D} preferably each independently denote
a C₁₋₁₈ hydrocarbyl group optionally having a substituent; a divalent carbon atom at any position of R^{2A} to R^{2D} excluding the terminal positions may be substituted with - O-, -C(=O)-, -C(=O)O-, -OCO-, -CONH-, -NHCO-, -NH(C=O)O-, -S-, or -SO₂-(provided that adjacent divalent carbon atoms are not substituted at the same time); at least one hydrogen atom in R^{2A} to R^{2D} is substituted with the (t) polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent; a divalent carbon atom at any position of R^{2A} to R^{2D} excluding the terminal positions may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time), at least one hydrogen atom in R^{2A} to R^{2D} is substituted with the (t) polar group having an acid-dissociable group.

R^{2A} to R^{2D} having one or more polar groups each having an acid-dissociable group are, for example, those in which a polar group, such as a hydroxy group, a carboxy group, an amino group, or a sulfo group, each having an acid-dissociable group, is introduced. The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

### [1-1-2-2-2. Ammonium Dication]

The ammonium dication is not particularly limited and may be known and commonly used. The ammonium dication is, for example, an organic quaternary ammonium dication represented by the following general formula (VII-2).

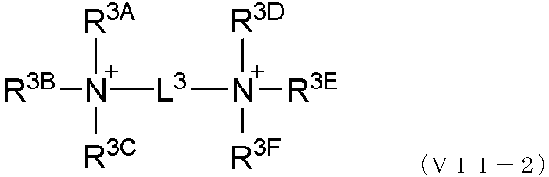

In the general formula (VII-2),
R^{3A} to R^{3F} each independently denote a C₁₋₁₈ hydrocarbyl group, a 3- to 18-membered non-aromatic heterocyclic group, or a 5- to 18-membered aromatic heterocyclic group, each optionally having a substituent,
   a divalent carbon atom at any position of R^{3A} to R^{3F} excluding the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time),
   L³ represents a C₁₋₁₈ hydrocarbylene group optionally having a substituent,
a divalent carbon atom at any position of L³ may be substituted with -O-, -C(=O)-, -C(=O)O-, -OCO-, -CONH-, -NHCO-, -S-, or -SO₂- (provided that adjacent divalent carbon atoms are not substituted at the same time); and
a hydrogen atom in R^{3A} to R^{3F} and L³ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{3A} to R^{3F} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a nitrogen atom in the formula (VII-2).

The organic quaternary ammonium dication represented by the general formula (VII-2) is not particularly limited but is, for example, 1,4-diallyl-1,4-diazabicyclo[2.2.2]octane-1,4-diium, 1,4-di(2-(meth)acryloyloxyethyl)-1,4-diazabicyclo[2.2.2]octane-1,4-diium, 1,4-bis(2-(meth)acrylamideethyl)-1,4-diazabicyclo[2.2.2]octane-1,4-diium, or the like.

### [1-1-2-2-3. Phosphonium Cation]

The phosphonium cation is not particularly limited and may be known and commonly used. The phosphonium cation is, for example, an organic quaternary phosphonium cation represented by the following general formula (VII-3).

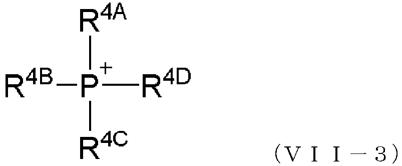

In general formula (VII-3), R^{4A} to R^{4D} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{4A} to R^{4D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
a hydrogen atom in R^{4A} to R^{4D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{4A} to R^{4D} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a phosphorus atom in the formula (VII-3).

### <Organic Quaternary Phosphonium Cation Having One or More Substituents>

In the organic quaternary phosphonium cation represented by the general formula (VII-3), from the perspective of providing a functional building block,
R^{4A} to R^{4D} preferably each independently denote
a C₁₋₁₈ hydrocarbyl group, a 3- to 18-membered non-aromatic heterocyclic group, or a 5- to 18-membered aromatic heterocyclic group, each optionally having a substituent;
   a divalent carbon atom at any position of R^{4A} to R^{4D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
   at least one hydrogen atom in R^{4A} to R^{4D} is substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
   a divalent carbon atom at any position of R^{4A} to R^{4D} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
   at least one hydrogen atom in R^{4A} to R^{4D} is substituted with (a) a halogen atom, (b) a C1-3 haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group.

R^{4A} to R^{4D} having one or more substituents are not particularly limited but are, for example, a C₁₋₁₈ hydrocarbyl group having a halogen atom, a hydroxy group, or a glycidyl group, such as a 2-trifluoromethylbenzyl group, a 2-hydroxyethyl group, a 3-hydroxypropyl group, or a 1-glycidyloxypropan-3-yl group; a C₁₋₁₈ hydrocarbyl group having an ethylenically unsaturated double bond, such as a vinyl group, an allyl group, a propenyl group, a butenyl group, a pentenyl group, a hexenyl group, a heptenyl group, an acryloylethyl group, an acryloylpropyl group, a methacryloylethyl group, a methacryloylpropyl group, an acryloyloxyethyl group, an acryloyloxypropyl group, a methacryloyloxyethyl group, a methacryloyloxypropyl group, an acryloylaminoethyl group, an acryloylaminopropyl group, a methacryloylaminoethyl group, a methacryloylaminopropyl group, or a styryl group; a C₁₋₁₈ hydrocarbyl group having an acid-dissociable group, such as a methoxymethyl group, an ethoxyethyl group, a methoxyethoxymethyl group, a t-butoxycarbonyl group, a 1-methylcyclopentyl group, a 1-ethylcyclopentyl group, a 1-phenylcyclopentyl group, a 1-tolylcyclopentyl group, a 1-methylcyclohexyl group, a 1-ethylcyclohexyl group, a 1-phenylcyclohexyl group, a 1-tolylcyclohexyl group, a 1-(naphthalen-2-yl)cyclohexyl group, a 1-(1-methoxy-2-methylpropan-2-yl)cyclopentyl group, a 1-(1-ethoxy-2-methylpropan-2-yl)cyclopentyl group, a 2-methyladamantan-2-yl group, a 2-ethyladamantan-2-yl group, a 2-phenyladamantan-2-yl group, a diethylaminocarbonyl group, or a diisopropylaminocarbonyl group; or the like.

The organic quaternary phosphonium cation represented by the general formula (VII-3) is not particularly limited but is, for example, a tributylcyanomethylphosphonium cation, a methyltriphenylphosphonium cation, an ethyltriphenylphosphonium cation, a cyanomethyltriphenylphosphonium cation, a formylmethyltriphenylphosphonium cation, a methoxymethyltriphenylphosphonium cation, a chloromethyltriphenylphosphonium cation, an acetonyltriphenylphosphonium cation, a tributyl-1,3-dioxan-2-ylmethylphosphonium cation, a triphenylpropargylphosphonium cation, an allyltriphenylphosphonium cation, a cyclopropyltriphenylphosphonium cation, a benzyltriphenylphosphonium cation, a tetrakis(hydroxymethyl)phosphonium cation, a 2-carboxyethyltriphenylphosphonium cation, a methoxycarbonylmethyltriphenylphosphonium cation, a t-butoxycarbonylmethyltriphenylphosphonium cation, a (4-((diisopropylcarbamoyl)oxy)phenyl)triphenylphosphonium cation, a (4-(methacryloyloxy)phenyl)triphenylphosphonium cation, a triphenyl(4-(nonanoyloxy)phenyl)phosphonium cation, or the like.

### <Organic Quaternary Phosphonium Cation Having One or More Polar Groups Each Having Acid-Dissociable Group>

From the perspective of providing a building block that changes the solubility in a developer or the like by the action of an acid or the like, as an organic quaternary phosphonium cation represented by the general formula (VII-3), at least one of R^{4A} to R^{4D} preferably contains a polar group having an acid-dissociable group.

In the above case, in the general formula (VII-3), R^{4A} to R^{4D} preferably each independently denote
a C₁₋₁₈ hydrocarbyl group optionally having a substituent; any divalent carbon atom excluding the terminals in R^{4A} to R^{4D} may be substituted with -O-, -C(=O)-, - C(=O)O-, -OCO-, -CONH-, -NHCO-, -NH(C=O)O-, -S-, or -SO₂- (provided that adjacent divalent carbon atoms are not substituted at the same time); at least one hydrogen atom in R^{4A} to R^{4D} is substituted with the (t) polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent; any divalent carbon atom excluding the terminals in R^{4A} to R^{4D} may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); at least one hydrogen atom in R^{4A} to R^{4D} is substituted with the (t) polar group having an acid-dissociable group.

R^{4A} to R^{4D} having one or more polar groups each having an acid-dissociable group are, for example, those in which a polar group, such as a hydroxy group, a carboxy group, an amino group, or a sulfo group, each having an acid-dissociable group, is introduced. The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

### [1-1-2-2-4. Phosphonium Dication]

The phosphonium dication is not particularly limited and may be a known and commonly used one. The phosphonium dication is, for example, an organic quaternary phosphonium dication represented by the following general formula (VII-4).

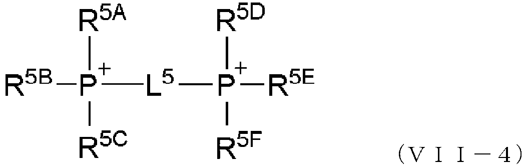

In general formula (VII-4), R^{5A} to R^{5F} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{5A} to R^{5F} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
L⁵ represents a C₁₋₁₈ hydrocarbylene group optionally having a substituent,
a divalent carbon atom at any position of L⁵ may be substituted with -O-, - C(=O)-, -C(=O)O-, -OCO-, -CONH-, -NHCO-, -S-, or -SO₂- (provided that adjacent divalent carbon atoms are not substituted at the same time);
a hydrogen atom in R^{5A} to R^{5F} and L⁵ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{5A} to R^{5F} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a phosphorus atom in the formula (VII-4).

The organic quaternary phosphonium dication represented by the general formula (VII-4) is not particularly limited but is, for example, a trans-2-butene-1,4-bis(triphenylphosphonium) dication, an ethylene bis(triphenylphosphonium) dication, a pentamethylene bis(triphenylphosphonium) dication, or the like.

### [1-1-2-2-5. Sulfonium Cation]

The sulfonium cation is not particularly limited and may be a known and commonly used one. The sulfonium cation is, for example, an organic sulfonium cation represented by the following general formula (VII-5).

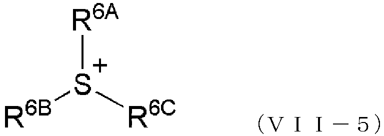

In general formula (VII-5), R^{6A}, R^{6B} and R^{6C} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{6A}, R^{6B} and R^{6C} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
a hydrogen atom in R^{6A}, R^{6B}, and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
furthermore, any two of R^{6A}, R^{6B}, and R^{6C} may be bonded to each other directly by a single bond or via a divalent linking group -O-, -S-, -C(=O)-, -S(=O)-, -S(=O)₂-, - C(=O)O-, or a C₁₋₃ alkylene group to form a ring together with a sulfur atom in the formula (VII-5).

R^{6A}, R^{6B} and R^{6C} are each independently preferably a C₁₋₁₈ hydrocarbyl group optionally having a substituent; in which a divalent carbon atom at any position of R^{6A}, R^{6B} and R^{6C} except the terminal positions may be substituted with -O-, -C(=O)-, - C(=O)O-, -OCO-, -CONH-, -NHCO-, -NH(C=O)O-, -S-, or -SO₂- (provided that adjacent divalent carbon atoms are not substituted at the same time); and a hydrogen atom contained in R^{6A}, R^{6B} and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{6A}, R^{6B} and R^{6C} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time); and a hydrogen atom contained in R^{6A}, R^{6B} and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time).

In the case where any two of R^{6A}, R^{6B}, and R^{6C} are linked to each other directly by a single bond or via a divalent linking group -O-, -S-, -C(=O)-, -S(=O)-, -S(=O)₂-, - C(=O)O-, or a C₁₋₃ alkylene group to form a ring together with the sulfur atom in formula (VII-5), the organic sulfonium cation is, for example, one having a thian-1-ium skeleton, a thiophen-1-ium skeleton, a 1,4-oxathian-4-ium skeleton, a 1,4-dithian-1-ium skeleton, a 1H-thiophen-1-ium skeleton, a benzo[b]thiophen-1-ium skeleton, a dibenzothiophenium skeleton, a 9,10-dihydrothioxanthylium skeleton, a 10H-phenoxathiin-10-ium skeleton, or a 5H-thianthren-5-ium skeleton, or the like, and examples thereof include the following. Note that * indicates a binding site to R^{6A}, R^{6B}, or R^{6C} which is not involved in formation of the ring.

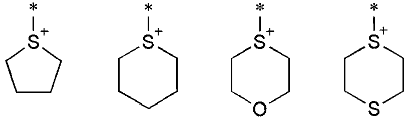

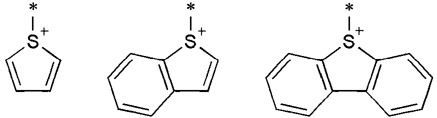

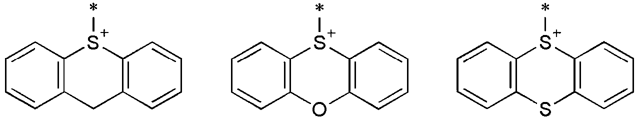

The organic sulfonium cation is, for example, a dibutyl(pentyl)sulfonium cation, a triethylsulfonium cation, a (2-carboxyethyl)dimethylsulfonium cation, a trimethylsulfonium cation, a dimethylphenacylsulfonium cation, a 1-(4-hydroxynaphthalen-1-yl)hexahydrothiopyrylium cation, a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, a di(naphthalen-1-yl)(phenyl)sulfonium cation, a phenylbis(2-(trifluoromethyl)phenyl)sulfonium cation, a mesitylbis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl)sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation, a 5-(3-(trifluoromethyl)phenyl)-5H-dibenzo[b,d]thiophen-5-ium cation, a 1-(4-(t-butyl)phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl)methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a (2-bromoethyl)diphenylsulfonium cation, a dimesityl(trifluoromethyl)sulfonium cation, a tri-p-tolylsulfonium cation, or the like.

### <Organic Sulfonium Cation Having One or More Polar Groups Each Having Acid-Dissociable Group>

From the perspective of providing a building block that changes the solubility in a developer or the like by the action of an acid or the like, as an organic sulfonium cation represented by the general formula (VII-5), at least one of R^{6A} to R^{6C} preferably contains a polar group having an acid-dissociable group.

In the above case, R^{6A} to R^{6C} having one or more polar groups each having an acid-dissociable group preferably each independently denote
a C₁₋₁₈ hydrocarbyl group optionally having a substituent;
   a divalent carbon atom at any position of R^{6A} to R^{6C} excluding the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); at least one hydrogen atom in R^{6A} to R^{6C} is substituted with the (t) polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent; a divalent carbon atom at any position of R^{6A} to R^{6C} excluding the terminal positions may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); at least one hydrogen atom in R^{6A} to R^{6C} is substituted with the (t) polar group having an acid-dissociable group.

R^{6A} to R^{6C} having one or more polar groups each having an acid-dissociable group are, for example, those in which a polar group, such as a hydroxy group, a carboxy group, an amino group, or a sulfo group, each having an acid-dissociable group, is introduced. The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

The organic sulfonium cation having one or more polar groups each having an acid-dissociable group is, for example, a (3,5-dimethyl-4-(2-((2-methyladamantan-2-yl)oxy)-2-oxoethoxy)phenyl)diphenylsulfonium cation, a (4-(2-((1-ethylcyclopentyl)oxy)-2-oxoethoxy)-3,5-dimethylphenyl)diphenylsulfonium cation, a (3,5-dimethyl-4-(2-((1-methylcyclopentyl)oxy)-2-oxoethoxy)phenyl)diphenylsulfonium cation, a (4-(2-(t-butoxy)-2-oxoethoxy)-3,5-dimethylphenyl)diphenylsulfonium cation, a (3,5-dimethyl-4-(2-(2-((2-methyladamantan-2-yl)oxy)-2-oxoethoxy)-2-oxoethoxy)phenyl)diphenylsulfonium cation, a 5-(3,5-dimethyl-4-(2-((2-methyladamantan-2-yl)oxy)-2-oxoethoxy)phenyl)-5H-dibenzo[b,d]thiophen-5-ium cation, a (4-(2-((1-ethylcyclohexyl)oxy)-2-oxoethoxy)-3,5-dimethylphenyl)diphenylsulfonium cation, a 1-(4-(2-((2-methyladamantan-2-yl)oxy)-2-oxoethoxy)naphthalen-1-yl)tetrahydro-1H-thiophen-1-ium cation, a (4-(t-butoxy)-3,5-dimethylphenyl)diphenylsulfonium cation, a (4-((diisopropylcarbamoyl)oxy)phenyl)dimethylsulfonium cation, a 1-(4-methoxymethoxy)naphthalen-1-yl)tetrahydro-1H-thiophen-1-ium cation, a 1-(2-((2-methyladamantan-2-yl)oxy)-2-oxoethyl)tetrahydro-1H-thiophen-1-ium cation, a 1-(2-((2-methyladamantan-2-yl)oxy)-2-oxoethyl)hexahydrothiopyrylium cation, or the like.

The organic sulfonium cation having one or more polar groups each having an acid-dissociable group is, for example, the following.

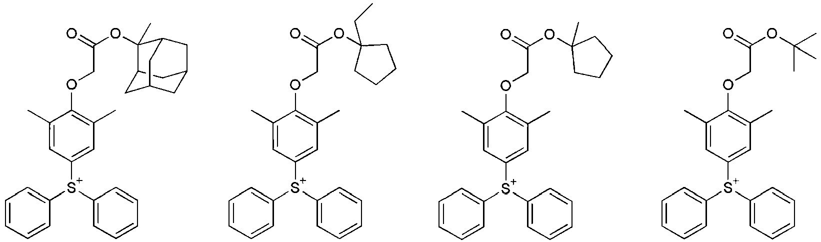

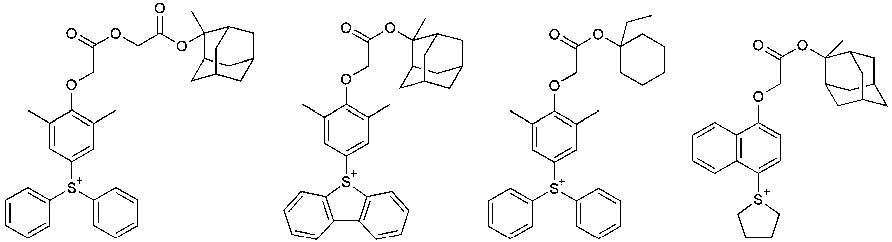

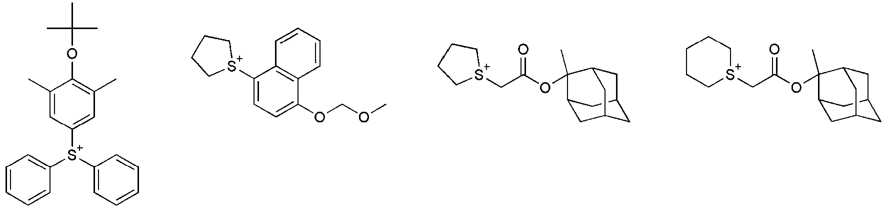

### [1-1-2-2-6. Sulfonium Dication]

The sulfonium dication is not particularly limited and may be a known and commonly used one. The sulfonium dication is, for example, an organic sulfonium dication represented by the following general formula (VII-6).

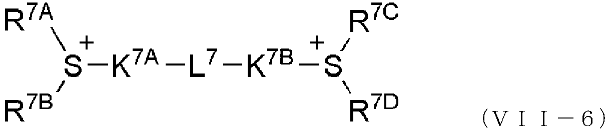

In general formula (VII-6), R^{7A}, R^{7B}, R^{7C}, and R^{7D} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{7A}, R^{7B}, R^{7C}, and R^{7D} except the terminal positions may be substituted with -O-, -C(=O)-, -C(=O)O-, -OCO-, -CONH-, - NHCO-, -NH(C=O)O-, -S-, or -SO₂- (provided that adjacent divalent carbon atoms are not substituted at the same time);
K^{7A}, K^{7B}, and L⁷ each independently represent a C₁₋₁₈ hydrocarbylene group optionally having a substituent,
a divalent carbon atom at any position of K^{7A}, K^{7B}, and L⁷ may be substituted with -O-, -C(=O)-, -C(=O)O-, -OCO-, -CONH-, -NHCO-, -S-, or -SO₂- (provided that adjacent divalent carbon atoms are not substituted at the same time);

a hydrogen atom in R^{7A}, R^{7B}, R^{7C}, R^{7D}, K^{7A}, K^{7B}, and L⁷ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{7A}, R^{7B}, and K^{7A} and/or any two of R^{7C}, R^{7D}, and K^{7B} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (VII-6).

R^{7A} to R^{7D} are each independently preferably a C₁₋₁₈ hydrocarbyl group optionally having a substituent; in which a divalent carbon atom at any position of R^{7A} to R^{7D} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and a hydrogen atom contained in R^{7A} to R^{7D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{7A} to R^{7D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time); and a hydrogen atom contained in R^{7A} to R^{7D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time).

K^{7A}, K^{7B}, and L⁷ each independently denote a C₁₋₁₈ alkylene group or a C₁₋₁₈ arylene group, each optionally having a substituent;
a divalent carbon atom at any position of K^{7A}, K^{7B}, and L⁷ may be substituted with -O-, -C(=O)-, -C(=O)O-, -OCO-, -CONH-, -NHCO-, -S-, or -SO₂- (provided that adjacent divalent carbon atoms are not substituted at the same time); a hydrogen atom in K^{7A}, K^{7B}, and L⁷ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group.

### [1-1-2-2-7. Iodonium Cation]

The iodonium cation is not particularly limited and may be a known and commonly used one. The iodonium cation is, for example, an organic iodonium cation represented by the following general formula (VII-7).

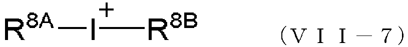

In general formula (VII-7), R^{8A} and R^{8B} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{8A} and R^{8B} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time);
a hydrogen atom in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); and
R^{8A} and R^{8B} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with an iodine atom in the formula (VII-7).

R^{8A} and R^{8B} are preferably a C₁₋₁₈ hydrocarbyl group optionally having a substituent; in which a divalent carbon atom at any position of R^{8A} and R^{8B} except the terminal positions may be substituted with -O-, -C(=O)-, -C(=O)O-, -OCO-, -CONH-, - NHCO-, -NH(C=O)O-, -S-, or -SO₂- (provided that adjacent divalent carbon atoms are not substituted at the same time); and a hydrogen atom contained in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{8A} and R^{8B} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time); and a hydrogen atom contained in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time).

### <Organic Iodonium Cation Having One or More Polar Groups each having Acid-Dissociable Group>

From the perspective of providing a building block that changes the solubility in a developer or the like by the action of an acid or the like, as an organic iodonium cation represented by the general formula (VII-7), at least one of R^{8A} and R^{8B} preferably contains a polar group having an acid-dissociable group.

In the above case, R^{8A} or R^{8B} having one or more polar groups each having an acid-dissociable group preferably each independently denotes
a C₁₋₁₈ hydrocarbyl group optionally having a substituent; in which a divalent carbon atom at any position of R^{8A} or R^{8B} except the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time); at least one hydrogen atom in R^{8A} or R^{8B} is substituted with the (t) polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent; a divalent carbon atom at any position of R^{8A} or R^{8B} except the terminal positions may be substituted with -O-, - C(=O)-, -C(=O)O-, -OCO-, -CONH-, -NHCO-, -NH(C=O)O-, -S-, or -SO₂- (provided that adjacent divalent carbon atoms are not substituted at the same time); at least one hydrogen atom in R^{8A} or R^{8B} is substituted with the (t) polar group having an acid-dissociable group.

R^{8A} or R^{8B} having one or more polar groups each having an acid-dissociable group are, for example, those in which a polar group, such as a hydroxy group, a carboxy group, an amino group, or a sulfo group, each having an acid-dissociable group, is introduced. The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

### [1-1-3. Polyacid Salt Having One or More polar Groups Each Having Acid-Dissociable Group or Mixture Thereof]

### <Polyacid Salt Having One or More Polar Groups Each Having Acid-Dissociable Group Represented by General Formula (I) or Mixture Thereof>

The polyacid salt having one or more polar groups each having an acid-dissociable group or a mixture thereof according to the present embodiment can be a polyacid salt having one or more polar groups each having an acid-dissociable group represented by the following general formula (I) or a mixture thereof.

(A^{m+})ₐ(C^{(am)-}) (I)

[in the formula (I),
A^{m+} each independently denotes H⁺, a metal ion, an onium cation, or an onium dication;
C^{(am)-} denotes an isopolyacid anion, a heteropolyacid anion, or a heteropolyacid anion having a lacunary site in which the lacunary site is modified;
A^{m+} and/or C^{(am)-} has one or more polar groups each having an acid-dissociable group; and
m denotes an integer in the range of 1 to 5, and a denotes a real number greater than 0]

In the polyacid salt having one or more polar groups each having an acid-dissociable group represented by the general formula (I) or the mixture thereof, the "metal ion", the "onium cation or onium dication", the "isopolyacid anion", the "heteropolyacid anion", and the "heteropolyacid anion having a lacunary site in which the lacunary site is modified" can appropriately be those described above.

The polyacid salt represented by the general formula (I) or the mixture thereof is characterized in that a polar group having an acid-dissociable group is introduced into an onium cation or onium dication or a heteropolyacid anion having a lacunary site in which the lacunary site is modified.

The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

The mixture of the polyacid salt represented by the general formula (I) may contain a plurality of types of A^{m+}. In this case, the content ratio of the plurality of types of A^{m+} can be determined by, for example, NMR analysis, XRF analysis, XPS analysis, or the like.

### <Polyacid Salt Having One or More Polar Groups Each Having Acid-Dissociable Group Represented by General Formula (I') or Mixture Thereof>

Another polyacid salt having one or more polar groups each having an acid-dissociable group or a mixture thereof according to the present embodiment can be a polyacid salt having one or more polar groups each having an acid-dissociable group represented by the following general formula (I') or a mixture thereof.

(A'^{m'+})_{a'}(Bⁿ⁺)_{b}(C'^{(a'm'+bn)-}) (I')

[in the formula (I'),
A'^{m'+} each independently denotes H⁺, a metal ion, an ammonium cation, an ammonium dication, a phosphonium cation, or a phosphonium dication;
Bⁿ⁺ each independently denotes a sulfonium cation, a sulfonium dication, or an iodonium cation;
C'^{(a'm'+bn)-} denotes an isopolyacid anion, a heteropolyacid anion, or a heteropolyacid anion having a lacunary site in which the lacunary site is modified;
A'^{m'+}, Bⁿ⁺, and/or C'^{(a'm'+bn)-} has one or more polar groups each having an acid-dissociable group; and
m' denotes an integer in the range of 1 to 5, n denotes an integer of 1 or 2, a' denotes a real number, and b denotes a real number greater than 0]

In the polyacid salt having one or more polar groups each having an acid-dissociable group represented by the general formula (I') or the mixture thereof, the "metal ion", the "ammonium cation", the "ammonium dication", the "phosphonium cation", the "phosphonium dication", the "sulfonium cation", the "sulfonium dication", the "iodonium cation", the "isopolyacid anion", the "heteropolyacid anion", and the "heteropolyacid anion having a lacunary site in which the lacunary site is modified" can appropriately be those described above.

The heteropolyacid salt having one or more polar groups each having an acid-dissociable group represented by the general formula (I') or the mixture thereof has a sulfonium cation, a sulfonium dication, or an iodonium cation in the cation moiety thereof and can therefore have a function of generating an acid upon exposure to DUV, XUV, EUV, an electron beam, or the like.

In the polyacid salt represented by the general formula (I') or the mixture thereof, a polar group having an acid-dissociable group is introduced into an ammonium cation, an ammonium dication, a phosphonium cation, a phosphonium dication, a sulfonium cation, a sulfonium dication, an iodonium cation, or a heteropolyacid anion having a lacunary site in which the lacunary site is modified.

The acid-dissociable group is, for example, a tertiary-carbon-type acid-dissociable group G_{A}, an allyl- or benzyl-type acid-dissociable group G_{B}, an acetal-type acid-dissociable group G_{C}, or the like.

A mixture of polyacid salts having one or more polar groups each having an acid-dissociable group represented by the general formula (I') may include polyacid salts having one or more polar groups each having a plurality of acid-dissociable groups in which the ratio of A'^{m'+} to Bⁿ⁺ is different. In this case, the values of a' and b can be determined by, for example, NMR analysis, XRF analysis, XPS analysis, or the like.

The ratio of a' to b depends on the types of the polyacid anions, C'^{(a'm'+bn)-}, A'^{m'+}, and Bⁿ⁺, and is preferably a':b = 0 to 8:1 to 12, more preferably 0 to 4:2 to 8, still more preferably 0 to 2:1 to 4.

In particular, when the value of a'm'+bn is an integer in the range of 2 to 8 and m' and n are 1, it is preferable that a' is a real number in the range of 0 to 7 and b is a real number in the range of 1 to 8, and it is more preferable that a' is a real number in the range of 0 to 4 and b is a real number in the range of 2 to 8.

### [1-1-4. Component (A) Content]

The component (A) content of the resist material is not particularly limited and may be appropriately determined according to the method for applying the resist material to a substrate or the like, the thickness of the film to be applied, or the like. The component (A) content of the resist material preferably ranges from 0.01% to 20% by mass, more preferably 0.1% to 15% by mass, still more preferably 0.2% to 10% by mass, relative to 100% by mass of the resist material.

### [1-2. (B) Polymer]

The resist material according to the present embodiment contains (B) a polymer in addition to the component (A). The component (B) is not particularly limited and may be any one known and commonly used in the field of chemically amplified resist materials.

The (B) polymer can suitably be a polymer including one or more structural units selected from the group consisting of a structural unit B_{A} having a phenolic hydroxy group, a structural unit B_{B} for adjusting solubility in a developer, and a structural unit B_{C} having a fluorine atom.

The polymer of the component (B) may include a structural unit other than those described above.

### [1-2-1. Structural Unit B_{A} Having Phenolic Hydroxy Group]

The structural unit B_{A} having a phenolic hydroxy group is not particularly limited and may be a known and commonly used one. The structural unit B_{A} having a phenolic hydroxy group in the (B) polymer can improve the etch resistance and improve the contrast of the solubility in a developer between the exposed portion and the unexposed portion.

The structural unit B_{A} is, for example, a structural unit represented by the following formula (VIII-1).

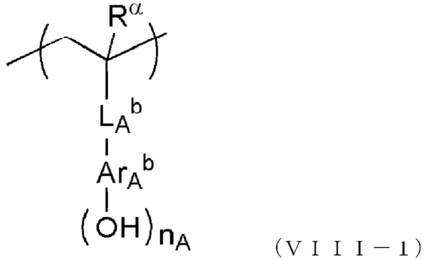

In the general formula (VIII-1), "Rα" denotes a hydrogen atom, a halogen atom, a C₁₋₃ alkyl group, or a C₁₋₃ haloalkyl group. Rα preferably denotes a hydrogen atom, a halogen atom, a methyl group, or a trifluoromethyl group, more preferably a hydrogen atom, a fluorine atom, a chlorine atom, a methyl group, or a trifluoromethyl group.

"L_{A}^{b}" denotes a single bond, -O-, -C(=O)-, -C(=O)O-, -OCO-, -CONH-, - NHCO-, -S-, -SO₂-, or a C₁₋₈ hydrocarbylene group optionally having a substituent, wherein a divalent carbon atom at any position including the terminal positions may be substituted with -O-, -C(=O)-, -C(=O)O-, -OCO-, -CONH-, -NHCO-, -NH(C=O)O-, - S-, or -SO₂-.

L_{A}^{b} preferably denotes a single bond, -O-, -C(=O)-, -C(=O)O-, -OCO-, -CONH-, -NHCO-, -S-, -SO₂-, or a C₁₋₈ alkylene group optionally having a substituent, wherein a divalent carbon atom at any position including the terminal positions may be substituted with -O-, -C(=O)-, -C(=O)O-, -OCO-, -CONH-, -NHCO-, -NH(C=O)O-, -S-, or -SO₂-, preferably -C(=O)-, -C(=O)O-, -OCO-, or -CONH-, more preferably a single bond, - C(=O)O-, or -OCO-.

"Ar_{A}^{b}" denotes a C₆₋₁₈ arylene group optionally having a substituent.

The C₆₋₁₈ arylene group refers to an aromatic hydrocarbon group or aromatic heterocyclic group each having 6 to 18 carbon atoms and has two binding sites.

The aromatic heterocyclic group may contain a heteroatom, such as a nitrogen atom, an oxygen atom, or a sulfur atom, in addition to a carbon atom, to form a cyclic conjugated system having 4n + 2π electrons. The aromatic heterocyclic group is, for example, one having a pyridine ring, a thiophene ring, a furan ring, a pyrrole ring, a benzofuran ring, a benzothiophene ring, an indole ring, a quinoline ring, an isoquinoline ring, or the like.

The C₆₋₁₈ arylene group optionally having a substituent is not particularly limited but is, for example, a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group, and a hydrogen atom on the C₆₋₁₈ arylene group may be substituted with a substituent. The substituent is, for example, a halogen atom, a haloalkyl group, a hydroxy group, a C₁₋₁₈ hydrocarbyl group, a C₁₋₁₈ hydrocarbyloxy group, or the like.

"OH" denotes a phenolic hydroxy group and is bonded to Ar_{A}^{b}. "nA" denotes an integer of 1 or more, preferably an integer in the range of 1 to 10, more preferably an integer in the range of 1 to 5, still more preferably 1, 2, or 3, particularly preferably 1 or 2.

The structural unit B_{A} having a phenolic hydroxy group is not particularly limited but is, for example, any one of the following structural units. In the following examples, "Rα" denotes a hydrogen atom, a halogen atom, a C₁₋₃ alkyl group, or a C₁₋₃ haloalkyl group.

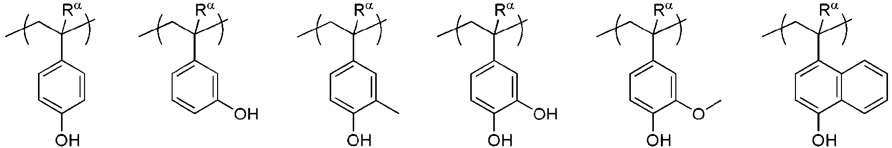

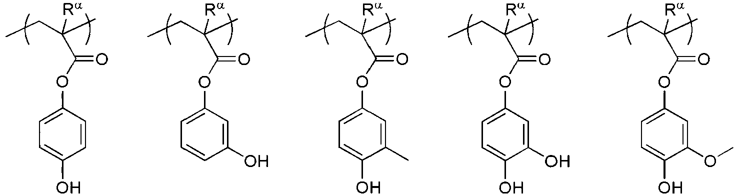

The structural unit B_{A} having a phenolic hydroxy group can be produced, for example, by polymerizing 4-vinylphenol, 4-(1-methylvinyl)phenol, 3-vinylphenol, 2-methyl-4-vinylphenol, 2-methoxy-4-vinylphenol, 4-vinylnaphthalen-1-ol, 4-hydroxyphenyl(meth)acrylate, 4-hydroxy-3-methylphenyl(meth)acrylate, 3,4-dihydroxyphenyl(meth)acrylate, 4-hydroxy-3-methoxyphenyl(meth)acrylate, or the like by a known and commonly used method.

### [1-2-2. Structural Unit B_{B} for Adjusting Solubility in Developer]

The structural unit B_{B} for adjusting solubility in a developer is not particularly limited and may be a known and commonly used one. The structural unit B_{B} is, for example, a structural unit B_{B1} having an acid-dissociable group, a structural unit B_{B2} having a lactone skeleton, a sultone skeleton, a sulfolane skeleton, a lactam skeleton, or a sultam skeleton, or the like.

When the (B) polymer contains a structural unit having an acid-dissociable group, the acid-dissociable group is eliminated by the action of an acid to yield a polar group, so that the solubility of the exposed portion and the unexposed portion in a developer can be greatly changed. When the (B) polymer contains a structural unit having a lactone skeleton or the like, the solubility in a developer can be finely adjusted.

### [1-2-2-1. Structural Unit B_{B1} Having Acid-Dissociable Group]

The structural unit B_{B1} having an acid-dissociable group is not particularly limited and may be a known and commonly used one. The structural unit B_{B1} is, for example, a structural unit B_{B1-1} or B_{B1-2} represented by the following formula (VIII-2) or (VIII-3).

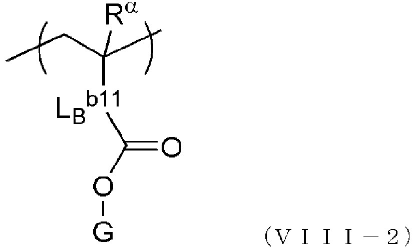

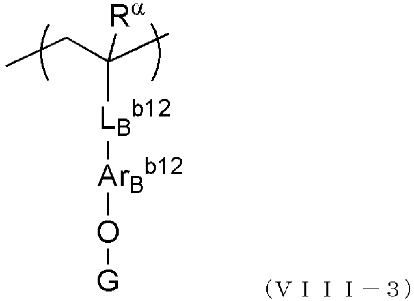

### <Structural Unit B_{B1-1} Having Acid-Dissociable Group Represented by General Formula (VIII-2)>

The structural unit B_{B1-1} represented by the following general formula (VIII-2) has a structure in which a hydrogen atom of a carboxy group is substituted with an acid-dissociable group G.

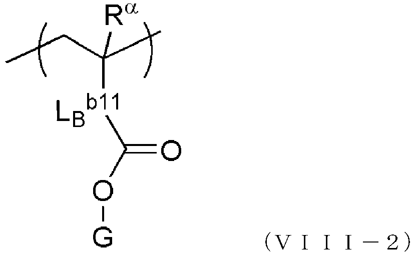

In the general formula (VIII-2), "Rα" denotes a hydrogen atom, a halogen atom, a C₁₋₃ alkyl group, or a C₁₋₃ haloalkyl group.

"L_{B}^{b11}" denotes a single bond or a C₁₋₈ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{B}^{b11} denotes a single bond or a C₁₋₈ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

"G" denotes an acid-dissociable group G, which is not particularly limited provided that it can be dissociated by the action of an acid, and may be a known and commonly used one.

The acid-dissociable group G can suitably be a tertiary-carbon-type acid-dissociable group G_{A}, an allyl- or benzyl-type acid-dissociable group G_{B}, an acetal-type acid-dissociable group G_{C}, or the like.

The structural unit B_{B1-1} having an acid-dissociable group is not particularly limited but is, for example, any one of the following structural units. In the following examples, "Rα" denotes a hydrogen atom, a halogen atom, a C₁₋₃ alkyl group, or a C₁₋₃ haloalkyl group.

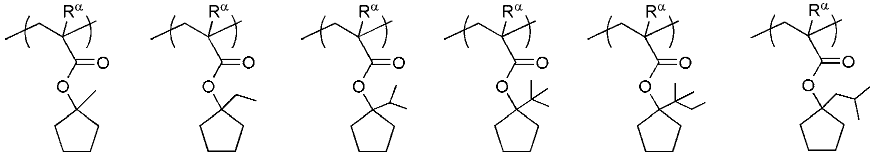

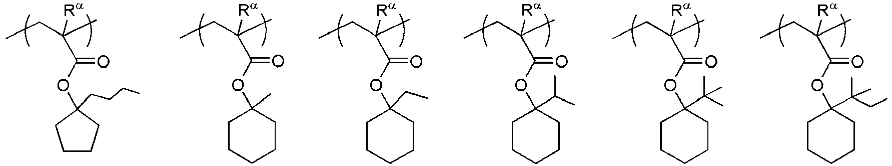

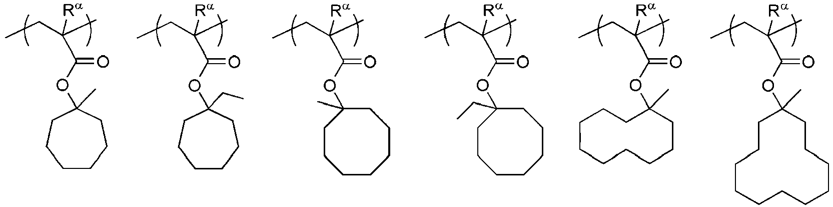

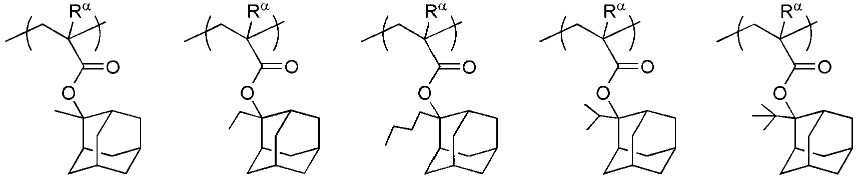

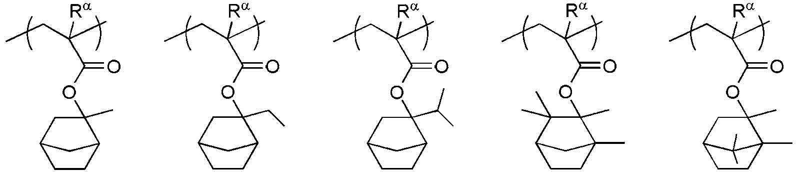

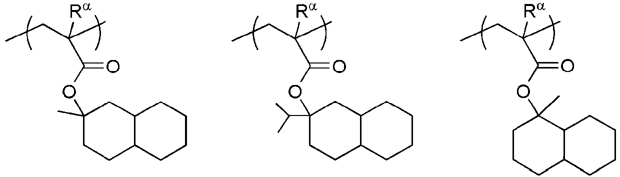

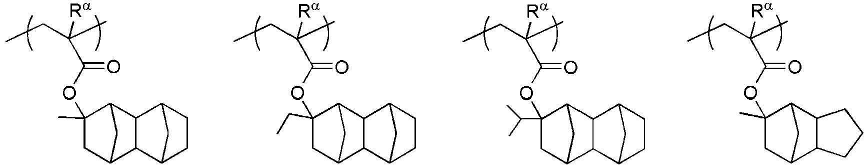

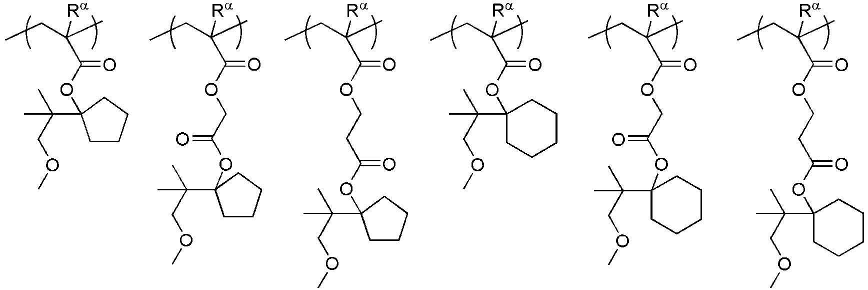

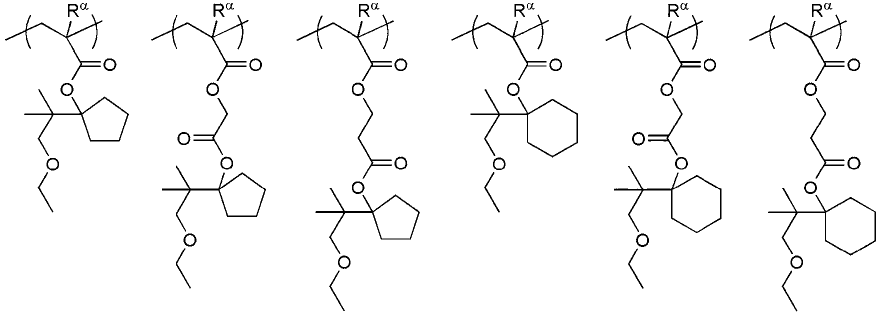

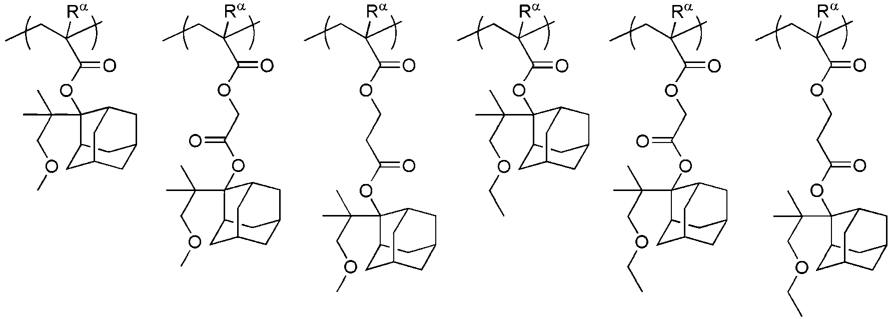

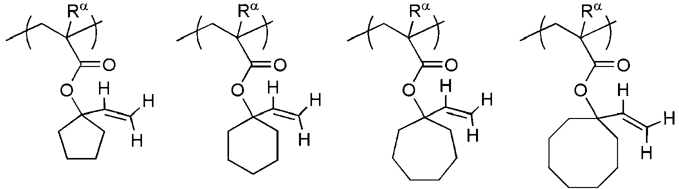

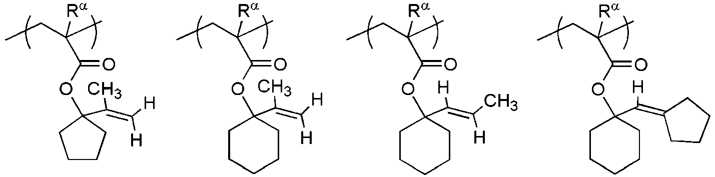

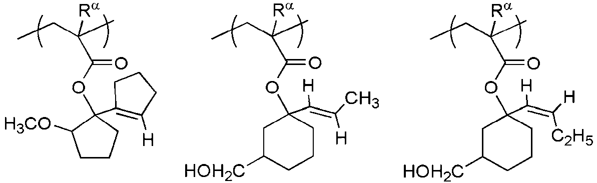

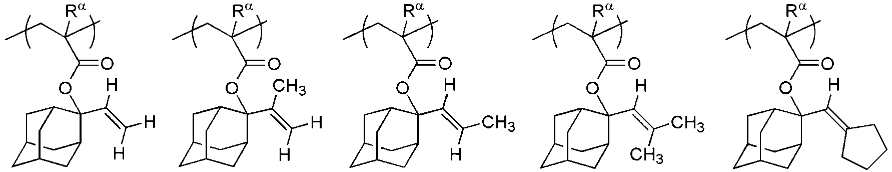

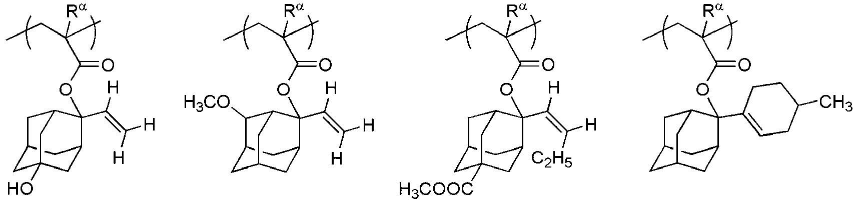

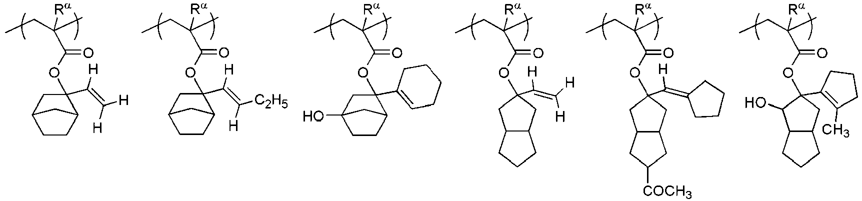

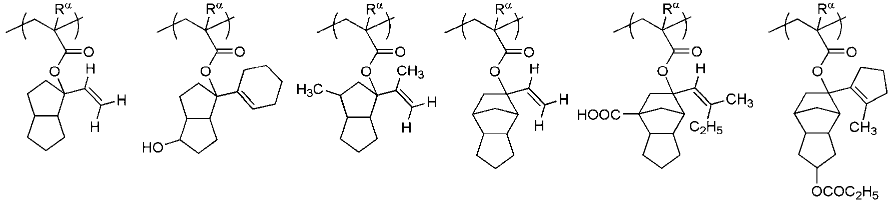

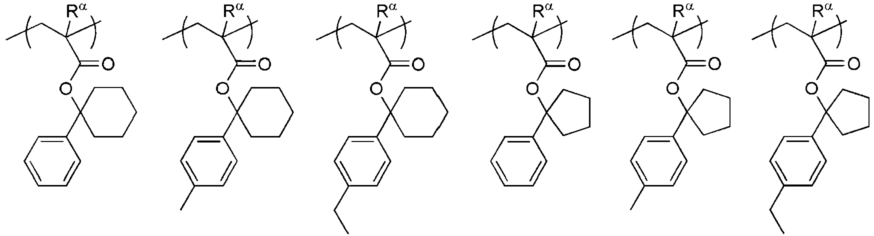

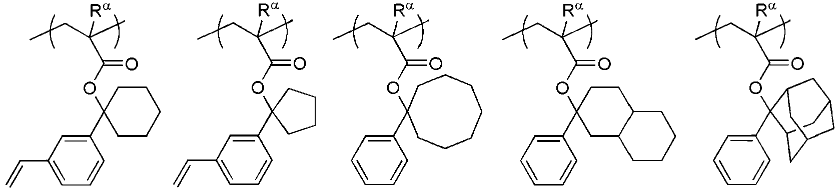

### <Structural Unit B_{B1-2} Having Acid-Dissociable Group Represented by General Formula (VIII-3)>

The structural unit B_{B1-2} represented by the following general formula (VIII-3) has a structure in which a hydrogen atom of a phenolic hydroxy group is substituted with an acid-dissociable group G.

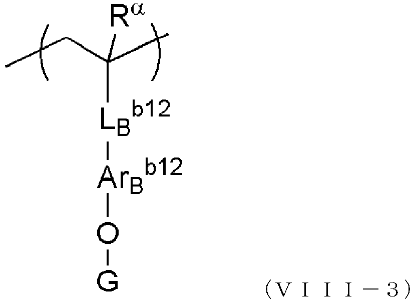

In the general formula (VIII-3), "Rα" denotes a hydrogen atom, a halogen atom, a C₁₋₃ alkyl group, or a C₁₋₃ haloalkyl group.

"L_{B}^{b12}" denotes a single bond or a C₁₋₈ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{B}^{b12} preferably denotes a single bond or a C₁₋₈ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time),
more preferably a single bond or -C(=O)-O-, -CONH-.

"Ar_{B}^{b12}" denotes a C₆₋₁₈ arylene group optionally having a substituent.

The structural unit B_{B1-2} having an acid-dissociable group is not particularly limited but is, for example, any one of the following structural units. In the following examples, "Rα" denotes a hydrogen atom, a halogen atom, a C₁₋₃ alkyl group, or a C₁₋₃ haloalkyl group.

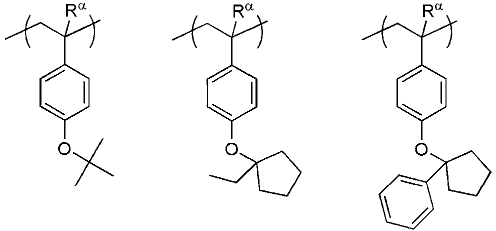

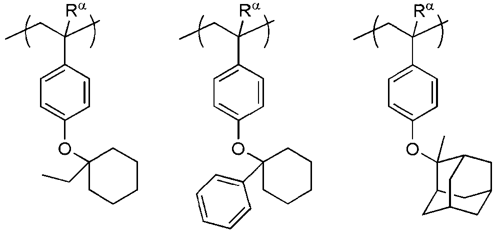

### [1-2-2-2. Structural Unit B_{B2} Having Lactone Skeleton or the Like]

The structural unit B_{B2} having a lactone skeleton is not particularly limited and may be a known and commonly used one. The structural unit B_{B2} has a ring having a lactone skeleton (having a CO-O- group in part of the ring: for example, β-propiolactone, γ-butyrolactone, δ-valerolactone, adamantane lactone, or the like), a sultone skeleton (having a SO₂-O- group in part of the ring), a sulfolane skeleton (having a -SO₂- group in part of the ring), a lactam skeleton (having a -C(OH)=N-group in part of the ring), or a sultam skeleton (having a -SO₂-NR- group in part of the ring), and the ring may be a monocyclic ring, a polycyclic ring, or a fused ring.

The structural unit B_{B2} is, for example, a structural unit represented by the following formula (VIII-4).

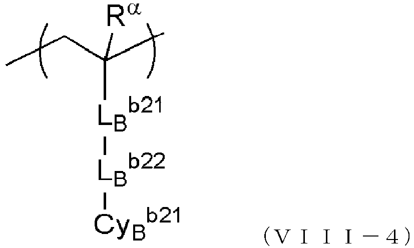

In the general formula (VIII-4), "Rα" denotes a hydrogen atom, a halogen atom, a C₁₋₃ alkyl group, or a C₁₋₃ haloalkyl group.

"L_{B}^{b21}" denotes a single bond or a C₁₋₄ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{B}^{b21} preferably denotes
a single bond or a C₁₋₄ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time),
more preferably a single bond, -C(=O)-O-, or -CONH-.

"L_{B}^{b22}" denotes a single bond or a C₁₋₈ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{B}^{b22} preferably denotes
a single bond or a C₁₋₈ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time),
more preferably a C₁₋₈ alkanediyl group optionally having a substituent, wherein any divalent carbon atom including the terminals may be substituted with -O-, -C(=O)-, -C(=O)-O-, or -O-C(=O)- (provided that adjacent divalent carbon atoms are not substituted at the same time).

"Cy_{B}^{b21}" denotes a monocyclic, polycyclic, or fused ring having a lactone skeleton, a sultone skeleton, a sulfolane skeleton, a lactam skeleton, or a sultam skeleton, each optionally having a substituent.

Cy_{B}^{b21} preferably denotes a monocyclic, polycyclic, or fused ring having a lactone skeleton, a sultone skeleton, or a sulfolane skeleton, each optionally having a substituent,
more preferably a monocyclic, polycyclic, or fused ring having a lactone skeleton or a sultone skeleton, each optionally having a substituent.

Cy_{B}^{b21} can be, for example, a monocyclic, polycyclic, or fused ring having a lactone skeleton, a sultone skeleton, or a sulfolane skeleton, as described below, and * denotes a binding site with L_{B}^{b22}. Furthermore, any hydrogen atom on these rings may be substituted with a substituent.

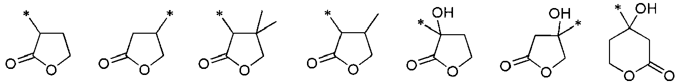

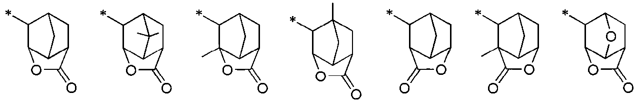

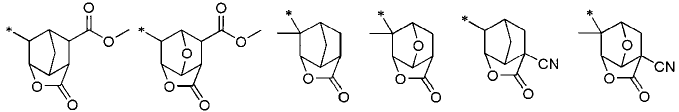

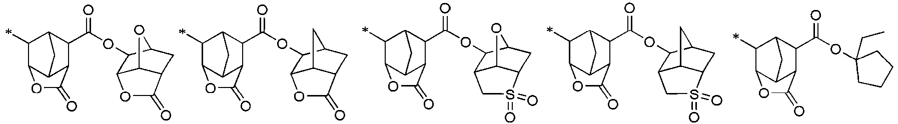

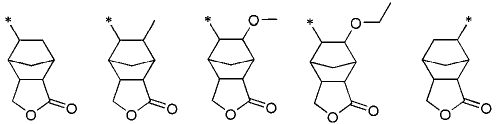

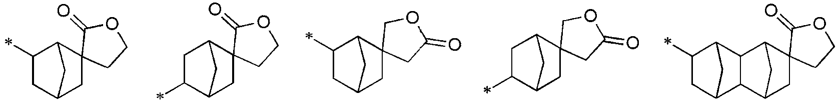

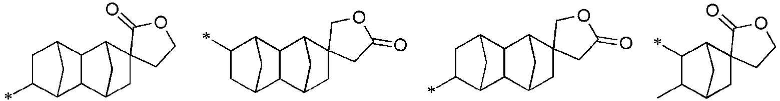

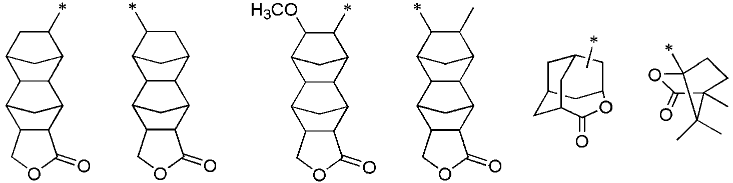

The structural unit B_{B2} having a lactone skeleton or the like is not particularly limited but is, for example, any one of the following structural units. In the following examples, "Rα" denotes a hydrogen atom, a halogen atom, a C₁₋₃ alkyl group, or a C₁₋₃ haloalkyl group.

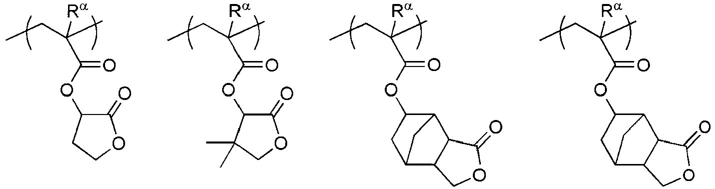

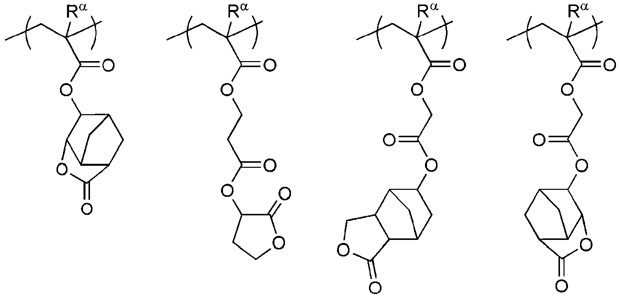

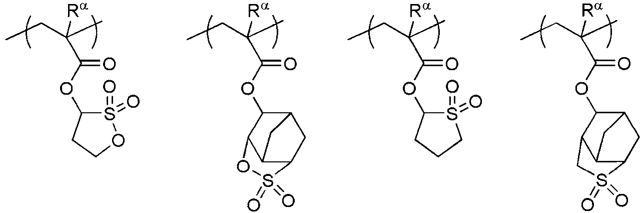

### [1-2-3. Structural Unit B_{C} Having Fluorine Atom]

The structural unit B_{C} having a fluorine atom is not particularly limited and may be a known and commonly used one. The structural unit having a fluorine atom, which has water repellency and oil repellency, in the (B) polymer can control the distribution state of the (B) polymer in the resist material and the pattern and can suppress the occurrence of bubble defects and the like in the pattern.

The structural unit B_{C} is, for example, the structural unit B_{C1}, B_{C2}, or the like represented by the following formula (VIII-5) or (VIII-6).

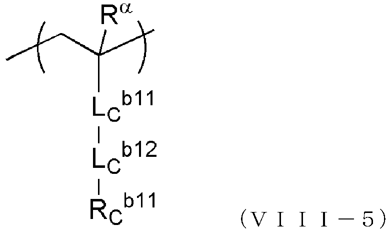

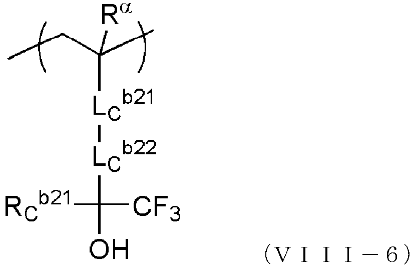

### [1-2-3-1. Structural Unit B_{C1} Having Fluorine Atom]

The structural unit B_{C1} having a fluorine atom is not particularly limited and may be a known and commonly used one. The structural unit B_{C1} is, for example, a structural unit represented by the following formula (VIII-5).

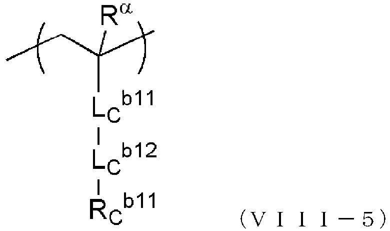

In the general formula (VIII-5), "Rα" denotes a hydrogen atom, a halogen atom, a C₁₋₃ alkyl group, or a C₁₋₃ haloalkyl group.

"L_{C}^{b11}" denotes a single bond, -O-, -C(=O)-, -C(=O)-O-, -O-C(=O)-, -CONH-, - NH(C=O)-, -S-, or -SO₂-. L_{C}^{b11} preferably denotes a single bond, -C(=O)-, -C(=O)O-, or -CONH-, more preferably a single bond or -C(=O)O-.

"L_{C}^{b12}" denotes a single bond or a C₁₋₈ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{C}^{b12} preferably denotes
a single bond or a C₁₋₈ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time),
more preferably a C₁₋₈ alkanediyl group optionally having a substituent, wherein one or more divalent carbon atoms including the terminals may be substituted with -O-, -C(=O)-, -C(=O)-O-, or -O-C(=O)- (provided that adjacent divalent carbon atoms are not substituted at the same time).

"R_{C}^{b11}" denotes a C₁₋₈ hydrocarbyl group optionally having a substituent, wherein at least one hydrogen atom is substituted with a fluorine atom.

R_{C}^{b11} preferably denotes
a C₁₋₈ hydrocarbyl group optionally having a substituent, wherein a quarter or more of the hydrogen atoms of the hydrocarbyl group are substituted with a fluorine atom,
more preferably a C₁₋₈ alkyl group optionally having a substituent, wherein one-half or more of the hydrogen atoms of the alkyl group are substituted with a fluorine atom.

The structural unit B_{C1} having a fluorine atom is not particularly limited but is, for example, the following structural units. In the following examples, "Rα" denotes a hydrogen atom, a halogen atom, a C₁₋₃ alkyl group, or a C₁₋₃ haloalkyl group.

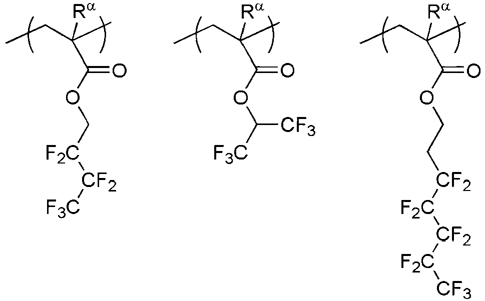

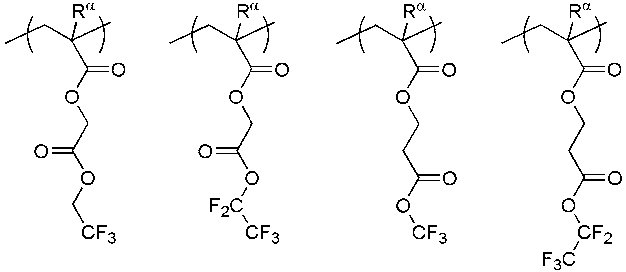

### [1-2-3-2. Structural Unit B_{C2} Having Fluorine Atom]

The structural unit B_{C2} having a fluorine atom is not particularly limited and may be a known and commonly used one. The structural unit B_{C2} is, for example, a structural unit represented by the following formula (VIII-6).

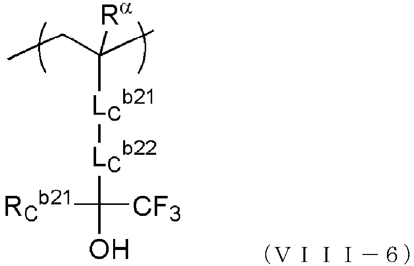

In the general formula (VIII-6), "R^{α}" denotes a hydrogen atom, a halogen atom, a C₁₋₃ alkyl group, or a C₁₋₃ haloalkyl group.

"L_{C}^{b21}" denotes a single bond, -O-, -C(=O)-, -C(=O)-O-, -O-C(=O)-, -CONH-, - NH(C=O)-, -S-, or -SO₂-. LC_{b}²¹ preferably denotes a single bond, -C(=O)-, -C(=O)O-, or -CONH-, more preferably a single bond or -C(=O)O-.

"L_{c}^{b22}" denotes a single bond or a C₁₋₈ hydrocarbylene group optionally having a substituent, wherein any divalent carbon atom including the terminals may be substituted with -O-, -C(=O)-, -C(=O)-O-, -O-C(=O)-, -CONH-, -NH(C=O)-, -S-, or - SO₂- (provided that adjacent divalent carbon atoms are not substituted at the same time).

L_{C}^{b22} preferably denotes
a single bond or a C₁₋₈ alkanediyl group optionally having a substituent, wherein any divalent carbon atom including the terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time),
more preferably a C₁₋₈ alkanediyl group optionally having a substituent, wherein one or more divalent carbon atoms including the terminals may be substituted with -O-, -C(=O)-, -C(=O)-O-, or -O-C(=O)- (provided that adjacent divalent carbon atoms are not substituted at the same time).

"R_{C}^{b21}" denotes a hydrogen atom, a fluorine atom, or a C₁₋₄ alkyl group optionally having a substituent, wherein at least one hydrogen atom is substituted with a fluorine atom.

R_{C}^{b21} preferably denotes
a fluorine atom or a C₁₋₄ alkyl group, wherein one-half or more of the hydrogen atoms of the alkyl group are substituted with a fluorine atom,
more preferably a fluorine atom or a C₁₋₄ perfluoroalkyl group,
still more preferably a fluorine atom, a trifluoromethyl group, a pentafluoroethyl group, or a heptafluoropropyl group.

R^{α} and L_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group to form a ring together.

L_{C}^{b22} and R_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group to form a ring together.

The structural unit B_{C2} having a fluorine atom is not particularly limited but is, for example, any one of the following structural units. In the following examples, "Rα" denotes a hydrogen atom, a halogen atom, a C₁₋₃ alkyl group, or a C₁₋₃ haloalkyl group.

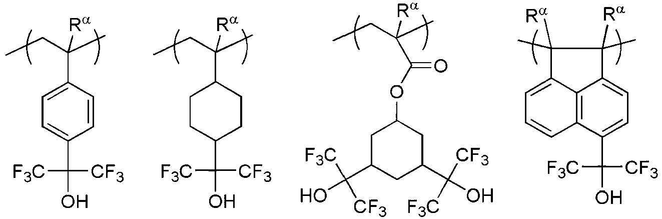

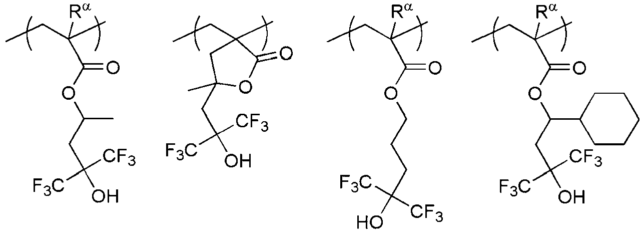

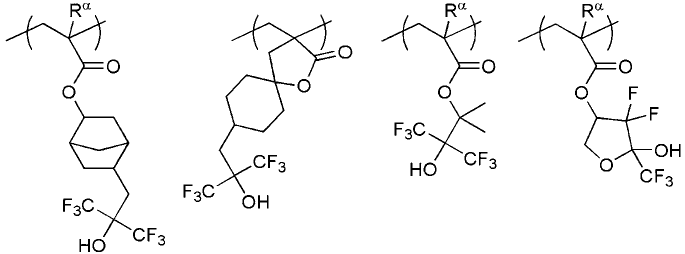

### [1-2-4. Other Structural Units]

The (B) polymer may contain another structural unit other than the structural units B_{A} to B_{C}. The other structural unit is not particularly limited but is, for example, a structural unit having (meth)acrylic acid or a (meth)acrylate derivative; a structural unit having styrene or a styrene derivative; or a structural unit having an alicyclic group with a carbonate skeleton, a carbamate skeleton, or the like.

### [1-2-5. Blend Ratio and the Like]

The (B) polymer includes one or more structural units selected from the group consisting of the structural unit B_{A} having a phenolic hydroxy group, the structural unit B_{B} for adjusting solubility in a developer, and the structural unit B_{C} having a fluorine atom.

The (B) polymer preferably includes two or more structural units selected from the group consisting of the structural unit B_{A} having a phenolic hydroxy group, the structural unit B_{B} for adjusting solubility in a developer, and the structural unit B_{C} having a fluorine atom.

Furthermore, the (B) polymer more preferably includes the structural unit B_{A} having a phenolic hydroxy group, the structural unit B_{B} for adjusting solubility in a developer, and the structural unit B_{C} having a fluorine atom.

When the (B) polymer includes the structural unit B_{A} having a phenolic hydroxy group, and the component (B) constitutes 100 parts by mass based on the solid content, the structural unit B_{A} preferably constitutes 10 to 100 parts by mass, more preferably 20 to 80 parts by mass, still more preferably 30 to 70 parts by mass.

When the (B) polymer includes the structural unit B_{A} having a phenolic hydroxy group and the structural unit B_{B} for adjusting solubility in a developer, the mole ratio of the structural unit B_{A} to the structural unit B_{B} is preferably 2 to 8:2 to 8, more preferably 3 to 7:3 to 7, still more preferably 4 to 6:4 to 6.

When the (B) polymer includes the structural unit B_{B} for adjusting solubility in a developer and the structural unit B_{C} having a fluorine atom, the mole ratio of the structural unit B_{B} to the structural unit B_{C} is preferably 1 to 9:1 to 9, more preferably 1 to 8:1 to 8, still more preferably 1 to 7:1 to 7.

When the (B) polymer includes a structural unit B_{A} having a phenolic hydroxy group and the structural unit B_{C} having a fluorine atom, the mole ratio of the structural unit B_{A} to the structural unit B_{C} is preferably 1 to 10:1 to 5, more preferably 3 to 10:1 to 4, still more preferably 5 to 10:1 to 3.

The method for synthesizing the (B) polymer is not particularly limited and may be a known and commonly used synthesis method. The method for synthesizing the (B) polymer is, for example, a synthesis method in which monomers from which each structural unit is derived are dissolved in a polymerization solvent, and a radical polymerization initiator, such as azobisisobutyronitrile (AIBN) or dimethyl azobisisobutyrate, is added thereto to perform polymerization, or the like.

The weight-average molecular weight (Mw) (in terms of polystyrene equivalent determined by gel permeation chromatography (GPC)) of the (B) polymer is not particularly limited, and the lower limit thereof is preferably 1000, more preferably 2000, still more preferably 3000. The upper limit of Mw is preferably 50,000, more preferably 40,000, still more preferably 30,000. The component (B) with Mw equal to or higher than the lower limit can improve the EL margin and sensitivity, and the component (B) with Mw equal to or lower than the upper limit can maintain the solubility.

The dispersity (Mw/Mn) of the (B) polymer is not particularly limited but preferably ranges from, for example, 1.0 to 5.0, more preferably 1.0 to 4.0, still more preferably 1.0 to 3.0. Mn means a number-average molecular weight. When the dispersity of the component (B) is within such a range and the molecular weight distribution is narrowed, the reactivity of the resist composition can be made uniform.

The content ratio of the (B) polymer to the total solid component of the resist composition preferably ranges from 0.1% to 20% by mass, more preferably 0.2% to 15% by mass, still more preferably 0.5% to 10% by mass. The term "total solid component" refers to components other than the organic solvent in the resist composition.

The (B) polymer content of the resist material according to the present embodiment is not particularly limited and can be appropriately selected depending on the content, type, and the like of the component (A). From the perspective of achieving both the etch resistance and the EL margin of the resist material, the component (B) content of the resist material preferably ranges from 0.01 to 200 parts by mass, more preferably 0.01 to 100 parts by mass, still more preferably 0.05 to 75 parts by mass, still more preferably 0.05 to 50 parts by mass, particularly preferably 0.1% to 25% by mass, relative to 100 parts by mass of the component (A).

### [1-3. Organic Solvent]

The resist material according to the present embodiment may further contain an organic solvent. The organic solvent is not particularly limited and may be a known and commonly used one. The organic solvent is preferably an organic solvent that can uniformly dissolve or disperse the (A) polyacid salt having one or more polar groups each having an acid-dissociable group or the mixture thereof and the (B) polymer during preparation.

Examples of the organic solvent include a polar solvent, such as an alcohol solvent, an ether solvent, a ketone solvent, an amide solvent, an ester solvent, a nitrile solvent, or an aprotic polar solvent, and a nonpolar solvent, such as a hydrocarbon solvent. These organic solvents may be used alone or in combination of two or more types thereof.

Specific examples of the polar solvent include an alcohol solvent, such as methanol, ethanol, isopropyl alcohol (IPA), diacetone alcohol (DAA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether;
   a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
a nitrile solvent, such as acetonitrile, propionitrile, or benzonitrile; and
an aprotic polar solvent, such as γ-butyrolactone, δ-valerolactone, γ-lactam, δ-lactam, dimethyl sulfoxide (DMSO), sulfolane, 1,3-dimethyl-2-imidazolidinone, or tetramethylurea; and
the nonpolar solvent may be a hydrocarbon solvent, such as n-pentane, n-hexane, toluene, or xylene; or the like.

These organic solvents may be used alone or in combination of two or more types thereof.

The organic solvent to be contained in the resist material according to the present embodiment is preferably a polar solvent from the perspective of coatability, more preferably an amide solvent, an ester solvent, an alcohol solvent, or a ketone solvent from the perspective of solubility. The amide solvent is preferably at least one selected from the group consisting of N,N-dimethylformamide, N,N-diethylformamide, acetamide, and N-methylpyrrolidone. Furthermore, from the perspective of solubility, the ester solvent or the alcohol solvent preferably has an ester bond and/or a hydroxy group, and among those described above, at least one selected from the group consisting of propylene glycol monomethyl ether, methyl lactate, ethyl lactate, methyl acetate, ethyl acetate, methyl pyruvate, ethyl pyruvate, and propylene glycol monomethyl ether acetate is preferred.

The organic solvent content of the resist material is not particularly limited and can be appropriately determined according to the method for applying the resist material to a substrate or the like, the thickness of the film to be applied, or the like. The organic solvent content of the resist material is such that the solid concentration of the resist material preferably ranges from 0.01% to 20% by mass, more preferably 0.1% to 15% by mass, still more preferably 0.2% to 10% by mass.

### [1-4. Others]

If desired, the resist material according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like. Furthermore, an acid generator, an acid diffusion control agent, and the like may be further added to the resist material according to the present embodiment.

The resist material according to the present embodiment preferably does not contain an epoxy resin. Furthermore, hydrogen peroxide is also preferably not contained.

### [2. Pattern Formation Method]

The pattern formation method according to the present embodiment includes a step of applying a resist material to a substrate, a step of exposing a resist film formed by the application step, and a step of developing the exposed resist film.

### [2-1. Application Step]

The pattern formation method according to the present embodiment includes the step of applying a resist material to a substrate.

### <Substrate>

The substrate used in the present embodiment is not particularly limited and can be a known and commonly used substrate. The substrate is, for example, a substrate for an electronic component, a substrate on which a predetermined wiring pattern is formed, or the like.

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, or the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

### <Application Method>

The method for applying the resist material to a substrate is not particularly limited and can be a known and commonly used method. The application method includes a dry method, for example, a chemical vapor deposition (CVD) method, such as thermal CVD, plasma CVD, or photo CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist material according to the present embodiment to a substrate is preferably a wet method, such as a spin coating method or screen printing, more preferably a spin coating method. After the coating film is formed, a backside rinse step, an edge bead removal step, or the like may be performed to remove an edge bead.

A resist film formed by applying the resist material to a substrate may be dried by any method, for example, using a heater (post-apply bake (PAB)), such as a hot plate, or a pressure reduction apparatus.

The baking conditions are not particularly limited and can be appropriately determined according to the type, application, or the like of the resist film. The baking temperature preferably ranges from 80°C to 300°C, more preferably 80°C to 200°C, still more preferably 80°C to 130°C. The baking time preferably ranges from 10 seconds to 300 seconds, more preferably 20 seconds to 180 seconds, still more preferably 30 seconds to 120 seconds.

The thickness of the resist film after drying is preferably, but not limited to, in the range of 0.5 to 100 nm, more preferably 1 to 75 nm, still more preferably 1 to 60 nm.

### [2-2. Exposure Step]

The pattern formation method according to the present embodiment includes a step of exposing the resist film formed by the application step.

As an exposure apparatus in the exposure step of the resist film, for example, an ArF exposure apparatus, an electron-beam lithography system, an EUV exposure apparatus, or the like can be used. Furthermore, in the exposure step, exposure may be performed through a mask (mask pattern) on which a predetermined pattern is formed, or selective exposure may be performed by drawing or the like by direct irradiation with an electron beam without using a mask pattern.

The exposure wavelength is not particularly limited, and radiation, such as an ArF excimer laser (wavelength: 193 nm), a KrF excimer laser (248 nm), an F₂ excimer laser (wavelength: 157 nm), extreme ultraviolet (EUV), vacuum ultraviolet (VUV), an electron beam (EB), X-rays, soft X-rays, or the like may be used.

For an ArF excimer laser or a KrF excimer laser, the exposure level on the resist film preferably ranges from 1 to 200 mJ/cm², more preferably 20 to 60 mJ/cm². Furthermore, for extreme ultraviolet, the exposure level is, for example, 500 mJ/cm² or less, preferably 0.1 to 200 mJ/cm², more preferably 3 to 100 mJ/cm², still more preferably 5 to 50 mJ/cm².

For an electron beam, exposure at a dose in the range of 3 µC/cm² to 2 mC/cm² at 50 kV is preferred, and exposure at a dose in the range of 10 µC/cm² to 1.5 mC/cm² is more preferred.

After the resist film is exposed, a baking (post-exposure bake (PEB)) treatment may or may not be performed. The baking conditions are not particularly limited and can be appropriately determined according to the type, application, or the like of the resist film. The baking temperature preferably ranges from 80°C to 300°C, more preferably 80°C to 200°C, still more preferably 80°C to 130°C, using a heater, such as a hot plate. The baking time preferably ranges from 10 seconds to 300 seconds, more preferably 20 seconds to 180 seconds, still more preferably 30 seconds to 120 seconds.

### [2-3. Development Step]

The pattern formation method according to the present embodiment includes the step of developing the exposed resist film. In the development step, the exposed resist film can be developed with a developer to form a pattern. A case where the exposed region remains as a pattern after development is a negative patterning process, and a case where the exposed region is removed after development is a positive patterning process. Whether a positive type or negative type pattern is formed can be appropriately selected depending on the resist material or the developer. Furthermore, the development may be followed by washing with a rinse liquid and drying, and in some cases, further followed by a baking treatment.

As the developer used in the present embodiment, an alkali developer may be used as a developer for an alkali development process, and a developer containing an organic solvent (organic developer) may be used as a developer for an organic solvent development process.

### <Alkaline Development Process>

It is difficult for a known metal oxide resist material to form a positive pattern with high resolution by an alkaline development process.

On the other hand, the resist material according to the present embodiment includes the (A) polyacid salt having one or more polar groups each having an acid-dissociable group or the mixture thereof, which has an onium cation or onium dication in the cation moiety thereof. Thus, when the resist material according to the present embodiment is exposed to DUV, XUV, EUV, an electron beam, or the like, generate an acid, and the acid-dissociable group can be dissociated by the action of the acid, thereby changing the solubility in a developer, particularly an alkaline developer, and forming a pattern with high resolution.

The alkali developer used in the alkali development process is not particularly limited, and a known and commonly used alkali developer can be used. Examples of the alkali developer include aqueous solutions containing one or more of quaternary ammonium salts such as tetramethylammonium hydroxide and (2-hydroxyethyl)trimethylammonium hydroxide; inorganic alkalis such as sodium hydroxide and potassium hydroxide; and alkanolamines such as dimethylethanolamine and triethanolamine.

As the rinsing liquid in the alkali development process, pure water can be used.

### <Organic Solvent Development Process>

Examples of the developer used in the organic solvent development process include developers containing one or more organic solvents such as polar solvents, e.g., ketone solvents, ester solvents, alcohol solvents, nitrile solvents, amide solvents, and ether solvents, and hydrocarbon solvents.

Specific examples of the organic solvent include:
a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
an alcohol solvent, such as methanol, ethanol, isopropyl alcohol (IPA), diacetone alcohol (DAA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
a nitrile solvent, such as acetonitrile, propionitrile, or benzonitrile;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether; and
a hydrocarbon solvent, such as n-pentane, n-hexane, toluene, or xylene.
These may be used alone or in combination of two or more types thereof.

Among these, the organic solvent used in the developer is preferably a polar solvent, preferably contains an amide solvent, an alcohol solvent, or an ester solvent, more preferably contains an amide solvent or an ester solvent and an alcohol solvent. The amide solvent is preferably at least one selected from the group consisting of N,N-dimethylformamide, N,N-diethylformamide, acetamide, and N-methylpyrrolidone.

Furthermore, the ester solvent is preferably one or more selected from the group consisting of methyl lactate, ethyl lactate (EL), methyl acetate, ethyl acetate, methyl pyruvate, ethyl pyruvate, methyl methoxypropionate, and propylene glycol monomethyl ether acetate.

The alcohol solvent is preferably at least one selected from the group consisting of ethanol, isopropyl alcohol (IPA), diacetone alcohol (DAA), 3-methoxybutanol, 3-methyl-3-methoxybutanol, 1-methoxy-2-propanol, 4-methyl-2-pentanol, benzyl alcohol, and 4-methylbenzyl alcohol.

In a case where the developer contains both an amide solvent or an ester solvent and an alcohol solvent, the blend ratio (weight ratio) of the amide solvent or the ester solvent to the alcohol solvent preferably ranges from 5:95 to 95:5, more preferably 10:90 to 90:10.

The method for developing the exposed resist film using the developer is not particularly limited and can be a known and commonly used method. The method of developing using the developer is, for example, a method of immersing the substrate having the exposed resist film in the developer for a certain period (dip method), a method of spraying the developer on the surface of the exposed resist film (spray method), a method of discharging the developer from a discharge nozzle at a constant speed toward the surface of the exposed resist film on the substrate rotating at a constant speed (dynamic dispense method), or the like.

The development with the developer may be followed by a step of washing with a rinse liquid. The rinse liquid is not particularly limited and may be a known and commonly used rinse liquid. As the rinse liquid, among water or the organic solvent(s) in the developer, a solvent that is less likely to dissolve the resist pattern can be appropriately selected and used.

The rinse liquid is, for example, but not limited to, at least one organic solvent selected from the group consisting of a hydrocarbon solvent, a ketone solvent, an ester solvent, an alcohol solvent, an amide solvent, and an ether solvent. Among these, the rinse liquid is preferably at least one organic solvent selected from the group consisting of a hydrocarbon solvent, a ketone solvent, an ester solvent, an alcohol solvent, and an amide solvent, more preferably at least one selected from the group consisting of an alcohol solvent and an ester solvent, still more preferably at least one alcohol solvent.

The alcohol solvent used in the rinse liquid is preferably a monohydric alcohol with 2 to 8 carbon atoms, and the monohydric alcohol may be linear, branched, or cyclic. Specific examples of the monohydric alcohol include ethanol, isopropyl alcohol (IPA), butanol, 1-hexanol, 1-heptanol, 1-octanol, 2-hexanol, 2-heptanol, 2-octanol, 3-hexanol, 3-heptanol, 3-octanol, 4-octanol, and benzyl alcohol.

These organic solvents may be used alone or in combination of two or more types thereof.

The method for washing the resist pattern with the rinse liquid is not particularly limited and can be a known and commonly used method. The method of washing using the rinse liquid is, for example, a method of immersing the resist pattern in the rinse liquid for a certain period (dip method), a method of spraying the rinse liquid onto the surface of the resist pattern (spray method), and a method of discharging the rinse liquid from a discharge nozzle at a constant speed toward the surface of the resist pattern rotating at a constant speed (dynamic dispense method), or the like.

### [3. Patterned Structure]

A patterned structure according to the present embodiment is produced by forming a pattern of the resist material on a substrate by the pattern formation method.

The average thickness of part or all of the patterned structure according to the present embodiment is not particularly limited and can be appropriately determined depending on the intended use or the like. The patterned structure preferably has a portion with an average thickness in the range of 1 to 100 nm, more preferably has a portion with an average thickness in the range of 5 to 75 nm, and still more preferably has a portion with an average thickness in the range of 10 to 60 nm.

The pitch of part or all of the patterned structure according to the present embodiment is not particularly limited and can be appropriately determined depending on the intended use or the like. The patterned structure preferably has a portion with a pitch of 100 nm or less, more preferably has a portion with a pitch of 50 nm or less, and still more preferably has a portion with a pitch of 20 nm or less.

The resist material according to the present embodiment can be patterned by the pattern formation method to form a portion with a pitch of 50 nm, a portion with a pitch of 20 nm, and a portion with a pitch of 15 nm in part or all of the patterned structure.

### [4. Resist Material for Electron Beam or EUV]

The resist material according to the present embodiment contains the (A) polyacid salt having one or more polar groups each having an acid-dissociable group or the mixture thereof and the (B) polymer. Thus, in the resist material according to the present embodiment, the acid-dissociable group can be dissociated by the action of an acid, the solubility in a developer can be changed, and a pattern can be formed with high resolution. The component (A) in the resist material can improve the etch resistance.

The (B) polymer in the resist material can improve the EL margin.

### EXAMPLES

The present invention will be more specifically described below with reference to examples, but the present invention is not limited to these examples.

### [1. Synthesis of Polyacid Salt Having Polar Group Having Acid-Dissociable Group]

Polyacid salts (A-1) and (A-7) were synthesized by the following methods.

### <Production Example: Potassium Undecatungstosilicate (α-K₈[SiW₁₁O₃₉])>

380 g of 1 M acetic acid was added to 63 g of silicotungstic acid hydrate (manufactured by Nippon Inorganic Colour & Chemical Co., Ltd.: H₄[SiW₁₂O₄₀]·xH₂O), and the reaction liquid was heated to 45°C. The pH was adjusted to 6.0 by addition of potassium hydrogen carbonate (52 g). The reaction liquid was then cooled to room temperature and was suction-filtered to prepare 56 g of a crude product. 216 g of pure water was added to the crude product, followed by heating to 73°C to redissolve the crude product. The solution was cooled at 4°C for 16 hours to recrystallize, and the resulting crystals were suction-filtered and dried under vacuum to yield 34 g of the target compound.
²⁹Si-NMR (119.22 MHz, D₂O): δ(ppm)= -84.6(s, 1Si).
¹⁸³W-NMR (20.84 MHz, D₂O): δ(ppm)= -101.85(s, 2W), -116.26(s, 2W), -119.29(s, 1W), -125.62(s, 2W), -140.85(s, 2W), -174.53(s, 2W).

### <Synthesis Example 1: tetrakis((4-(2-((1-ethylcyclopentyl)oxy)-2-oxoethoxy)-3,5-dimethylphenyl)diphenylsulfonium)(1,3-di(3-(2-(1-methylcyclopentyloxycarbonyl)ethylthio)propyl)disiloxane-1,1,3,3-tetrayl)undecatungstosilicate (polyacid salt (A-1))>

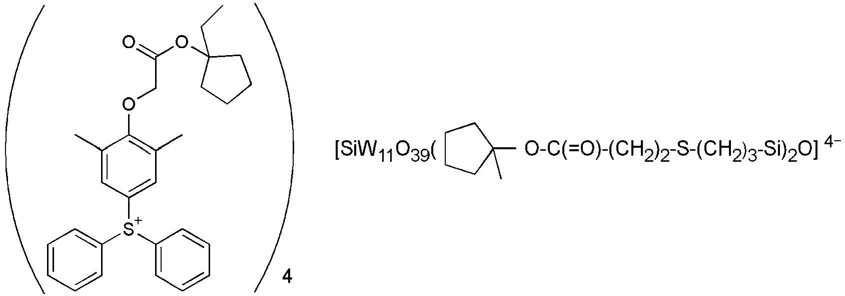

3.8 g (10.9 mmol) of (3-(2-(1-methylcyclopentyloxycarbonyl)ethylthio)propyl)trimethoxysilane was added to a mixed solvent of 402 g of acetonitrile and 184 g of pure water, and 10.9 g (3.6 mmol) of the synthesized mono-lacunary Keggin-type potassium undecatungstosilicate (α-K₈[SiW₁₁O₃₉]) was added thereto. The pH was adjusted to 1.8 using 1 M hydrochloric acid. After stirring for 2 hours, the unreacted powder was filtered off by suction filtration, and the filtrate was concentrated to approximately 200 g using a rotary evaporator. A solution of 9.9 g (18.2 mmol) of (4-(2-((1-ethylcyclopentyl)oxy)-2-oxoethoxy)-3,5-dimethylphenyl)diphenylsulfonium bromide dissolved in 40 g of methanol was added to the concentrate to precipitate a powder. The precipitated powder was filtered off by suction filtration and was washed three times each with 180 mL of pure water, 180 mL of methanol, and 180 mL of methyl-t-butyl ether. The powder was then dispersed and washed with 160 g of methanol for 3 hours, was filtered off again by suction filtration, and was washed with 160 g of methanol three times. Furthermore, the powder was sufficiently dried under vacuum to yield 15.4 g of the target compound, a polyacid salt (A-1), as a white powder.
¹H-NMR(400 MHz, DMSO-d6) :δ(ppm) =0.67(t, 4H), 0.77-0.81(t, 12H), 1.48-1.75(m, 46H), 1.90-1.93(m, 16H), 1.99-2.08(m, 4H), 2.29(m, 24H), 2.49(t, 4H), 2.58(t, 4H), 2.67(t, 4H), 4.55(s, 8H), 7.59(s, 8H), 7.76-7.82(m, 40H).
²⁹ Si-NMR(119.22 MHz, DMSO-d6): δ(ppm)=-53.02(s ,2Si), -85.04(s, 1Si). ESI-MS:POSITIVE m/z 461.2([C₂₉H₃₃O₃S]⁺)
   NEGATIVE m/z 801.1(median)([C₂₄H₄₂O₄₄S₂Si₃W₁₁]⁴⁻)

### <Synthesis Example 2: tetrakis(triphenylsulfonium)silicotungstate (polyacid salt (A-2))>

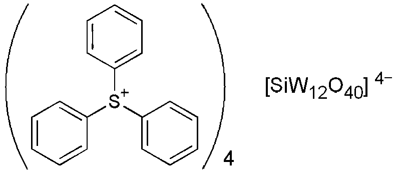

27.95 g of triphenylsulfonium chloride was dissolved in 50 g of cyclohexanone, 41.97 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a polyacid salt (A-2) as a target compound.
¹H-NMR(400 MHz, DMSO-D6) :δ(ppm)=7.74-7.90(m, 60H).
¹⁸³W-NMR(20.84 MHz, DMSO-D6) :δ(ppm)=-92.7(s, 12W).
ESI-MS:NEGATIVE m/z 718.5(median)([SiW₁₂O₄₀]⁴⁻)
XPS analysis S:W (mol ratio of S and W)=4:12

### <Synthesis Example 3: tetrakis(triphenylsulfonium)(1,3-bis(3-(2-(1-methylcyclopentyloxycarbonyl)ethylthio)propan-1-yl)disiloxane-1,1,3,3-tetrayl)undecatungstosilicate (polyacid salt (A-3))>

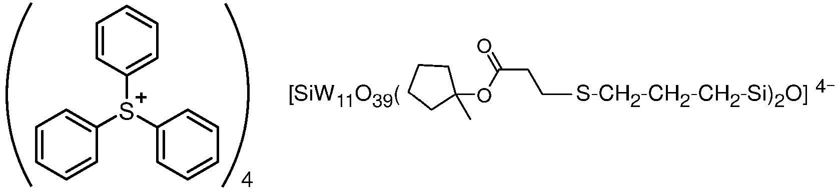

A polyacid salt (A-3) was produced as a target compound in the same manner as in Synthesis Example 1 except that triphenylsulfonium chloride was used as a raw material compound instead of (4-(2-((1-ethylcyclopentyl)oxy)-2-oxoethoxy)-3,5-dimethylphenyl)diphenylsulfonium bromide.
¹H-NMR(400 MHz, DMSO-d6) :δ(ppm)=0.67(t, 4H), 1.49(s, 6H), 1.54-1.71(m, 16H), 1.99-2.08(m, 4H), 2.49(t, 4H), 2.58(t, 4H), 2.67(t, 4H), 7.78-7.87(m, 60H). ²⁹Si-NMR(119.22 MHz, DMSO-d6): δ(ppm)=-53.02(s, 2Si), -85.04(s, 1Si).
ESI-MS:POSITIVE m/z 263.1([C₁₈H₁₅S]⁺)
NEGATIVE m/z 801.1(median)([C₂₄H₄₂O₄₄S₂Si₃W₁₁]⁴⁻)

### <Synthesis Example 4: tetrakis((4-(2-((1-ethylcyclopentyl)oxy)-2-oxoethoxy)-3,5-dimethylphenyl)diphenylsulfonium)silicotungstate (polyacid salt (A-4))>

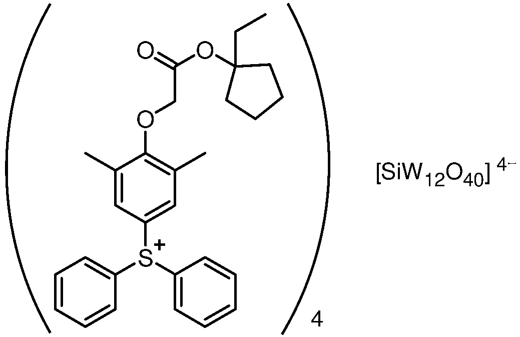

35.47 g of (4-(2-((1-ethylcyclopentyl)oxy)-2-oxoethoxy)-3,5-dimethylphenyl)diphenylsulfonium chloride was dissolved in 50 g of cyclohexanone, 41.06 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a polyacid salt (A-4) as a target compound.
¹H-NMR(400 MHz, DMSO-D6): δ(ppm)=7.76-7.82(m, 40H), 7.59(s, 8H), 4.55(s, 8H), 2.29(m, 24H), 1.90-1.93(m, 16H), 1.48-1.75(m, 24H), 0.77-0.81(t, 12H).
¹⁸³W-NMR(20.84 MHz, DMSO-D6) :δ(ppm)=-92.7(s, 12W).
ESI-MS:NEGATIVE m/z 718.5(median)([SiW₁₂O₄₀]⁴⁻)
XPS analysis S:W(mol ratio of S and W)=4:12

### <Synthesis Example 5: tetrakis((4-(2-((1-ethylcyclopentyl)oxy)-2-oxoethoxy)-3,5-dimethylphenyl)diphenylsulfonium)(1,3-di(2-((1-methylcyclopentyl)oxycarbonyl)ethyl)disiloxane-1,1,3,3-tetrayl)undecatungstosilicate (polyacid salt (A-5))>

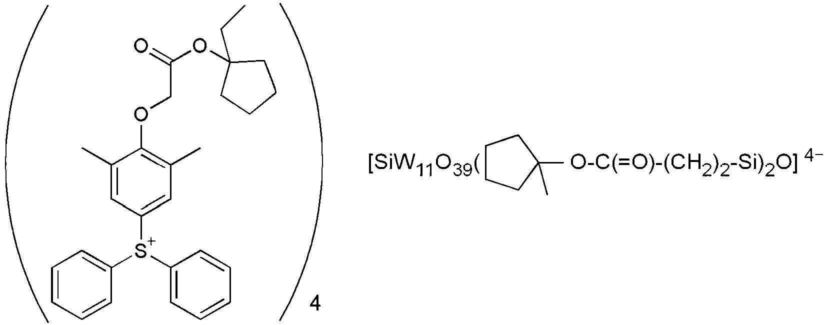

A polyacid salt (A-5) was produced as a target compound in the same manner as in Synthesis Example 1 except that, as raw material compounds, (2-((1-methylcyclopentyl)oxycarbonyl)ethyltrimethoxysilane was used instead of (3-(2-(1-methylcyclopentyloxycarbonyl)ethylthio)propyl)trimethoxysilane.
¹H-NMR(400 MHz, DMSO-d6): δ(ppm)=0.77-0.81(m, 16H), 1.48-1.93(m, 62H), 2.29(m, 24H), 2.37-2.42(m, 4H), 4.55(s, 8H), 7.59(s, 8H), 7.76-7.82(m, 40H).
²⁹Si-NMR (119.22 MHz,DMSO-d6): δ(ppm)=-53.12(s, 2Si), -85.01(s, 1Si).
ESI-MS: POSITIVE m/z 461.2 ([C₂₉H₃₃O₃S]⁺)
   NEGATIVE m/z 764.4 (median) ([C₁₈H₃₀O₄₄Si₃W₁₁]⁴⁻)

### <Synthesis Example 6: tetrakis((3,5-dimethyl-4-((2-methyladamantan-2-yl)oxycarbonylmethyloxy)phenyl)diphenylsulfonium)(1,3-di(3-(2-(1-methylcyclopentyloxycarbonyl)ethylthio)propyl)disiloxane-1,1,3,3-tetrayl)undecatungstosilicate (polyacid salt (A-6))>

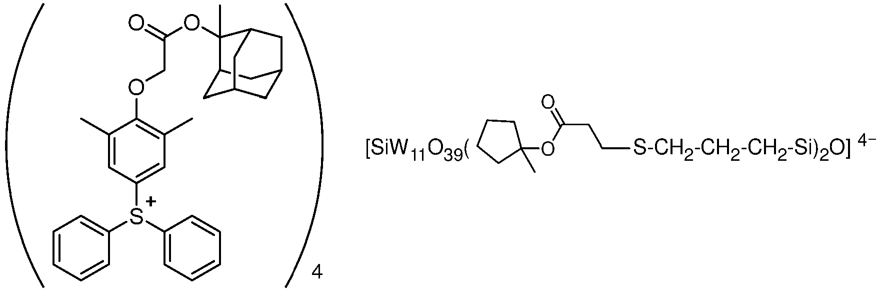

A polyacid salt (A-6) was produced as a target compound in the same manner as in Synthesis Example 1 except that (3,5-dimethyl-4-((2-methyladamantan-2-yl)oxycarbonylmethyloxy)phenyl)diphenylsulfonium chloride was used as a raw material compound instead of (4-(2-((1-ethylcyclopentyl)oxy)-2-oxoethoxy)-3,5-dimethylphenyl)diphenylsulfonium bromide.
¹H-NMR(400 MHz, DMSO-d6): δ(ppm)=0.67(t, 4H), 1.49-2.08(m, 94H), 2.31(s, 24H), 2.49(t, 4H), 2.58(t, 4H), 2.67(t, 4H), 4.62(s, 8H), 7.61(s, 8H), 7.75-7.86(m, 40H). ²⁹Si-NMR(119.22 MHz, DMSO-d6) :δ(ppm)=-53.02(s, 2Si), -85.04(s, 1Si).
ESI-MS:POSITIVE m/z 513.2([C₃₃H₃₇O₃S]⁺)
NEGATIVE m/z 801.1(median)([C₂₄H₄₂O₄₄S₂Si₃W₁₁]⁴⁻)

### <Synthesis Example 7: tetrakis((4-(t-butyloxycarbonylmethyloxy)-3,5-dimethylphenyl)diphenylsulfonium)(1,3-di(3-(2-(1-methylcyclopentyloxycarbonyl)ethylthio)propyl)disiloxane-1,1,3,3-tetrayl)undecatungstosilicate (polyacid salt (A-7))>

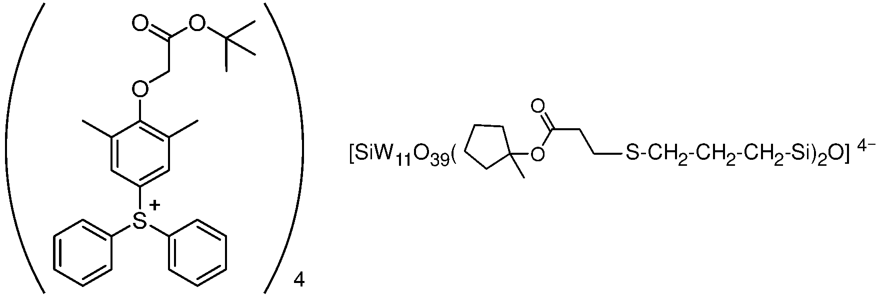

A polyacid salt (A-7) was produced as a target compound in the same manner as in Synthesis Example 1 except that (4-(t-butyloxycarbonylmethyloxy)-3,5-dimethylphenyl)diphenylsulfonium chloride was used as a raw material compound instead of (4-(2-((1-ethylcyclopentyl)oxy)-2-oxoethoxy)-3,5-dimethylphenyl)diphenylsulfonium bromide.
¹H-NMR(400MHz, DMSO-d6) :δ(ppm)=0.67(t, 4H), 1.42(s, 36H), 1.49(s, 6H), 1.54-1.71(m, 16H), 1.99-2.08(m, 4H), 2.15(s, 24H), 2.49(t, 4H), 2.58(t, 4H), 2.67(t, 4H), 4.99(s, 8H), 7.11(s, 8H), 7.33-7.36(m, 40H).
²⁹Si-NMR(119.22 MHz, DMSO-d6): δ(ppm)=-53.02(s, 2Si), -85.04(s, 1Si).
ESI-MS:POSITIVE m/z 421.2([C₂₆H₂₉O₃S]⁺)
NEGATIVE m/z 801.1(median)([C₂₄H₄₂O₄₄S₂Si₃W₁₁]⁴⁻)

### [2. Preparation of Test Resist Material]

Test resist materials (R-1) to (R-25) were prepared by blending the synthesized polyacid salts (A-1) to (A-7), the polymers (B-1) to (B-7) shown in Tables 1 and 2 below, and an organic solvent as test resist materials so as to have the contents (unit: parts by mass) shown in Tables 1 and 2 below.

The details of the polymers (B-1) to (B-7) shown in Tables 1 and 2 are as described below.
- Polymer (B-1): a polymer represented by the following formula (B-1) produced by copolymerizing 4-vinylphenol, which provides a structural unit having a phenolic hydroxy group, and 1-phenylcyclopentyl methacrylate, which provides a structural unit for adjusting solubility in a developer (mole ratio: 40:60; weight-average molecular weight (Mw) in terms of standard polystyrene equivalent determined by GPC measurement: 5000). 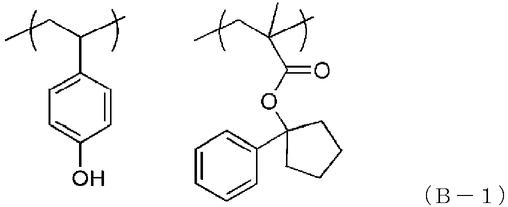
- Polymer (B-2): a polymer represented by the following formula (B-2) produced by polymerizing 4-vinylphenol, which provides a structural unit having a phenolic hydroxy group (weight-average molecular weight (Mw) in terms of standard polystyrene equivalent determined by GPC measurement: 8000). 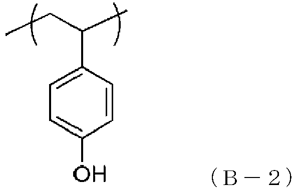
- Polymer (B-3): a polymer represented by the following formula (B-3) produced by copolymerizing 1-ethylcyclooctyl methacrylate, which provides a structural unit for adjusting solubility in a developer, 2-oxo-2-(2,2,2-trifluoroethoxy)ethyl methacrylate, which provides a structural unit having a fluorine atom, and methacrylic acid, which provides another structural unit (mole ratio: 20:70:10; weight-average molecular weight (Mw) in terms of standard polystyrene equivalent determined by GPC measurement: 27000). 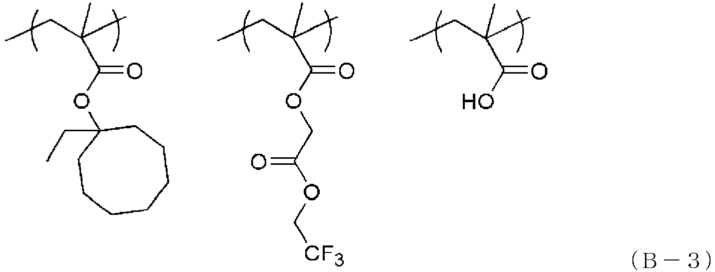
- Polymer (B-4): a polymer represented by the following formula (B-4) produced by copolymerizing 5-oxotetrahydrofuran-3-yl methacrylate, which provides a structural unit for adjusting solubility in a developer, and 5,5,5-trifluoro-4-hydroxy-4-(trifluoromethyl)pentan-2-yl methacrylate, which provides a structural unit having a fluorine atom (mole ratio: 20:80; weight-average molecular weight (Mw) in terms of standard polystyrene equivalent determined by GPC measurement: 8000). 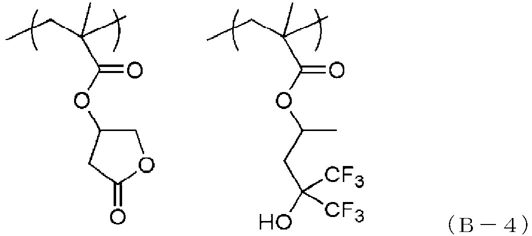
- Polymer (B-5): a polymer represented by the following formula (B-5) produced by copolymerizing 4-vinylphenol, which provides a structural unit having a phenolic hydroxy group, 1-ethylcyclooctyl methacrylate, which provides a structural unit for adjusting solubility in a developer, and 2-oxo-2-(2,2,2-trifluoroethoxy)ethyl methacrylate, which provides a structural unit having a fluorine atom (mole ratio: 10:20:70; weight-average molecular weight (Mw) in terms of standard polystyrene equivalent determined by GPC measurement: 23000). 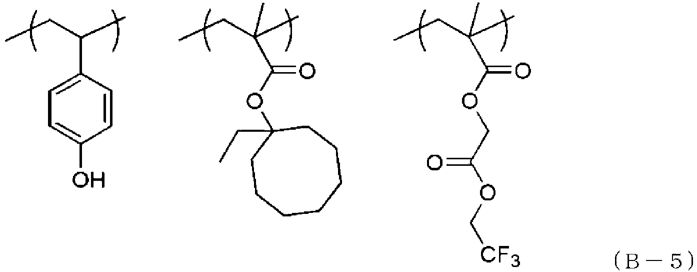
- Polymer (B-6): a polymer represented by the following formula (B-6) produced by copolymerizing 4-vinylphenol, which provides a structural unit having a phenolic hydroxy group, and 2-oxo-2-(2,2,2-trifluoroethoxy)ethyl methacrylate, which provides a structural unit having a fluorine atom (mole ratio: 20:80; weight-average molecular weight (Mw) in terms of standard polystyrene equivalent determined by GPC measurement: 20000). 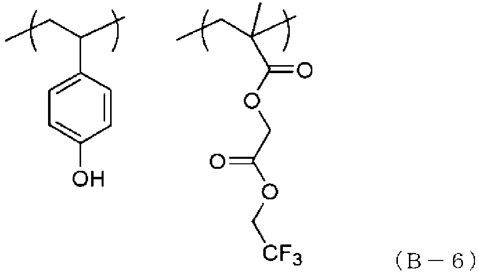
- Polymer (B-7): a polymer represented by the following formula (B-7) produced by copolymerizing 1-ethylcyclooctyl methacrylate, which provides a structural unit for adjusting solubility in a developer, and 5,5,5-trifluoro-4-hydroxy-4-(trifluoromethyl)pentan-2-yl methacrylate, which provides a structural unit having a fluorine atom (mole ratio: 20:80; weight-average molecular weight (Mw) in terms of standard polystyrene equivalent determined by GPC measurement: 20000).

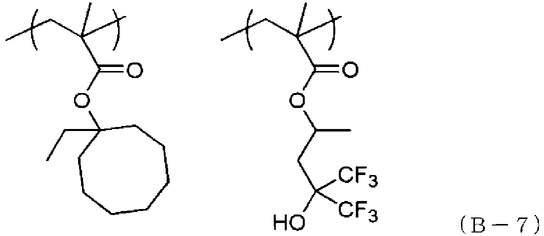

**[Table 1]**

| Components | | R-1 | R-2 | R-3 | R-4 | R-5 | R-6 | R-7 | R-8 | R-9 | R-10 | R-11 | R-12 | R-13 | R-14 | R-15 | R-16 | R-17 | R-18 |
|---|---|---|---|---|---|---|---|---|---|---|---|---|---|---|---|---|---|---|---|
| (A) | Polyacid salt (A-1) | 2 | 2 | 2 | 2 | 2 | 2 | 2 | | | | | | | | | | | |
| | Polyacid salt (A-2) | | | | | | | | | | | | | | | | | | 2 |
| | Polyacid salt (A-3) | | | | | | | | 2 | 2 | | | | | | | | | |
| | Polyacid salt (A-4) | | | | | | | | | | 2 | 2 | | | | | | | |
| | Polyacid salt (A-5) | | | | | | | | | | | | 2 | 2 | | | | | |
| | Polyacid salt (A-6) | | | | | | | | | | | | | | 2 | 2 | | | |
| | Polyacid salt (A-7) | | | | | | | | | | | | | | | | 2 | 2 | |
| (B) | Polymer (B-1) | 0.1 | | | | | | | 0.1 | | 0.1 | | 0.1 | | 0.1 | | 0.1 | | |
| | Polymer (B-2) | | 0.1 | | | | | | | | | | | | | | | | |
| | Polymer (B-3) | | | 0.1 | | | | | | 0.1 | | 0.1 | | 0.1 | | 0.1 | | 0.1 | |
| | Polymer (B-4) | | | | 0.1 | | | | | | | | | | | | | | |
| | Polymer (B-5) | | | | | 0.1 | | | | | | | | | | | | | |
| | Polymer (B-6) | | | | | | 0.1 | | | | | | | | | | | | |
| | Polymer (B-7) | | | | | | | 0.1 | | | | | | | | | | | |
| Organic solvent | Cyclopentanone | 100 | 100 | 100 | 100 | 100 | 100 | 100 | 100 | 100 | 100 | 100 | 100 | 100 | 100 | 100 | 100 | 100 | 100 |

**[Table 2]**

| Components | | R-19 | R-20 | R-21 | R-22 | R-23 | R-24 | R-25 |
|---|---|---|---|---|---|---|---|---|
| (A) | Polyacid salt (A-1) | 2 | 2 | 2 | 2 | 2 | 2 | |
| (B) | Polymer (B-1) | 0.002 | 0.02 | 0.1 | 0.2 | 2 | 6 | 5 |
| Organic solvent | Cyclopentanone | 100 | 100 | 100 | 100 | 100 | 100 | 100 |

### [3. Evaluation of Sensitivity and EL Margin]

### <Formation of LS Pattern>

Each of the resist materials R-1 to R-5 was applied using a spinner to an 8-inch silicon substrate subjected to a hexamethyldisilazane (HMDS) treatment, was subjected to a post-applied bake (PAB) treatment on a hot plate at a temperature of 120°C for 60 seconds, and was dried to form a resist film with a thickness of 50 nm. The thickness of the formed resist film was measured with a thickness measuring apparatus ("M-2000D" manufactured by J. A. Woollam).

Lithography (exposure) was performed on the resist film using an electron-b eam lithography system F7000S-VD2 (manufactured by Advantest Corporation) at a n accelerating voltage of 50 kV such that the target size was a 1:1 line-and-space pattern (hereinafter also referred to as an "LS pattern") with a line width of 50 n m. Post-exposure bake (PEB) treatment was then performed at 90°C for 60 secon ds.

Development was then performed at 23°C for 60 seconds using a developer (NMD-W (manufactured by Tokyo Ohka Kogyo Co., Ltd.)), and rinsing was perfor med for 60 seconds using pure water.

As a result, 1:1 LS patterns with a line width of 50 nm were formed, and LS patterns (LS-1) to (LS-18) corresponding to the resist materials (R-1) to (R-18) were formed. All of the LS patterns (LS-1) to (LS-18) are positive patterns.

### <Evaluation of Sensitivity>

The optimum exposure dose Eop (µC/cm²) was determined for forming a 1:1 LS pattern with a line width of 50 nm, which is formed by the LS pattern formation method described above. Table 2 shows the results.

### <Evaluation of EL Margin>

In the formation of the LS pattern, the EL margin (unit: %) was determined using the following equation from the exposure dose for forming LS patterns of 45 nm and 55 nm, which is ±10% of a space width of 50 nm.

The larger the value of the EL margin, the smaller the amount of change in the pattern dimension due to the variation in the exposure dose.
Eop: optimum exposure dose for forming a LS pattern with a line width of 50 nm and a pitch of 100 nm
E1: optimum exposure dose for forming a LS pattern with a line width of 45 nm and a pitch of 100 nm
E2: optimum exposure dose for forming a LS pattern with a line width of 55 nm and a pitch of 100 nm $EL margin \left(%\right) = \left(\left|E1-E2\right|/Eop\right) \times 100$

The EL margin was evaluated according to the following criteria. Table 3 shows the results.
A: value of EL margin of 15% or more
B: value of EL margin of 10% or more and less than 15%
C: value of EL margin of 5% or more and less than 10%
D: value of EL margin of less than 5%

**[Table 3]**

| LS pattern | LS-1 | LS-2 | LS-3 | LS-4 | LS-5 | LS-6 | LS-7 | LS-8 | LS-9 |
|---|---|---|---|---|---|---|---|---|---|
| Eop (µC/cm²) | 73 | 70 | 87 | 56 | 66 | 71 | 74 | 89 | 90 |
| EL margin | A | B | A | A | A | B | B | B | A |

| LS pattern | LS-10 | LS-11 | LS-12 | LS-13 | LS-14 | LS-15 | LS-16 | LS-17 | LS-18 |
|---|---|---|---|---|---|---|---|---|---|
| Eop (µC/cm²) | 78 | 86 | 72 | 85 | 70 | 82 | 78 | 88 | 92 |
| EL margin | B | B | A | B | A | A | A | A | D |

The results of Table 3 show that the LS patterns (LS-1) to (LS-17) formed using the resist materials (R-1) to (R-17) containing any one of the polymers (B-1) to (B-7) in addition to the polyacid salts (A-1) and (A-3) to (A-7) have a large value of EL margin and are all good in the evaluation. The large value of the EL margin results in a small amount of change in the pattern dimension due to the variation in the exposure dose, giving a margin to the process, which is preferred.

### [5. Evaluation of Etch Resistance]

Resist films (M-19) to M-25) with a thickness of 40 nm were formed by applying the resist materials (R-19) to (R-25) using a spinner to an 8-inch silicon substrate treated with hexamethyldisilazane (HMDS), subjecting the resist materials to a post-applied bake (PAB) treatment on a hot plate at a temperature of 120°C for 60 seconds, and drying the resist materials.

Under the following conditions, the resist films were subjected to dry etching using plasma obtained from oxygen gas (O₂ plasma etching).

### <O₂ Plasma Etching Conditions>

Each resist film with a thickness of 40 nm was subjected to dry etching treatment using a dry etching apparatus TCA-3822 (trade name, manufactured by Tokyo Ohka Kogyo Co., Ltd.) using CF₄ gas for 60 seconds.

The residual film amount was determined from the thicknesses of the resist film before and after the dry etching treatment.

The residual film amount of each of the resist films (M-19) to (M-24) formed using the resist materials (R-19) to (R-24) was expressed as a relative value when the residual film amount of the resist film (M-25) formed using the resist material (R-25) was set to 1.00, and this value is shown in Table 4 as "Etch resistance".

A larger relative value means that the residual film amount is relatively large, the film loss is suppressed, and the etch resistance is high.

**[Table 4]**

| | M-19 | M-20 | M-21 | M-22 | M-23 | M-24 | M-25 |
|---|---|---|---|---|---|---|---|
| Etch resistance (Relative value of residual film amount) | 4.22 | 3.85 | 3.24 | 2.10 | 1.47 | 1.27 | 1.00 |

The results of Table 4 show that the resist films (M-19) to (M-24) formed using the resist materials (R-19) to (R-24) containing the polyacid salt (A-1) all have improved etch resistance as compared with the resist film (M-25) formed using the resist material (R-25) containing no polyacid salt.

Here, in the resist materials (R-19) to (R-24), the polymer (B-1) content of the resist material increases in this order, and the content ratio of the polyacid salt (A-1) in the resist material relatively decreases. Table 4 shows that when the relative content ratio of the polyacid salt (A-1) in the resist material decreases, the etch resistance decreases.

## Claims

1. A resist material comprising (A) a polyacid salt having one or more polar groups each having an acid-dissociable group or a mixture thereof and (B) a polymer.

2. The resist material according to claim 1, wherein the (A) polyacid salt having one or more polar groups each having an acid-dissociable group or the mixture thereof has an anion moiety that is an isopolyacid anion, a heteropolyacid anion, or a heteropolyacid anion having a lacunary site in which the lacunary site is modified.

3. The resist material according to claim 2, wherein the isopolyacid anion is an isopolyoxomolybdate anion, an isopolyoxotungstate anion, an isopolyoxoniobate anion, or an isopolyoxotantalate anion.

4. The resist material according to claim 2, wherein the heteropolyacid anion has a polyatom of Mo, W, V, Nb, or Ta and a heteroatom of P, Si, B, S, or Ge.

5. The resist material according to claim 2, wherein the heteropolyacid anion having the lacunary site is a lacunary Keggin-type heteropolyacid anion or a lacunary Dawson-type heteropolyacid anion.

6. The resist material according to claim 2, wherein the modification is performed by bonding a group having one or more heteroatoms of P, Si, Ge, or Sn, to which one or more organic groups are bonded, to the heteropolyacid anion having the lacunary site via a part or all of the heteroatoms.

7. The resist material according to claim 6, wherein the organic group has one or more polar groups each having an acid-dissociable group.

8. The resist material according to claim 7, wherein the acid-dissociable group is a tertiary-carbon-type acid-dissociable group, an allyl- or benzyl-type acid-dissociable group, or an acetal-type acid-dissociable group.

9. The resist material according to claim 1, wherein the (A) polyacid salt having one or more polar groups each having an acid-dissociable group or the mixture thereof has a cation moiety that has H⁺, a metal ion, an onium cation, or an onium dication.

10. The resist material according to claim 9, wherein the onium cation or the onium dication is an ammonium cation, an ammonium dication, a phosphonium cation, a phosphonium dication, a sulfonium cation, a sulfonium dication, or an iodonium cation.

11. The resist material according to claim 9, wherein the onium cation or the onium dication has one or more polar groups each having an acid-dissociable group.

12. The resist material according to claim 11, wherein the acid-dissociable group is a tertiary-carbon-type acid-dissociable group, an allyl- or benzyl-type acid-dissociable group, or an acetal-type acid-dissociable group.

13. The resist material according to claim 1, wherein the (A) polyacid salt having one or more polar groups each having an acid-dissociable group or the mixture thereof is a polyacid salt having one or more polar groups each having an acid-dissociable group represented by the general formula (I) or a mixture thereof.
(A^{m+})ₐ(C^{(am)-}) (I)
wherein
A^{m+} each independently denotes H⁺, a metal ion, an onium cation, or an onium dication;
C^{(am)-} denotes an isopolyacid anion, a heteropolyacid anion, or a heteropolyacid anion having a lacunary site in which the lacunary site is modified;
A^{m+} and/or C^{(am)-} has one or more polar groups each having an acid-dissociable group; and
m denotes an integer in the range of 1 to 5, and a denotes a real number greater than 0.

14. The resist material according to claim 1, wherein the (A) polyacid salt having one or more polar groups each having an acid-dissociable group or the mixture thereof is a polyacid salt having one or more polar groups each having an acid-dissociable group represented by the general formula (I') or a mixture thereof.
(A'^{m'+})_{a'}(Bⁿ⁺)_{b}(C'^{(a'm'+bn)-}) (I')
wherein
A'^{m'+} each independently denotes H⁺, a metal ion, an ammonium cation, an ammonium dication, a phosphonium cation, or a phosphonium dication;
Bⁿ⁺ each independently denotes a sulfonium cation, a sulfonium dication, or an iodonium cation;
C'^{(a'm'+bn)-} denotes an isopolyacid anion, a heteropolyacid anion, or a heteropolyacid anion having a lacunary site in which the lacunary site is modified;
A'^{m'+}, Bⁿ⁺, and/or C'^{(a'm'+bn)-} has one or more polar groups each having an acid-dissociable group; and
m' denotes an integer in the range of 1 to 5, n denotes an integer of 1 or 2, a' denotes a real number, and b denotes a real number greater than 0.

15. The resist material according to claim 1, wherein the (B) polymer includes one or more structural units selected from the group consisting of a structural unit having a phenolic hydroxy group, a structural unit for adjusting solubility in a developer, and a structural unit having a fluorine atom.

16. The resist material according to claim 1, wherein a content ratio of the (B) polymer ranges from 0.1 to 200 parts by mass when a blending amount of the (A) polyacid salt having one or more polar groups each having an acid-dissociable group or the mixture thereof is 100 parts by mass.

17. The resist material according to claim 15, wherein the structural unit for adjusting solubility in a developer is a structural unit represented by the general formula (VIII-2) or (VIII-3). 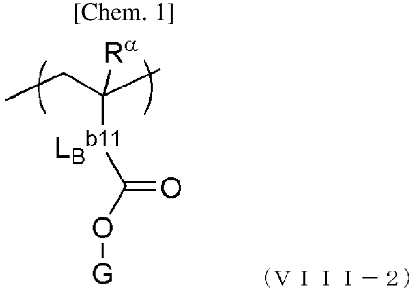 wherein
Rα denotes a hydrogen atom, a halogen atom, a C₁₋₃ alkyl group, or a C₁₋₃ haloalkyl group;
L_{B}^{b11} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time); and
G denotes a tertiary-carbon-type acid-dissociable group, an allyl- or benzyl-type acid-dissociable group, or an acetal-type acid-dissociable group. 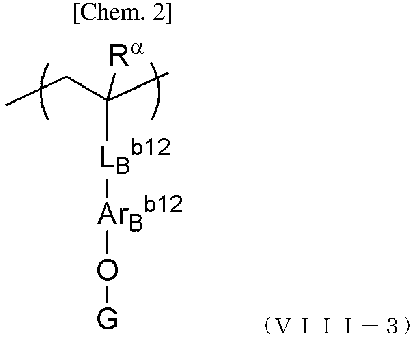 wherein
Rα denotes a hydrogen atom, a halogen atom, a C₁₋₃ alkyl group, or a C₁₋₃ haloalkyl group;
L_{B}^{b12} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time);
Ar_{B}^{b12} denotes a C₆₋₁₈ arylene group optionally having a substituent; and
G denotes a tertiary-carbon-type acid-dissociable group, an allyl- or benzyl-type acid-dissociable group, or an acetal-type acid-dissociable group.

18. The resist material according to claim 15, wherein the structural unit having a fluorine atom is a structural unit represented by the general formula (VIII-5) or (VIII-6). 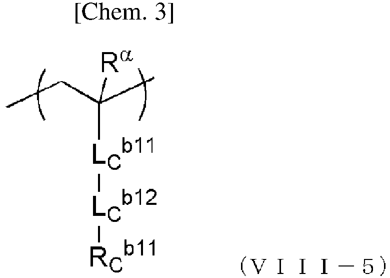 wherein
Rα denotes a hydrogen atom, a halogen atom, a C₁₋₃ alkyl group, or a C₁₋₃ haloalkyl group;
LC_{b}¹¹ denotes a single bond, -O-, -C(=O)-, -C(=O)-O-, -O-C(=O)-, -CONH-, - NH(C=O)-, -S-, or -SO₂-;
L_{C}^{b12} denotes a single bond or a C₁₋₈ hydrocarbylene group optionally having a substituent, wherein any divalent carbon atom including terminals may be substituted with -O-, -C(=O)-, -C(=O)-O-, -O-C(=O)-, -CONH-, -NH(C=O)-, -S-, or -SO₂- (provided that adjacent divalent carbon atoms are not substituted at the same time); and
R_{C}^{b11} denotes a C₁₋₈ hydrocarbyl group optionally having a substituent in which at least one hydrogen atom is substituted with a fluorine atom. 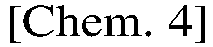 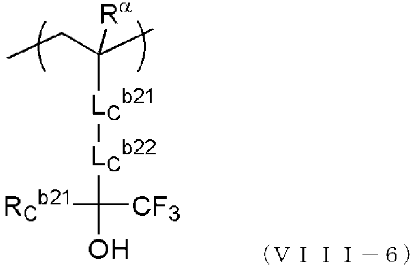 wherein
Rα denotes a hydrogen atom, a halogen atom, a C₁₋₃ alkyl group, or a C₁₋₃ haloalkyl group;
L_{C}^{b21} denotes a single bond, -O-, -C(=O)-, -C(=O)-O-, -O-C(=O)-, -CONH-, - NH(C=O)-, -S-, or -SO₂-;
R_{C}^{b21} denotes a hydrogen atom, a fluorine atom, or a C₁₋₄ alkyl group optionally having a substituent in which at least one hydrogen atom is substituted with a fluorine atom;
Rα and L_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group, thereby forming a ring; and
L_{C}^{b21} and R_{C}^{b21} may be bonded to each other directly by a single bond or via a divalent linking group -O-, -S-, -C(=O)-, -S(=O)-, -S(=O)₂-, -C(=O)O-, or a C₁₋₃ alkylene group, thereby forming a ring.

19. A pattern forming method comprising:
a step of forming a resist film using the resist material according to any one of claims 1 to 18;
a step of exposing the resist film; and
a step of developing the exposed resist film using a developer.

20. The pattern forming method according to claim 19, wherein the step of exposing the resist film includes a step of exposing the resist film to an electron beam with a dose of 2 mC/cm² or less or extreme ultraviolet of 200 mJ/cm² or less.
